# EUROPEAN PATENT APPLICATION

(11) **EP 4 719 020 A1**
(43) Date of publication of application: **01.04.2026**
(21) Application number: 24811278.1
(22) Date of filing: 24.04.2024
(51) Int. Cl.: H10K 85/60, H10K 85/30, H10K 50/12, C09K 11/06

(54) **ORGANIC OPTOELECTRONIC DEVICE AND DISPLAY DEVICE**

(30) Priority: 23.05.2023 KR 20230066537
(71) Applicant: SAMSUNG SDI CO., LTD., Yongin-si, Gyeonggi-do 17084 (KR)
(72) Inventor: LEE, Mijin, Suwon-si, Gyeonggi-do 16678 (KR); LYU, Seungchul, Suwon-si, Gyeonggi-do 16678 (KR); HUH, Dalho, Suwon-si, Gyeonggi-do 16678 (KR); LUI, Jinhyun, Suwon-si, Gyeonggi-do 16678 (KR); LEE, Namheon, Suwon-si, Gyeonggi-do 16678 (KR); JUNG, Ho Kuk, Suwon-si, Gyeonggi-do 16678 (KR); JO, Youngkyoung, Suwon-si, Gyeonggi-do 16678 (KR); CHO, Pyeongseok, Suwon-si, Gyeonggi-do 16678 (KR); JUNG, Sung-Hyun, Suwon-si, Gyeonggi-do 16678 (KR)
(74) Representative: Michalski Hüttermann & Partner Patentanwälte mbB
(86) International application number: PCT/KR2024/005542
(87) International publication number: WO 2024/242339

(57) **Abstract**

Provided is an organic optoelectronic device and display device including an anode and a cathode facing each other, an intermediate layer between the anode and the cathode, wherein the intermediate layer includes a first light emitting layer and a second light emitting layer, the first light emitting layer is disposed between an anode and a second light emitting layer, and includes a first host including a composition of a first compound and a second compound, and a first dopant, the second light emitting layer is disposed between the cathode and the first light emitting layer, and includes a second host including a composition of a third compound and a fourth compound and a second dopant, the first dopant is an iridium complex and the second dopant is a platinum complex, and the organic optoelectronic device satisfies Formula 1: 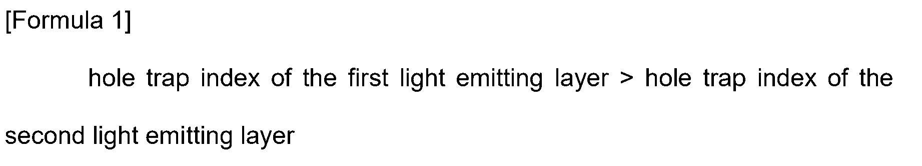 hole trap index of the first light emitting layer > hole trap index of the second light emitting layer

The hole trap index is calculated according to Formula 2: 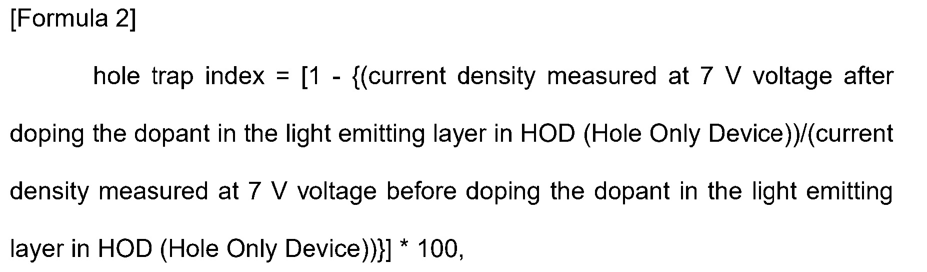 hole trap index = [1 - {(current density measured at 7 V voltage after doping the dopant in the light emitting layer in HOD (Hole Only Device))/(current density measured at 7 V voltage before doping the dopant in the light emitting layer in HOD (Hole Only Device))}] * 100,
HOD: ITO/Compound E (1,400 Å)/Compound F (1% NDP-9 doping, 100 Å)/Compound F (200 Å)/light emitting layer (400 Å)/ HAT-CN (100 Å) / Ag (50 Å) / Mg:Ag (9:1, 550 Å);
Compound E: N-([1,1'-biphenyl]-4-yl)-9,9-dimethyl-N-(4-(9-phenyl-9H-carbazol-3-yl)phenyl)-9H-fluoren-2-amine; and
Compound F: N-([1,1'-biphenyl]-4-yl)-N-(2-(9,9-diphenyl-9H-fluoren-4-yl)phenyl)-9,9-dimethyl-9H-fluoren-2-amine).

## Description

### [Technical Field]

An organic optoelectronic device and a display device are disclosed.

### [Background Art]

An organic optoelectronic device (organic optoelectronic diode) is a device capable of converting electrical energy and optical energy to each other.

Organic optoelectronic devices may be largely divided into two types according to a principle of operation. One is a photoelectric device that generates electrical energy by separating excitons formed by light energy into electrons and holes, and transferring the electrons and holes to different electrodes, respectively and the other is light emitting device that generates light energy from electrical energy by supplying voltage or current to the electrodes.

Examples of the organic optoelectronic device include an organic photoelectric device, an organic light emitting diode, an organic solar cell, and an organic photoconductor drum.

Among them, organic light emitting diodes (OLEDs) are attracting much attention in recent years due to increasing demands for flat panel display devices. The organic light emitting diode is a device that converts electrical energy into light, and the performance of the organic light emitting diode is greatly influenced by an organic material between electrodes.

### [Disclosure]

### [Technical Problem]

An embodiment provides an organic optoelectronic device with high efficiency, low driving voltage and long life-span.

Another embodiment provides a display device including the organic optoelectronic device.

### [Technical Solution]

According to an embodiment, an organic optoelectronic device includes an anode and a cathode facing each other, an intermediate layer between the anode and the cathode, wherein the intermediate layer includes a first light emitting layer and a second light emitting layer, the first light emitting layer is disposed between an anode and a second light emitting layer, and includes a first host including a composition of a first compound and a second compound, and a first dopant, the second light emitting layer is disposed between the cathode and the first light emitting layer, and includes a second host including a composition of a third compound and a fourth compound and a second dopant, the first dopant is an iridium complex and the second dopant is a platinum complex, and the organic optoelectronic device satisfies Formula 1. 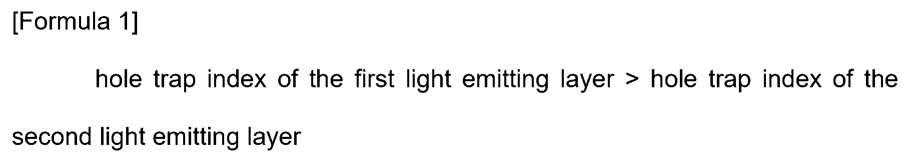 hole trap index of the first light emitting layer > hole trap index of the second light emitting layer

The hole trap index is calculated according to Formula 2. 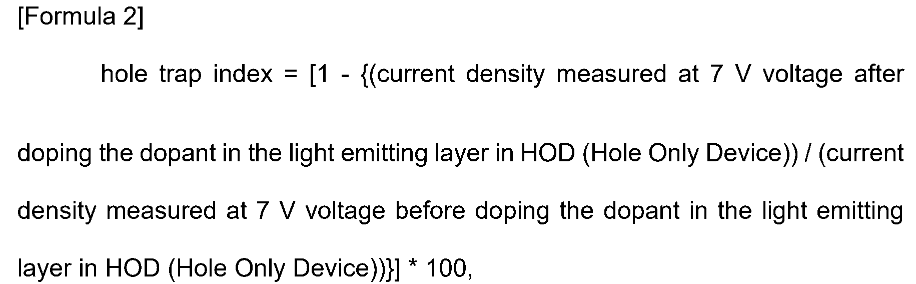 hole trap index = [1 - {(current density measured at 7 V voltage after doping the dopant in the light emitting layer in HOD (Hole Only Device)) / (current density measured at 7 V voltage before doping the dopant in the light emitting layer in HOD (Hole Only Device))}] * 100,
HOD: ITO/Compound E (1,400 Å)/Compound F (1% NDP-9 doping, 100 Å)/Compound F (200 Å)/light emitting layer (400 Å)/ HAT-CN (100 Å) / Ag (50 Å) / Mg:Ag (9:1, 550 Å);
Compound E: N-([1,1'-biphenyl]-4-yl)-9,9-dimethyl-N-(4-(9-phenyl-9H-carbazol-3-yl)phenyl)-9H-fluoren-2-amine;
Compound F: N-([1,1'-biphenyl]-4-yl)-N-(2-(9,9-diphenyl-9H-fluoren-4-yl)phenyl)-9,9-dimethyl-9H-fluoren-2-amine).

Another embodiment provides a display device including the aforementioned organic optoelectronic device.

High-efficiency, low-driving voltage, and long life-span organic optoelectronic device may be implemented.

### [Description of the Drawings]

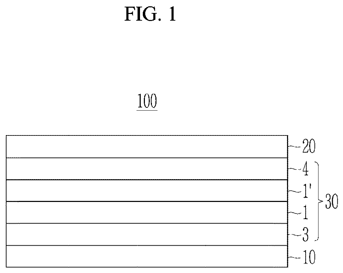

FIGS. 1 to 5 are cross-sectional views illustrating organic light emitting diodes according to various embodiments.

**<Description of symbols>**

| | | | | | |
|---|---|---|---|---|---|
| 100, 200, 300, 400: | organic light emitting diode | | | | |
| 10: | anode | | | 20: | cathode |
| 30, 31, 32, 33, 34: | intermediate layer | | | | |
| 41: | first stack, | 42: | second stack, | 43: | third stack |
| 1, 1', 1": | light emitting layer | | | | |
| 3, 3', 3": | hole transport region | | | | |
| 4, 4', 4": | electron transport region | | | | |

### [Best Mode]

Hereinafter, embodiments of the present invention are described in detail. However, these embodiments are exemplary, the present invention is not limited thereto and the present invention is defined by the scope of claims.

As used herein, when a definition is not otherwise provided, "substituted" refers to replacement of at least one hydrogen of a substituent or a compound by deuterium, a halogen, a hydroxyl group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, a C1 to C20 alkoxy group, a C1 to C10 trifluoroalkyl group, a cyano group, or a combination thereof.

In one example of the present invention, the "substituted" refers to replacement of at least one hydrogen of a substituent or a compound by deuterium, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, or a cyano group. In specific example of the present invention, the "substituted" refers to replacement of at least one hydrogen of a substituent or a compound by deuterium, a C1 to C20 alkyl group, a C6 to C30 aryl group, or a cyano group. In specific example of the present invention, the "substituted" refers to replacement of at least one hydrogen of a substituent or a compound by deuterium, a C1 to C5 alkyl group, a C6 to C18 aryl group, or a cyano group. In specific example of the present invention, the "substituted" refers to replacement of at least one hydrogen of a substituent or a compound by deuterium, a cyano group, a methyl group, an ethyl group, a propyl group, a butyl group, a phenyl group, a biphenyl group, a terphenyl group, or a naphthyl group.

"Unsubstituted" refers to non-replacement of a hydrogen atom by another substituent and remaining of the hydrogen atom.

As used herein, "hydrogen substitution (-H)" may include deuterium substitution (-D) or "tritium substitution (-T).

As used herein, when a definition is not otherwise provided, "hetero" refers to one including one to three heteroatoms selected from N, O, S, P, and Si, and remaining carbons in one functional group.

As used herein, "an aryl group" refers to a group including at least one hydrocarbon aromatic moiety, and all elements of the hydrocarbon aromatic moiety have p-orbitals which form conjugation, for example a phenyl group, a naphthyl group, and the like, two or more hydrocarbon aromatic moieties may be linked by a sigma bond and may be, for example a biphenyl group, a terphenyl group, a quaterphenyl group, and the like, and two or more hydrocarbon aromatic moieties are fused directly or indirectly to provide a non-aromatic fused ring, for example a fluorenyl group.

The aryl group may include a monocyclic, polycyclic, or fused ring polycyclic (i.e., rings sharing adjacent pairs of carbon atoms) functional group.

As used herein, "a heterocyclic group" is a generic concept of a heteroaryl group, and may include at least one heteroatom selected from N, O, S, P, and Si instead of carbon (C) in a cyclic compound such as an aryl group, a cycloalkyl group, a fused ring thereof, or a combination thereof. When the heterocyclic group is a fused ring, the entire ring or each ring of the heterocyclic group may include one or more heteroatoms.

For example, "a heteroaryl group" may refer to an aryl group including at least one heteroatom selected from N, O, S, P, and Si. Two or more heteroaryl groups are linked by a sigma bond directly, or when the heteroaryl group includes two or more rings, the two or more rings may be fused. When the heteroaryl group is a fused ring, each ring may include one to three heteroatoms.

More specifically, the substituted or unsubstituted C6 to C30 aryl group may be a substituted or unsubstituted phenyl group, a substituted or unsubstituted naphthyl group, a substituted or unsubstituted anthracenyl group, a substituted or unsubstituted phenanthrenyl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted o-terphenyl group, a substituted or unsubstituted chrysenyl group, a substituted or unsubstituted triphenylene group, a substituted or unsubstituted perylenyl group, a substituted or unsubstituted fluorenyl group, a substituted or unsubstituted indenyl group, a substituted or unsubstituted furanyl group, or a combination thereof, but is not limited thereto.

More specifically, the substituted or unsubstituted C2 to C30 heterocyclic group may be a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted carbazolyl group, a substituted or unsubstituted dibenzofuranyl group, a substituted or unsubstituted dibenzothiophenyl group, a substituted or unsubstituted benzofuranpyrimidinyl group, a substituted or unsubstituted benzothiophenepyrimidinyl group, or a combination thereof, but is not limited thereto.

As used herein, hole characteristics refer to an ability to donate an electron to form a hole when an electric field is applied and that a hole formed in the anode may be easily injected into the light emitting layer and transported in the light emitting layer due to conductive characteristics according to a highest occupied molecular orbital (HOMO) level.

In addition, electron characteristics refer to an ability to accept an electron when an electric field is applied and that electron formed in the cathode may be easily injected into the light emitting layer and transported in the light emitting layer due to conductive characteristics according to a lowest unoccupied molecular orbital (LUMO) level.

In this specification, Dn refers to the number of deuterium substitutions and can be selected from any integer of 1 or more.

The organic optoelectronic device may be any device to convert electrical energy into photoenergy and vice versa without particular limitation, and may be, for example an organic photoelectric device, an organic light emitting diode, an organic solar cell, and an organic photoconductor drum.

Herein, an organic light emitting diode as one example of an organic optoelectronic device is described, but the present invention is not limited thereto, and may be applied to other organic optoelectronic device in the same way.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

FIGS. 1 to 5 are cross-sectional views illustrating organic light emitting diodes according to various embodiments.

Hereinafter, organic light emitting diodes according to embodiments will be described with reference to FIGS. 1 to 5.

Referring to FIG. 1, an organic light emitting diode 100 according to an embodiment includes an anode 10 and a cathode 20 facing each other, and an intermediate layer 30 between the anode 10 and the cathode 20.

The anode 10 may be made of a conductor having a large work function to help hole injection, and may be for example a metal, a metal oxide and/or a conductive polymer. The anode 10 may be, for example a metal such as nickel, platinum, vanadium, chromium, copper, zinc, gold, and the like or an alloy thereof; a metal oxide such as zinc oxide, indium oxide, indium tin oxide (ITO), indium zinc oxide (IZO), and the like; a combination of a metal and an oxide such as ZnO and Al or SnO₂ and Sb; a conductive polymer such as poly(3-methylthiophene), poly(3,4-(ethylene-1,2-dioxy)thiophene) (PEDOT), polypyrrole, and polyaniline, but is not limited thereto.

The cathode 20 may be made of a conductor having a small work function to help electron injection, and may be for example a metal, a metal oxide and/or a conductive polymer. The cathode 20 may be for example a metal such as magnesium, calcium, sodium, potassium, titanium, indium, yttrium, lithium, gadolinium, aluminum silver, tin, lead, cesium, barium, and the like, or an alloy thereof; a multi-layer structure material such as LiF/Al, LiO₂/Al, LiF/Ca, and BaF₂/Ca, but is not limited thereto.

The intermediate layer 30 includes a first light emitting layer 1 and a second light emitting layer 1', the first light emitting layer 1 is disposed between the anode 10 and the second light emitting layer 1', and the second light emitting layer 1' is disposed between the cathode 20 and the first light emitting layer 1.

In addition, the intermediate layer 30 includes a hole transport region 3 between the anode 10 and the first light emitting layer 1, and an electron transport region 4 between the cathode 20 and the second light emitting layer 1'.

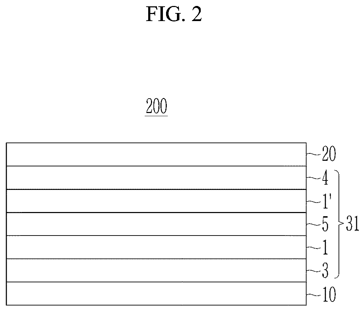

Referring to FIG. 2, the organic light emitting diode 200 according to another embodiment includes an intermediate layer 31 further including a charge generation layer 5 between the first light emitting layer 1 and the second light emitting layer 1'.

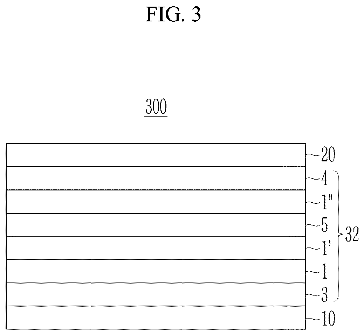

Referring to FIG. 3, an organic light emitting diode 300 according to another embodiment may include an intermediate layer 32 further including a charge generation layer 5 and a third light emitting layer 1" between the cathode 20 and the second light emitting layer 1'.

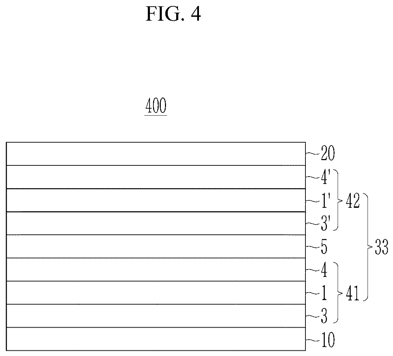

Referring to FIG. 4, an organic light emitting diode 400 according to another embodiment includes an intermediate layer 33 including a first stack 41 and a second stack 42, wherein the first stack 41 includes a first hole transport region 3 between the anode 10 and the first light emitting layer 1 and a first electron transport region 4 between the cathode 20 and the first light emitting layer 1, and the second stack 42 includes a second hole transport region 3' between the anode 10 and the second light emitting layer 1' and a second electron transport region 4' between the cathode 20 and the second light emitting layer 1'. At this time, the charge generation layer 5 may be included between the first stack 41 and the second stack 42.

As shown in FIGS. 1 and 3, the first light emitting layer 1 and the second light emitting layer 1' may be in contact with each other.

As shown in FIG. 4, in a tandem structure including two or more stacks, the first light emitting layer 1 and the second light emitting layer 1' may be disposed independently of each other within each stack, and a charge generation layer 5 may be further included between each stack.

The tandem structure may further include additional stacks, and each stack may further include a hole transport region, an electron transport region, a light emitting layer, and optionally a charge generation layer between the anode and the cathode.

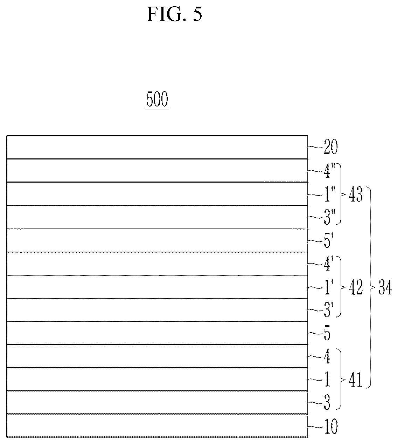

Referring to FIG. 5, as an example, the organic light emitting diode 500 includes an intermediate layer 34 including a first stack 41, a second stack 42, and a third stack 43, wherein the first stack 41 may include a first hole transport region 3 between the anode 10 and the first light emitting layer 1, and a first electron transport region 4 between the cathode 20 and the first light emitting layer 1, the second stack 42 may include a second hole transport region 3' between the anode 10 and the second light emitting layer 1', and a second electron transport region 4' between the cathode 20 and the second light emitting layer 1', and the third stack 43 may include a third hole transport region 3" between the anode 10 and the third light emitting layer 1", and a third a third electron transport region 4" between the cathode 20 and the third light emitting layer 1". Herein, charge generation layers 5 and 5' may be included between the first stack 41, the second stack 42, and the third stack 43.

In the organic optoelectronic device according to an embodiment of the present invention, the first light emitting layer 1 is disposed between the anode 10 and the second light emitting layer 1', and includes a first host including a composition of the first compound and the second compound, and a first dopant,
the second light emitting layer 1' is disposed between the cathode 20 and the first light emitting layer 1, and includes a second host including a composition of a third compound and a fourth compound and a second dopant,
the first dopant is an iridium complex and the second dopant is a platinum complex, and
Formula 1 is satisfied. 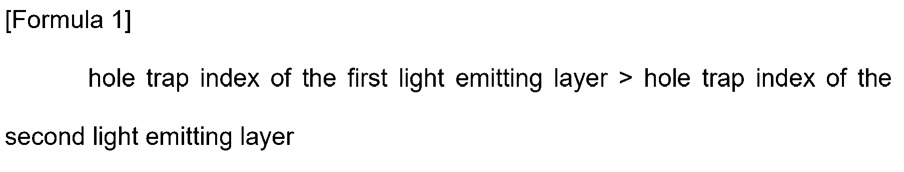 hole trap index of the first light emitting layer > hole trap index of the second light emitting layer

The hole trap index is calculated according to Formula 2. 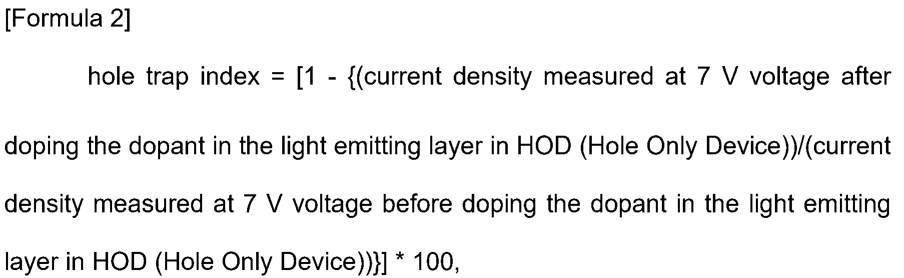 hole trap index = [1 - {(current density measured at 7 V voltage after doping the dopant in the light emitting layer in HOD (Hole Only Device))/(current density measured at 7 V voltage before doping the dopant in the light emitting layer in HOD (Hole Only Device))}] * 100,
HOD: ITO/Compound E (1,400 Å)/Compound F (1% NDP-9 doping, 100 Å)/Compound F (200 Å)/light emitting layer (400 Å)/ HAT-CN (100 Å) / Ag (50 Å) / Mg:Ag (9:1, 550 Å);
Compound E: N-([1,1'-biphenyl]-4-yl)-9,9-dimethyl-N-(4-(9-phenyl-9H-carbazol-3-yl)phenyl)-9H-fluoren-2-amine;
Compound F: N-([1,1'-biphenyl]-4-yl)-N-(2-(9,9-diphenyl-9H-fluoren-4-yl)phenyl)-9,9-dimethyl-9H-fluoren-2-amine).

The hole trap index is to digitize a degree to which holes are trapped by a dopant, for example, when the hole trap index is 100%, it means that the holes are not trapped by the dopant, while when the hole trap index is 0%, the holes are all trapped by the dopant.

Since a dopant may act as a hole trap site of a host due to a HOMO energy level difference of the dopant and the host, hole mobility of a light emitting layer may vary according to the host and the dopant included therein the light emitting layer, which may be digitized as the hole trap index.

When the hole trap index satisfies the range, a light emitting zone is disposed relatively toward an anode, which may have an advantageous effect on device performance.

On the other hand, although not limited to a specific concentration, when the dopant is doped on the light emitting layer in the HOD, an iridium complex (first dopant) may be doped at a concentration of about 1 to 10 wt% or for example, 5 wt% to 10 wt%, and a platinum complex (second dopant) may be doped at a concentration of about 5 wt% to 15 wt% or for example 7 wt% to 12 wt%.

A difference between the hole trap index of the first light emitting layer and the hole trap index of the second light emitting layer may be greater than or equal to 30%.

The first compound is an electron transporting host and may be a compound that does not include carbazole.

If the first emitting layer includes a non-carbazole-based compound with weak hole trapping characteristics, the device performance can be optimized because the light emitting zone is relatively disposed toward the anode.

For example, the first compound may be represented by Chemical Formula 1.

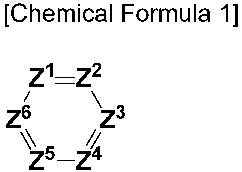

In Chemical Formula 1,
Z¹ to Z⁶ are each independently N or C-L^{a}-R^{a},
at least two of Z¹ to Z⁶ are N,
L^{a}s are each independently a single bond, a substituted or unsubstituted C6 to C20 arylene group, a substituted or unsubstituted dibenzofuranylene group, or a substituted or unsubstituted dibenzothiophenylene group,
R^{a}s are each independently hydrogen, deuterium, a substituted or unsubstituted C1 to C30 alkyl group, a substituted or unsubstituted C6 to C30 aryl group, a substituted or unsubstituted dibenzofuranyl group, or a substituted or unsubstituted dibenzothiophenyl group, and
R^{a}s are each independently present or adjacent groups are linked to form a substituted or unsubstituted aliphatic, aromatic, or heteroaromatic monocyclic or polycyclic ring.

As a specific example, Chemical Formula 1 may be represented by any one of Chemical Formula 1A, Chemical Formula 1B, and Chemical Formula 1C.

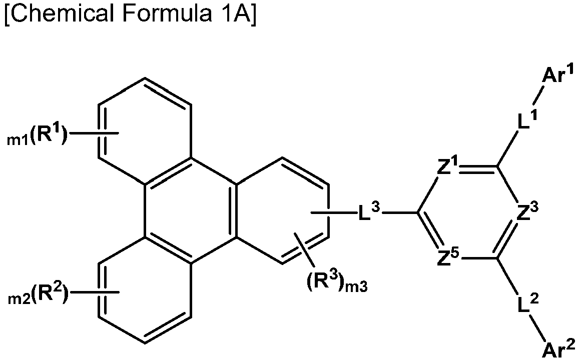

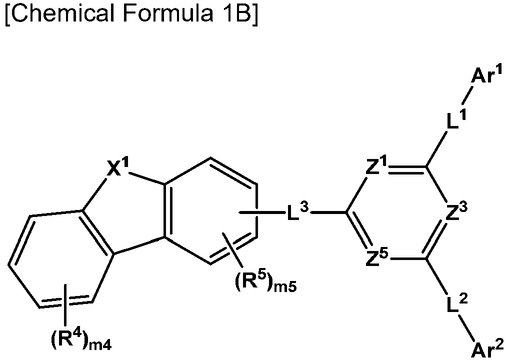

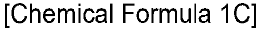

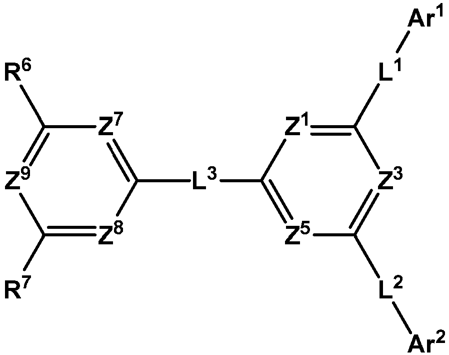

In Chemical Formula 1A, Chemical Formula 1B, and Chemical Formula 1C,
Z¹, Z³, and Z⁵ are each independently N or C-L^{a}-R^{a},
at least two of Z¹, Z³, and Z⁵ are N,
at least two of Z⁷ to Z⁹ are each independently N or C-L^{b}-R^{b},
X¹ is O, S or CR^{c}R^{d},
L^{a}, L^{b}, and L¹ to L³ are each independently a single bond, a substituted or unsubstituted C6 to C20 arylene group, a substituted or unsubstituted dibenzofuranylene group, or a substituted or unsubstituted dibenzothiophenylene group,
Ar¹ and Ar² are each independently a substituted or unsubstituted C6 to C30 aryl group, a substituted or unsubstituted dibenzofuranyl group, or a substituted or unsubstituted dibenzothiophenyl group,
R^{a}, R^{b}, R^{c}, R^{d}, and R¹ to R⁷ are each independently hydrogen, deuterium, a substituted or unsubstituted C1 to C30 alkyl group, a substituted or unsubstituted C6 to C30 aryl group, a substituted or unsubstituted dibenzofuranyl group, a substituted or unsubstituted dibenzothiophenyl group, a substituted or unsubstituted silyl group, a substituted or unsubstituted amine group, a halogen, a cyano group, or a combination thereof,
m1, m2, and m4 are each independently one of integers of 1 to 4, and
m3 and m5 are each independently one of integers of 1 to 3.

When m1 is greater than or equal to 2, each R¹ may be the same as or different from each other.

When m2 is greater than or equal to 2, each R² may be the same as or different from each other.

When m3 is greater than or equal to 2, each R³ may be the same as or different from each other.

When m4 is greater than or equal to 2, each R⁴ may be the same as or different from each other.

When m5 is greater than or equal to 2, each R⁵ may be the same as or different from each other.

As a specific example, Chemical Formula 1A may be represented by Chemical Formula 1A- I or Chemical Formula 1A-II.

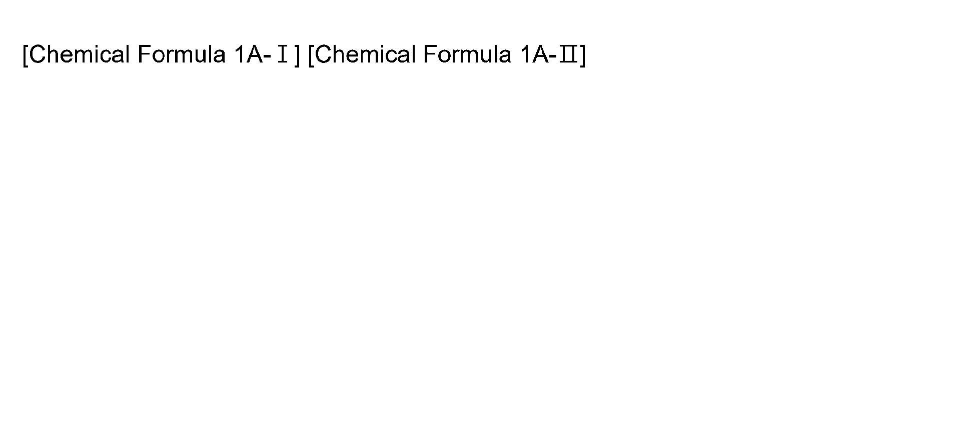

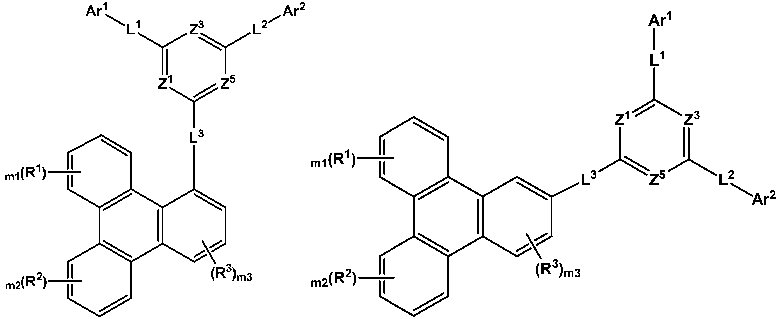

In Chemical Formula 1A-I and Chemical Formula 1A-II,
Z¹, Z³, Z⁵, L¹ to L³, Ar¹, Ar², R¹ to R³, and m1 to m3 are the same as described above.

As a specific example, Chemical Formula 1B may be represented by Chemical Formula 1B- I to Chemical Formula 1B-IV.

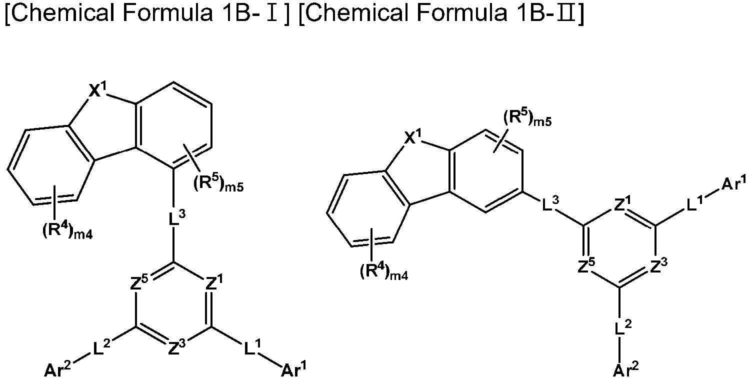

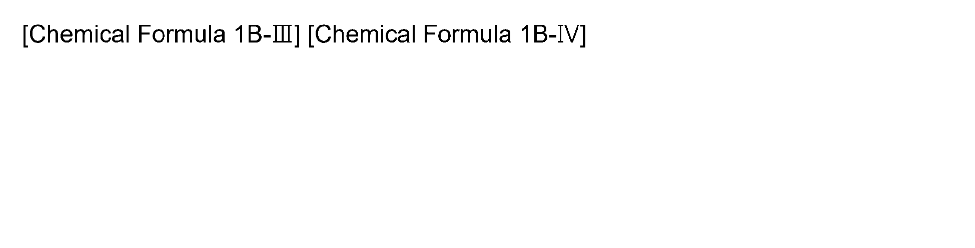

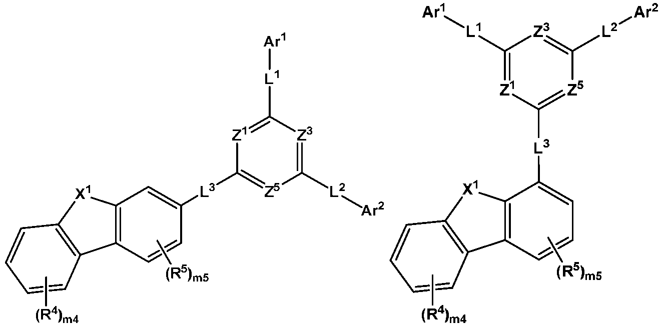

In Chemical Formula 1B- I to Chemical Formula 1B-IV,
X¹, Z¹, Z³, Z⁵, L¹ to L³, Ar¹, Ar², R⁴, R⁵, m4, and m5 are the same as described above.

As a specific example, Chemical Formula 1C may be represented by Chemical Formula 1C- I to Chemical Formula 1C-VI.

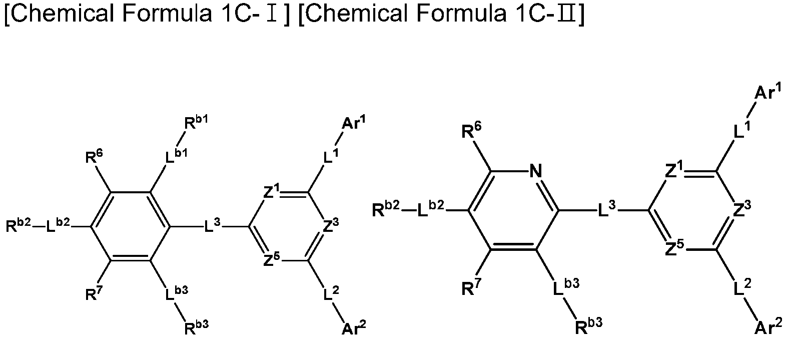

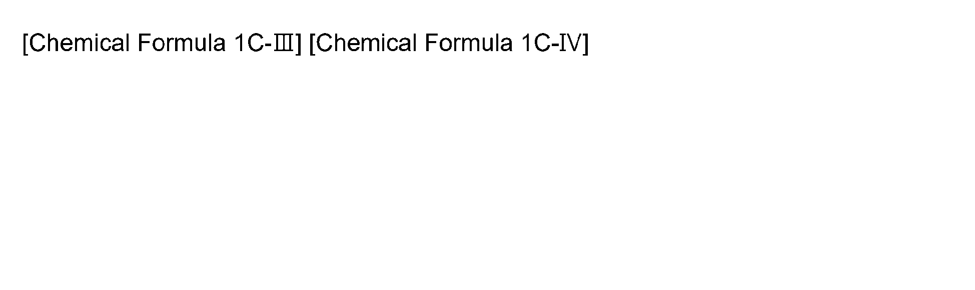

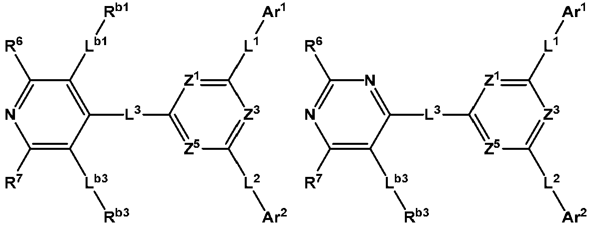

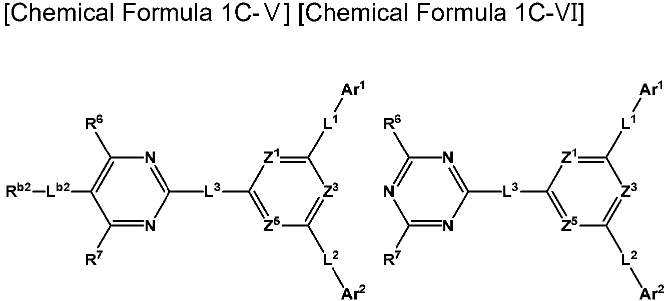

In Chemical Formula 1C- I to Chemical Formula 1C-VI,
Z¹, Z³, Z⁵, L¹ to L³, Ar¹, Ar², R⁶, and R⁷ are the same as described above,
L^{b1} to L^{b3} are each independently the same as the definition of L^{b} described above, and
R^{b1} to R^{b3} are each independently the same as the definition of R^{b} described above.

For example, each of Z¹ and Z³ may be N, and Z⁵ may be C-L^{a}-R^{a}.

For example, each of Z¹ and Z⁵ may be N, and Z³ may be C-L^{a}-R^{a}.

For example, each of Z¹, Z³, and Z⁵ may be N.

For example, X¹ may be O or S.

For example, X¹ may be CR^{c}R^{d}, and R^{c} and R^{d} may each independently be a substituted or unsubstituted C1 to C10 alkyl group or a substituted or unsubstituted C6 to C12 aryl group.

For example, L^{a}, L^{b}, and L¹ to L³ may each independently be a single bond, a substituted or unsubstituted phenylene group, a substituted or unsubstituted biphenylene group, a substituted or unsubstituted dibenzofuranylene group, a substituted or unsubstituted dibenzothiophenylene group, or a substituted or unsubstituted C6 to C20 arylene group.

For example, Ar¹ and Ar² may each independently be a substituted or unsubstituted phenyl group, a substituted or unsubstituted biphenyl group, a substituted or unsubstituted terphenyl group, a substituted or unsubstituted naphthyl group, a substituted or unsubstituted fluorenyl group, a substituted or unsubstituted triphenylene group, a substituted or unsubstituted dibenzofuranyl group, or a substituted or unsubstituted dibenzothiophenyl group.

R^{a}, R^{b}, and R¹ to R⁷ may each independently be hydrogen, deuterium, a halogen, a cyano group, a substituted or unsubstituted C1 to C10 alkyl group, a substituted or unsubstituted phenyl group, a substituted or unsubstituted biphenyl group, a substituted or unsubstituted terphenyl group, a substituted or unsubstituted naphthyl group, a substituted or unsubstituted fluorenyl group, a substituted or unsubstituted dibenzofuranyl group, or a substituted or unsubstituted dibenzothiophenyl group.

R⁴ and R⁵ may each independently be present or adjacent groups may be linked to form a substituted or unsubstituted C6 to C20 aryl group or a substituted or unsubstituted C2 to C30 heterocyclic group, and
the first compound may be, for example, one selected from the compounds of Group 1.

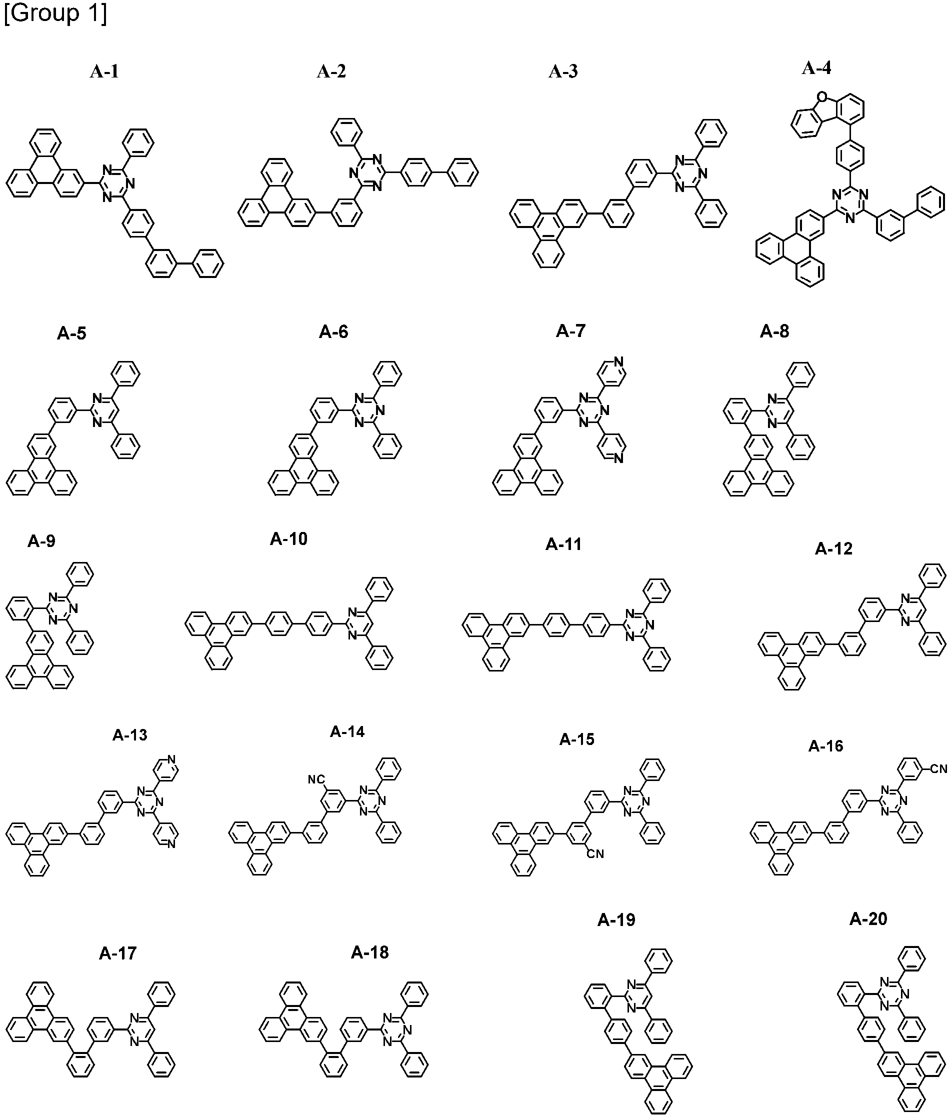

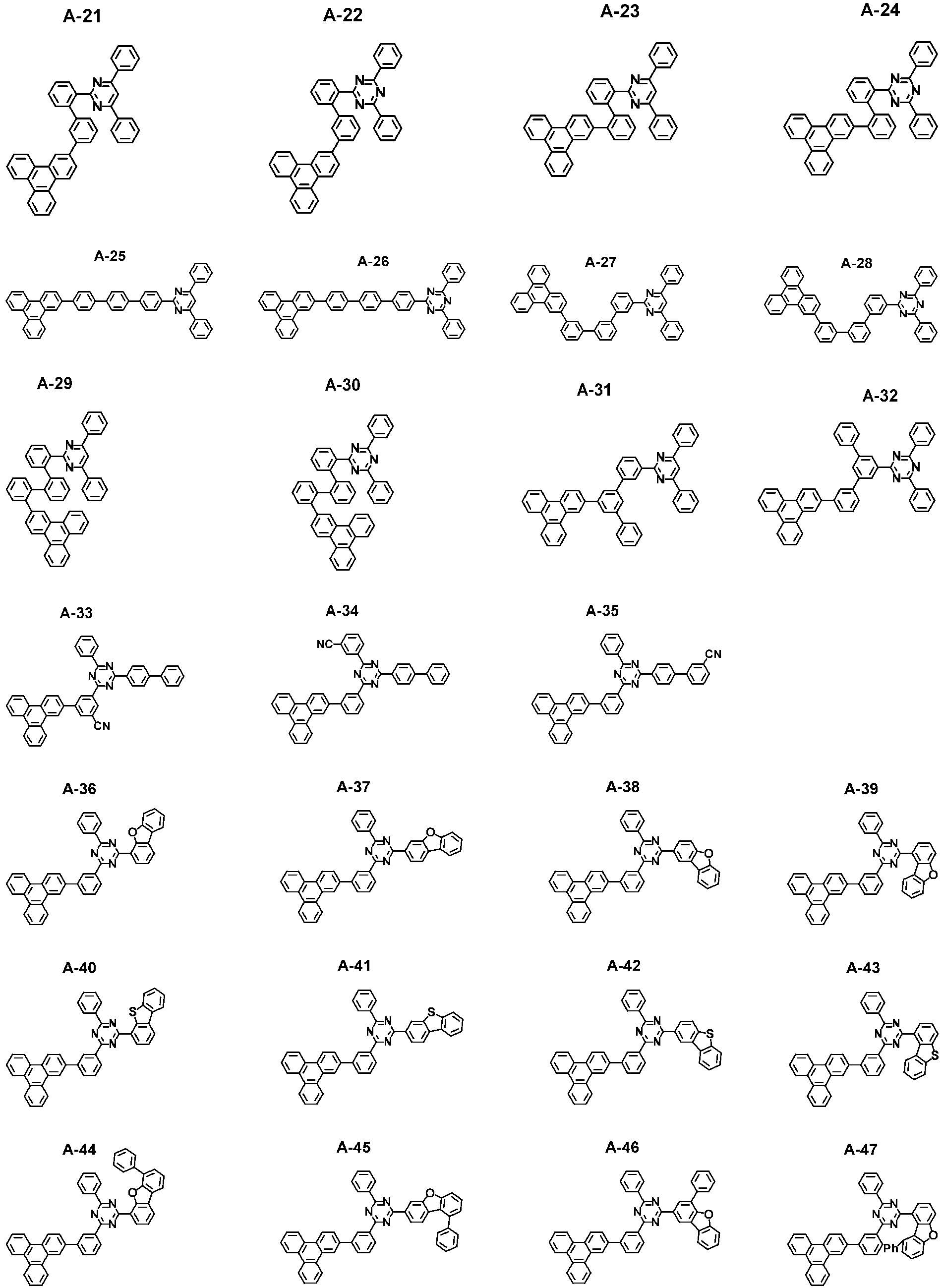

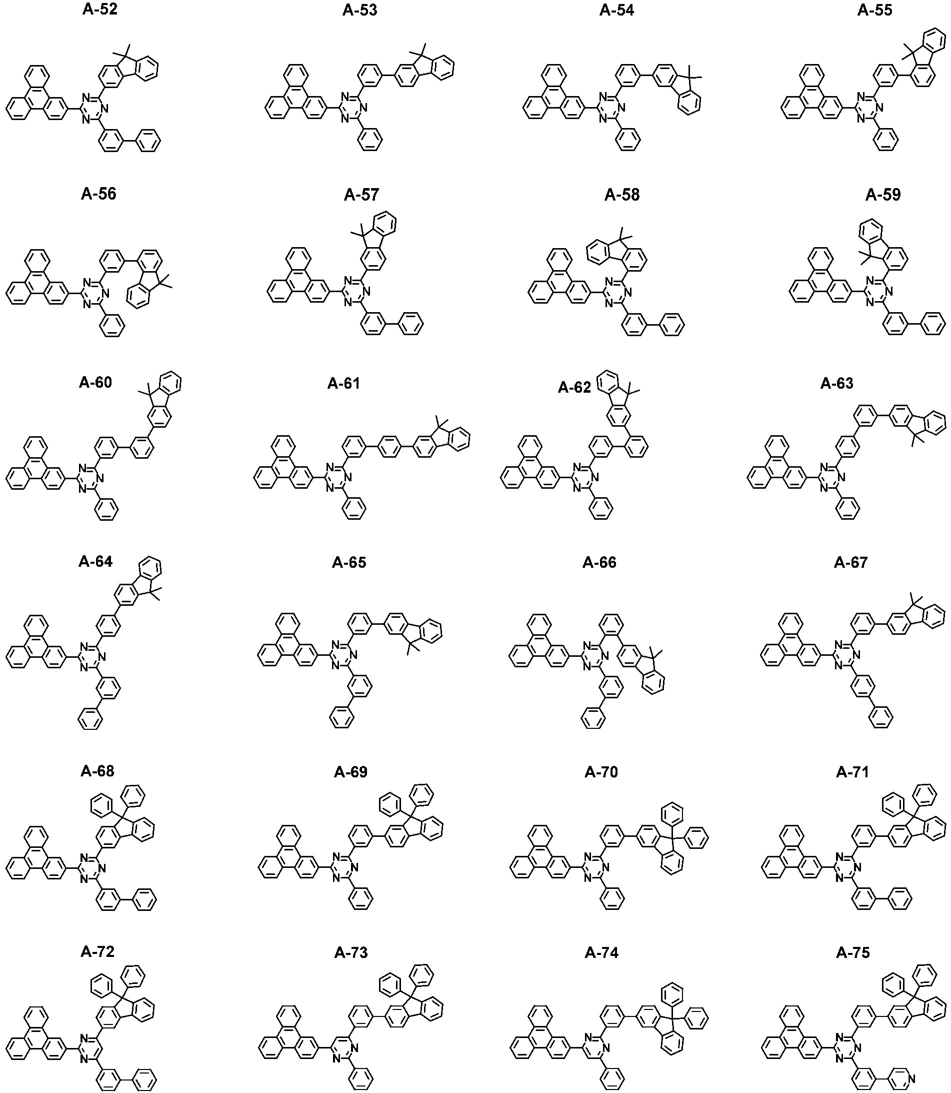

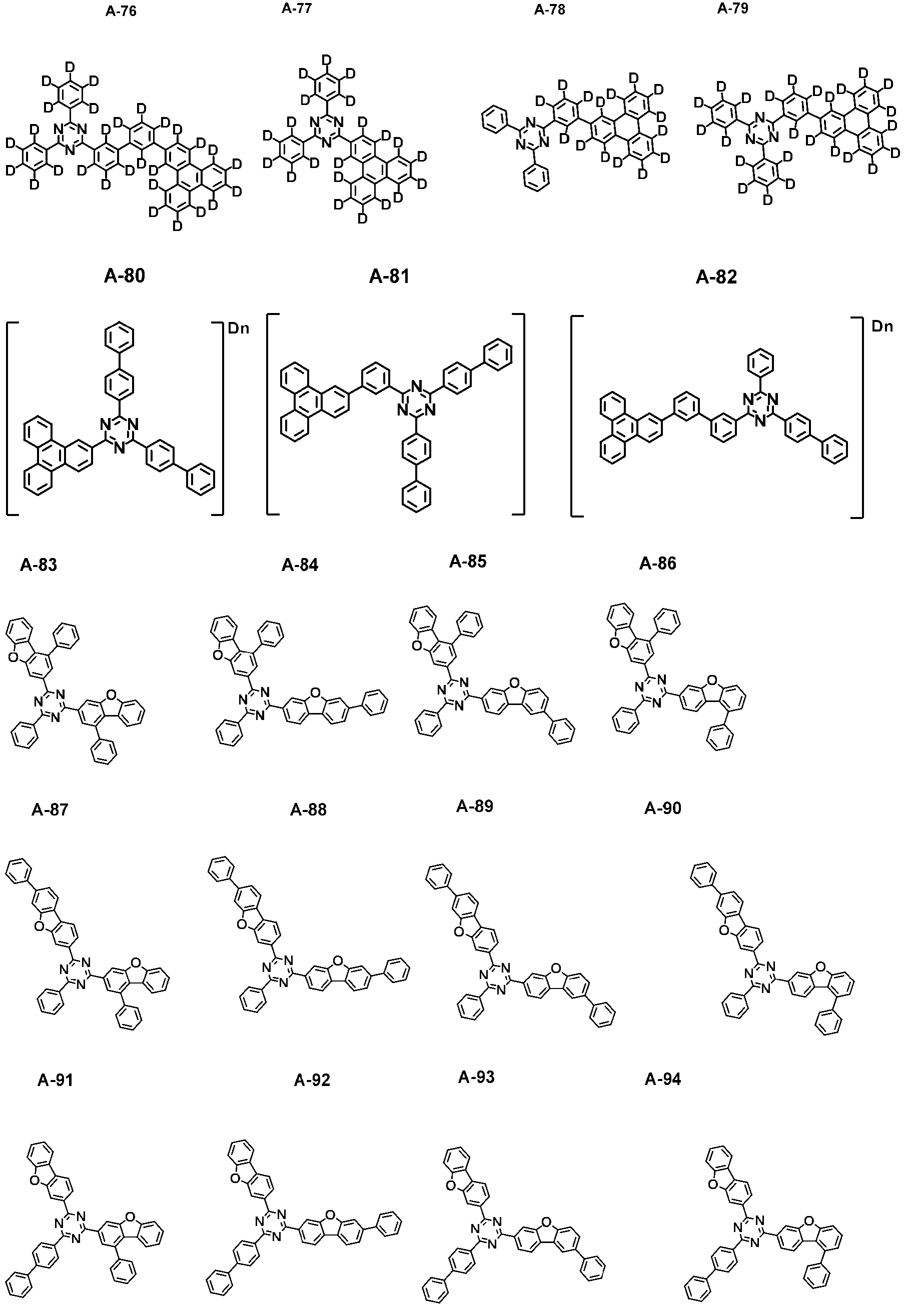

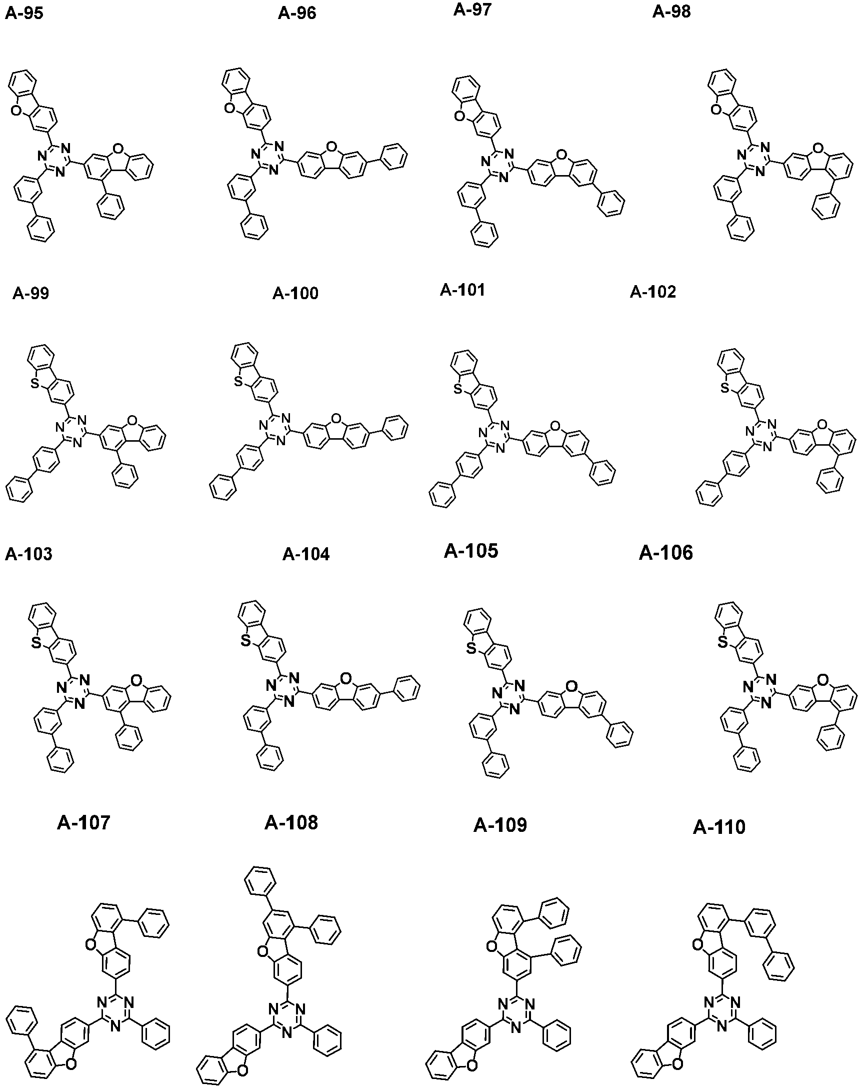

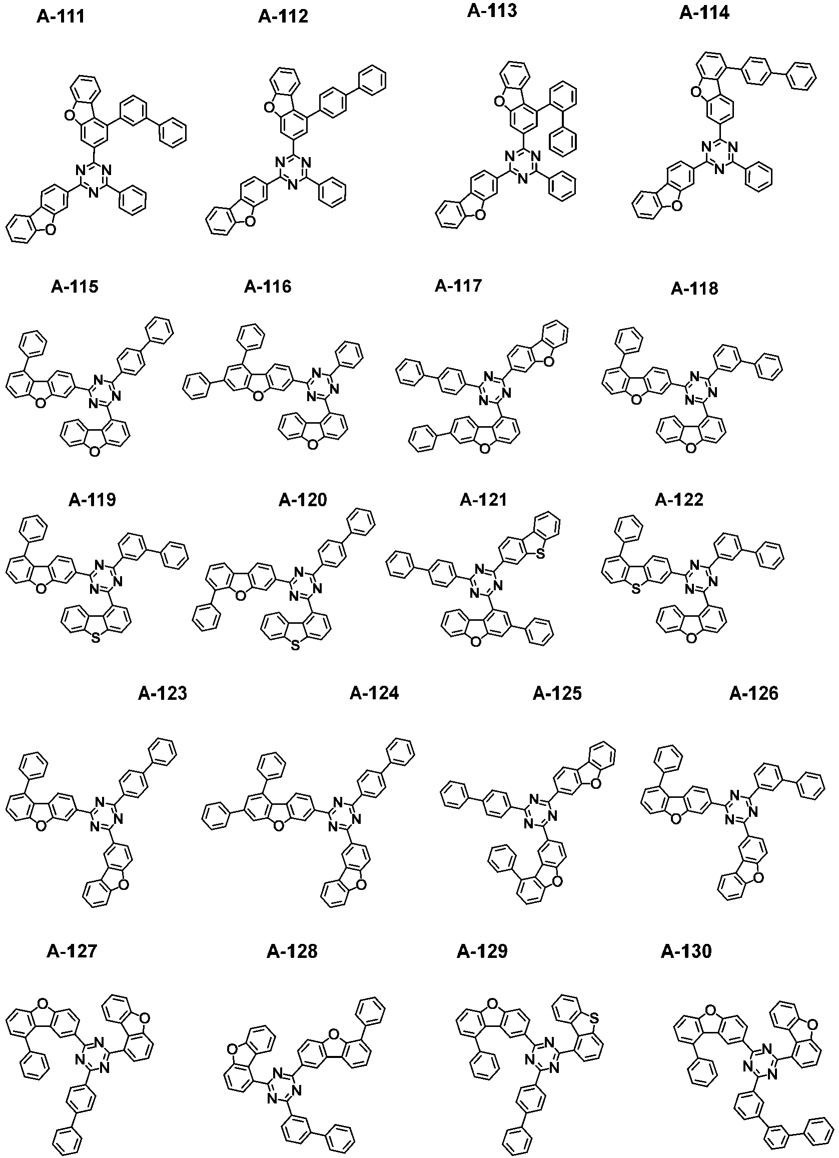

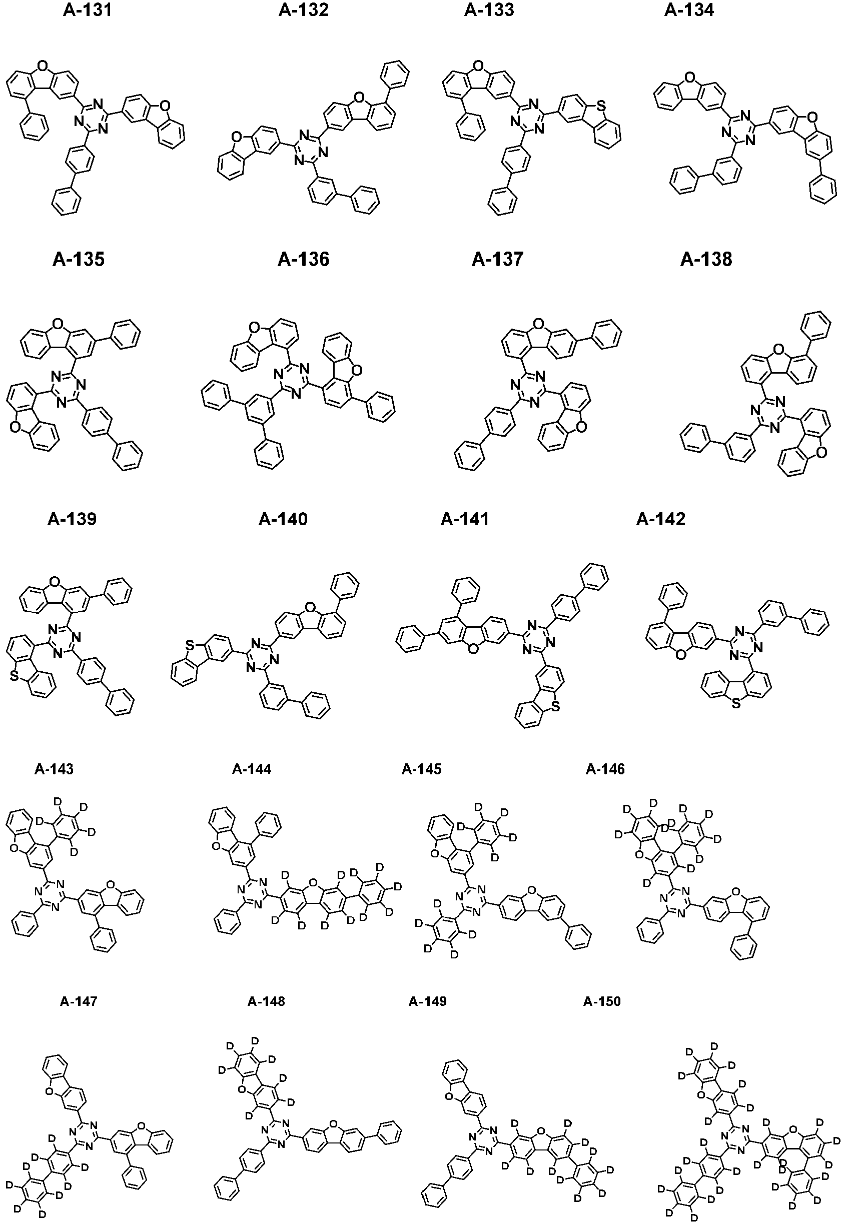

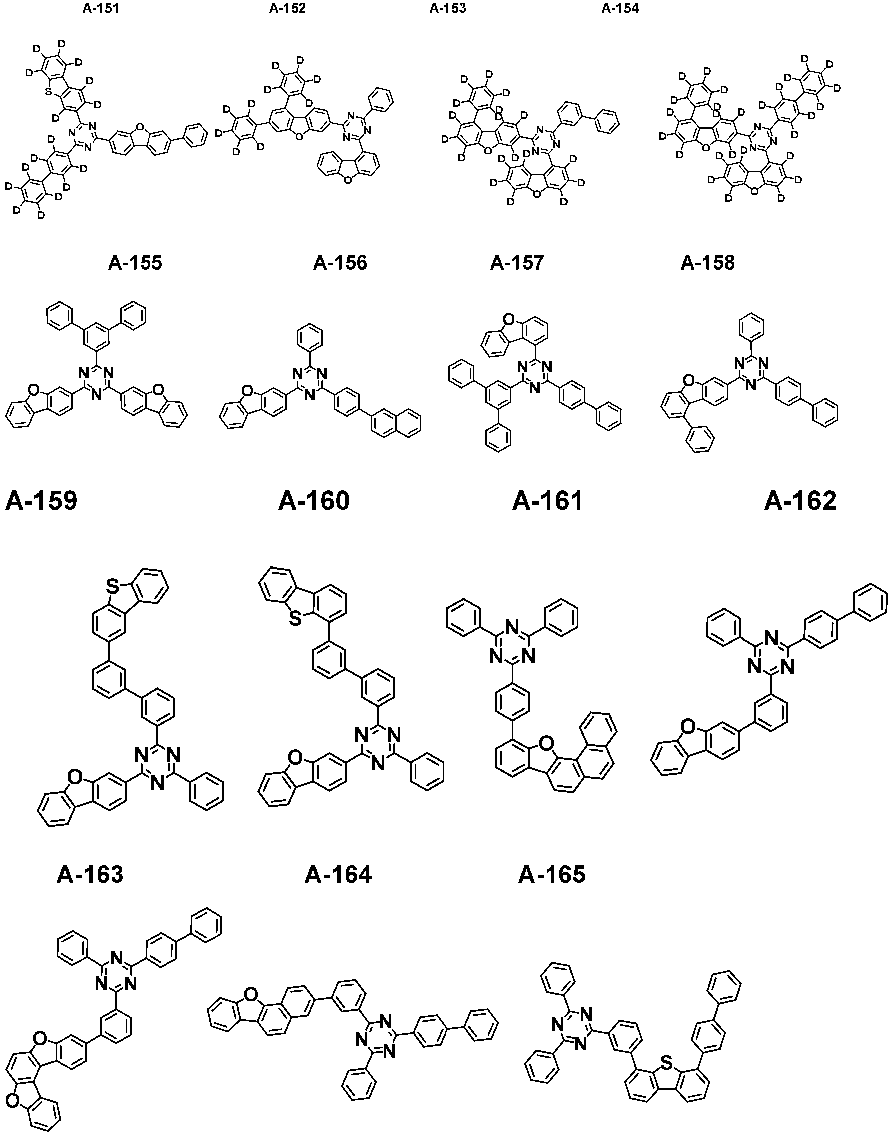

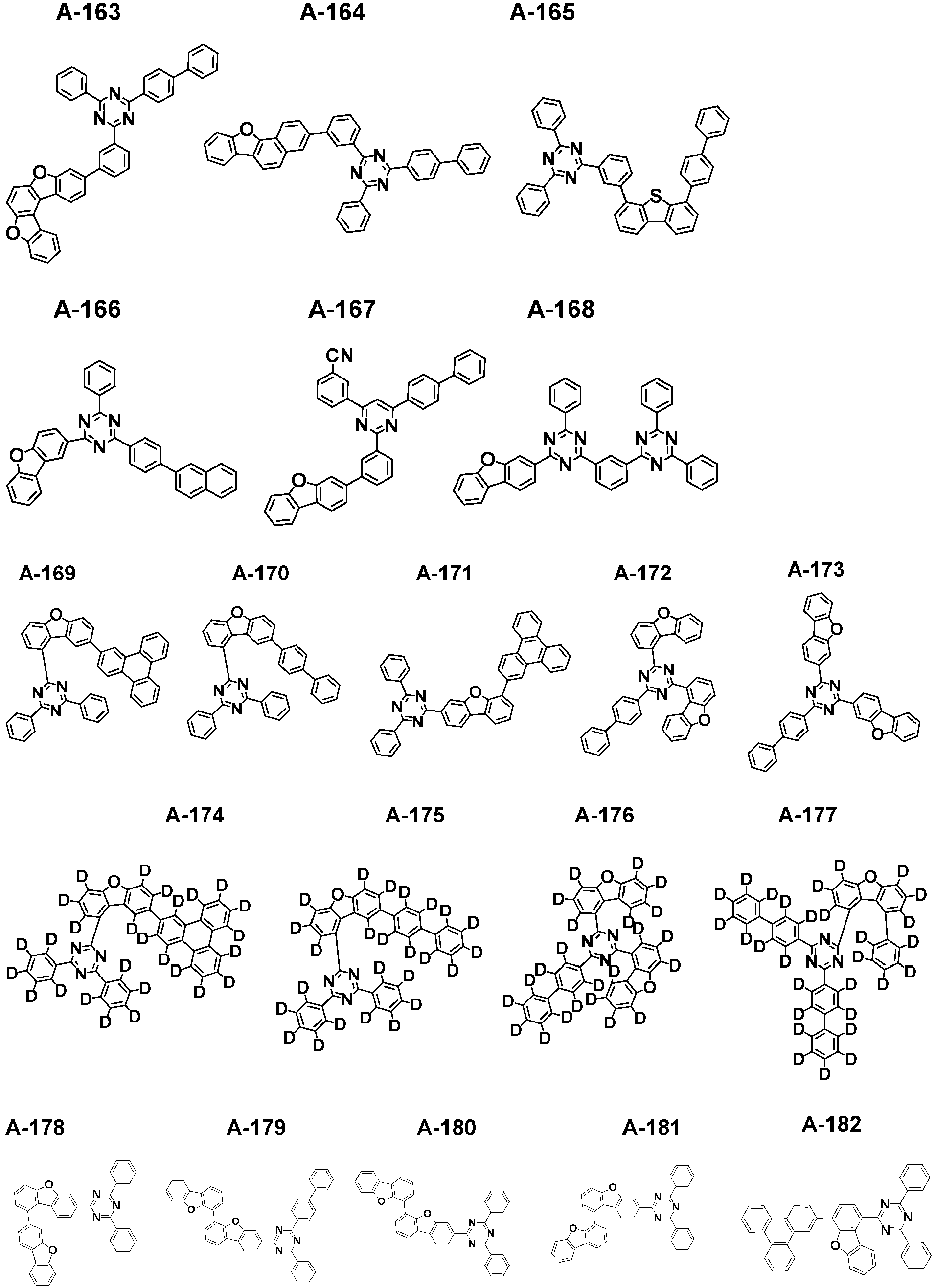

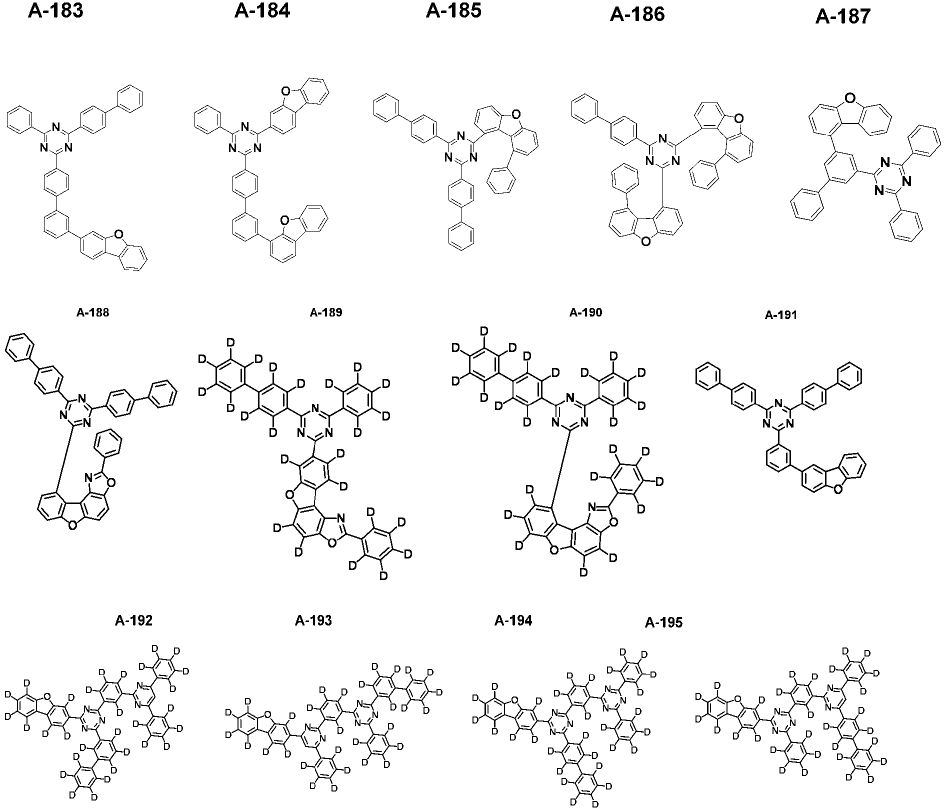

The third compound may be an electron transporting host and may be a compound including at least one of carbazole and indolocarbazole.

Meanwhile, if carbazole, which has excellent hole transport characteristics, is included as a host in the second light emitting layer, the hole trap index is relatively lowered, and the light emitting zone is relatively disposed toward the anode, thereby optimizing device performance.

The third compound may be represented by Chemical Formula 2.

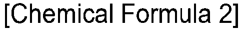

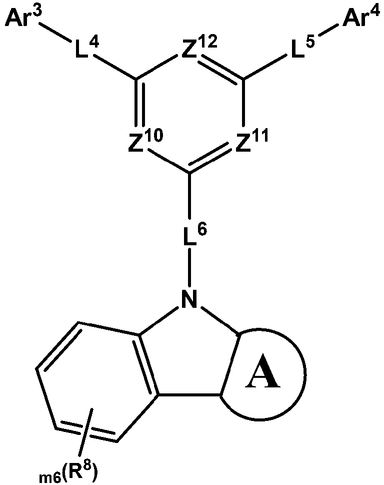

In Chemical Formula 2,
Z¹⁰ to Z¹² are each independently N or C-L^{c}-R^{e},
at least two of Z¹⁰ to Z¹² are N,
L^{c} and L⁴ to L⁶ are each independently a single bond, a substituted or unsubstituted C6 to C20 arylene group, a substituted or unsubstituted C2 to C20 heterocyclic group, or a combination thereof,
Ar³ and Ar⁴ are each independently a substituted or unsubstituted C6 to C30 aryl group, a substituted or unsubstituted C2 to C30 heterocyclic group, or a combination thereof,
R^{e} and R⁸ are each independently hydrogen, deuterium, a substituted or unsubstituted C1 to C30 alkyl group, a substituted or unsubstituted C6 to C30 aryl group, a substituted or unsubstituted C2 to C30 heterocyclic group, a substituted or unsubstituted silyl group, a substituted or unsubstituted amine group, a halogen, a cyano group, or a combination thereof, m6 is an integer of 1 to 4, and
ring A is represented by any one of Chemical Formula I -1 to Chemical Formula I -4, 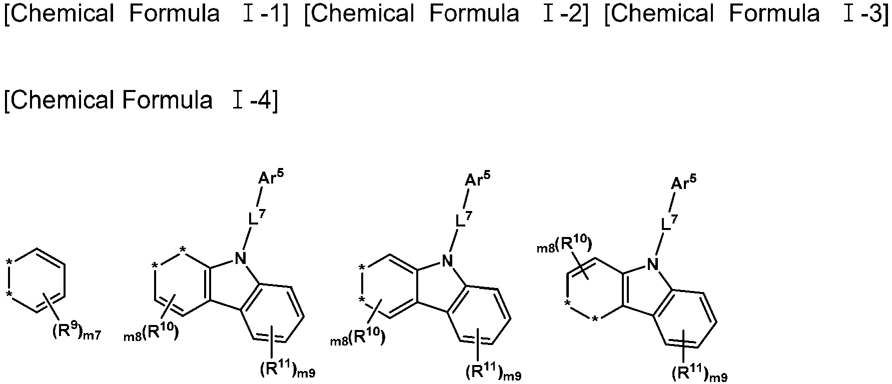
wherein, in Chemical Formula I -1 to Chemical Formula I-4,
R⁹ to R¹¹ are each independently hydrogen, deuterium, a substituted or unsubstituted C1 to C30 alkyl group, a substituted or unsubstituted C6 to C30 aryl group, a substituted or unsubstituted C2 to C30 heterocyclic group, a substituted or unsubstituted silyl group, a substituted or unsubstituted amine group, a halogen, a cyano group, or a combination thereof,
R⁸ and R⁹ are each independently present or adjacent groups are linked to form a substituted or unsubstituted C6 to C20 aryl group or a substituted or unsubstituted C2 to C30 heterocyclic group,
L⁷ is a single bond, a substituted or unsubstituted C6 to C20 arylene group, a substituted or unsubstituted C2 to C20 heterocyclic group, or a combination thereof,
Ar⁵ is a substituted or unsubstituted C6 to C30 aryl group, a substituted or unsubstituted C2 to C30 heterocyclic group, or a combination thereof,
m7 and m11 are each independently one of integers of 1 to 4,
m8 is an integer of 1 or 2, and
* is a linking point.

When m6 is greater than or equal to 2, each R⁸ may be the same as or different from each other.

When m7 is greater than or equal to 2, each R⁹ may be the same as or different from each other.

When m8 is greater than or equal to 2, each R¹⁰ may be the same as or different from each other.

When m9 is greater than or equal to 2, each R¹¹ may be the same as or different from each other.

Chemical Formula 2 may be represented by any one of Chemical Formula 2A to Chemical Formula 2G according to specific structure of carbazole and carbazole derivative.

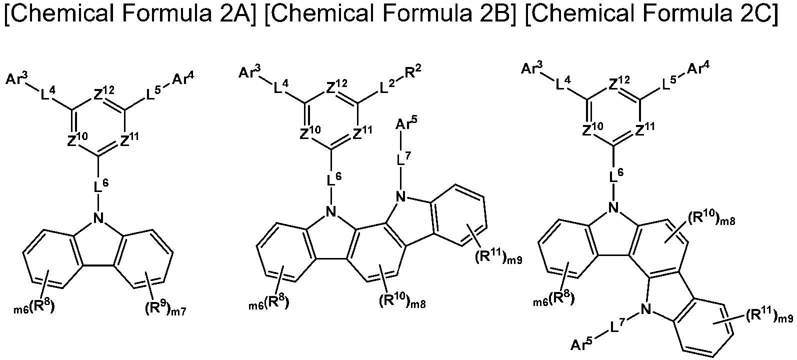

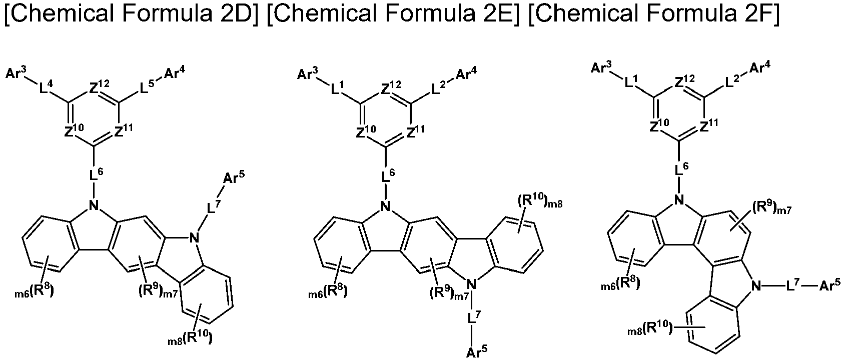

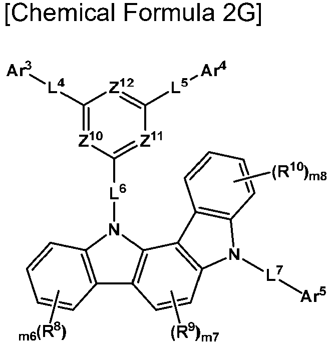

In Chemical Formula 2A to Chemical Formula 2G, Z¹⁰ to Z¹², L⁴ to L⁷, R⁸ to R¹⁰, Ar³ to Ar⁵, and m6 to m8 are the same as described above.

Specifically, in Chemical Formula 2A, R⁸ to R⁹ may each independently be hydrogen, deuterium, a substituted or unsubstituted phenyl group, a substituted or unsubstituted biphenyl group, a substituted or unsubstituted terphenyl group, a substituted or unsubstituted carbazolyl group, a substituted or unsubstituted indolocarbazolyl group, a substituted or unsubstituted dibenzofuranyl group, or a substituted or unsubstituted dibenzothiophenyl group.

For example, in Chemical Formula 2A, R⁸ and R⁹ may each independently be hydrogen, deuterium, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

For example, in Chemical Formula 2B to Chemical Formula 2G, R⁸, R¹⁰, and R¹¹ may each independently be hydrogen, deuterium, or a substituted or unsubstituted phenyl group.

As a specific example, the third compound may be represented by Chemical Formula 2A or Chemical Formula 2B.

According to a specific embodiment of the present invention, in Chemical Formula 2A, L⁴ to L⁶ may each independently be a single bond or a substituted or unsubstituted phenylene group, Ar³ and Ar⁴ may each independently be a substituted or unsubstituted phenyl group, substituted or unsubstituted biphenyl group, a substituted or unsubstituted carbazolyl group, a substituted or unsubstituted dibenzofuranyl group, or a substituted or unsubstituted dibenzothiophenyl group, and R⁸ and R⁹ may each independently be hydrogen, deuterium, or a substituted or unsubstituted dibenzothiophenyl group, but they are not limited thereto.

The third compound may be, for example, one selected from compounds of Group 2.

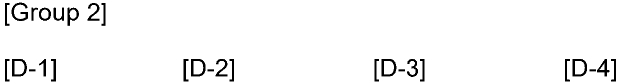

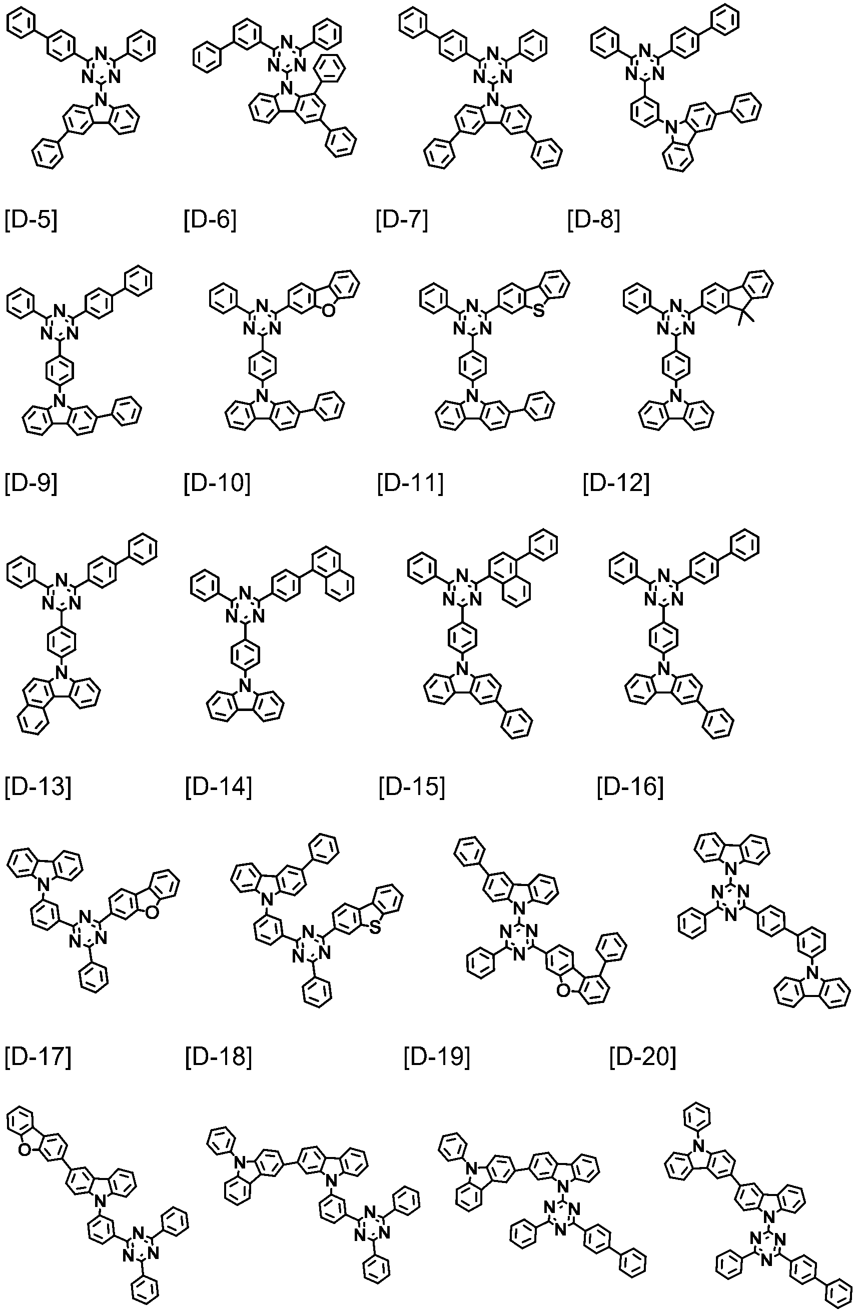

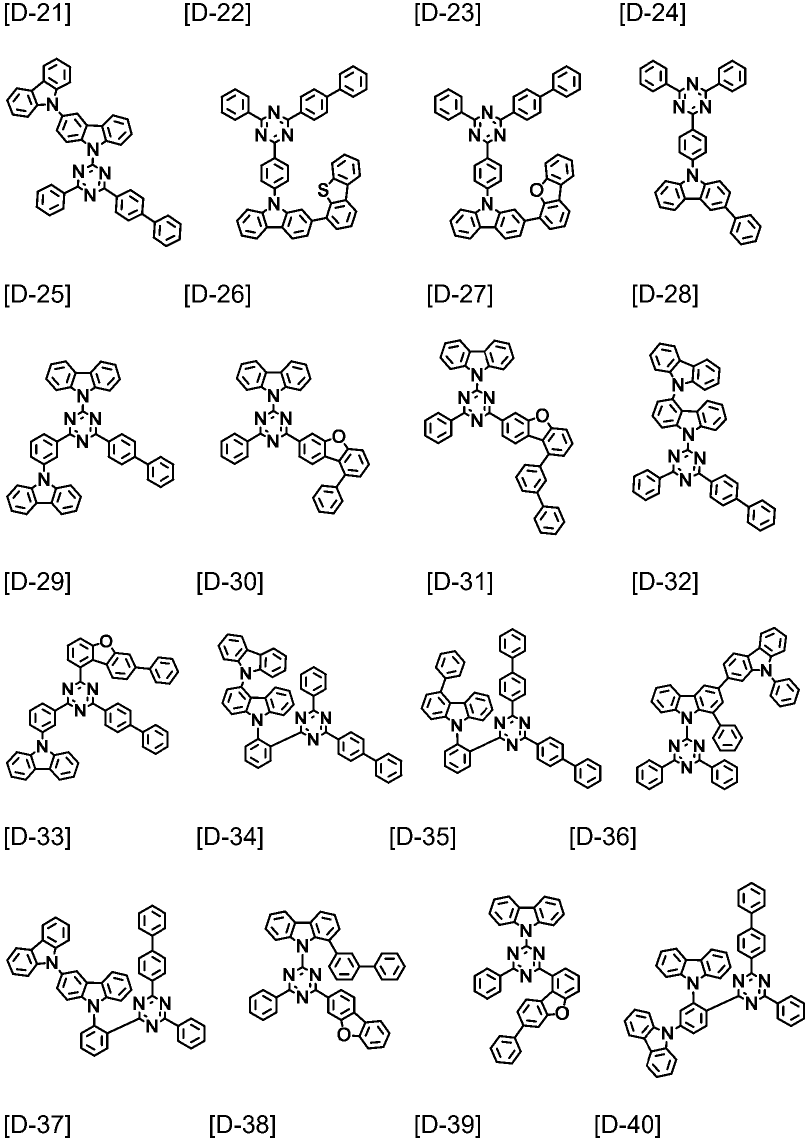

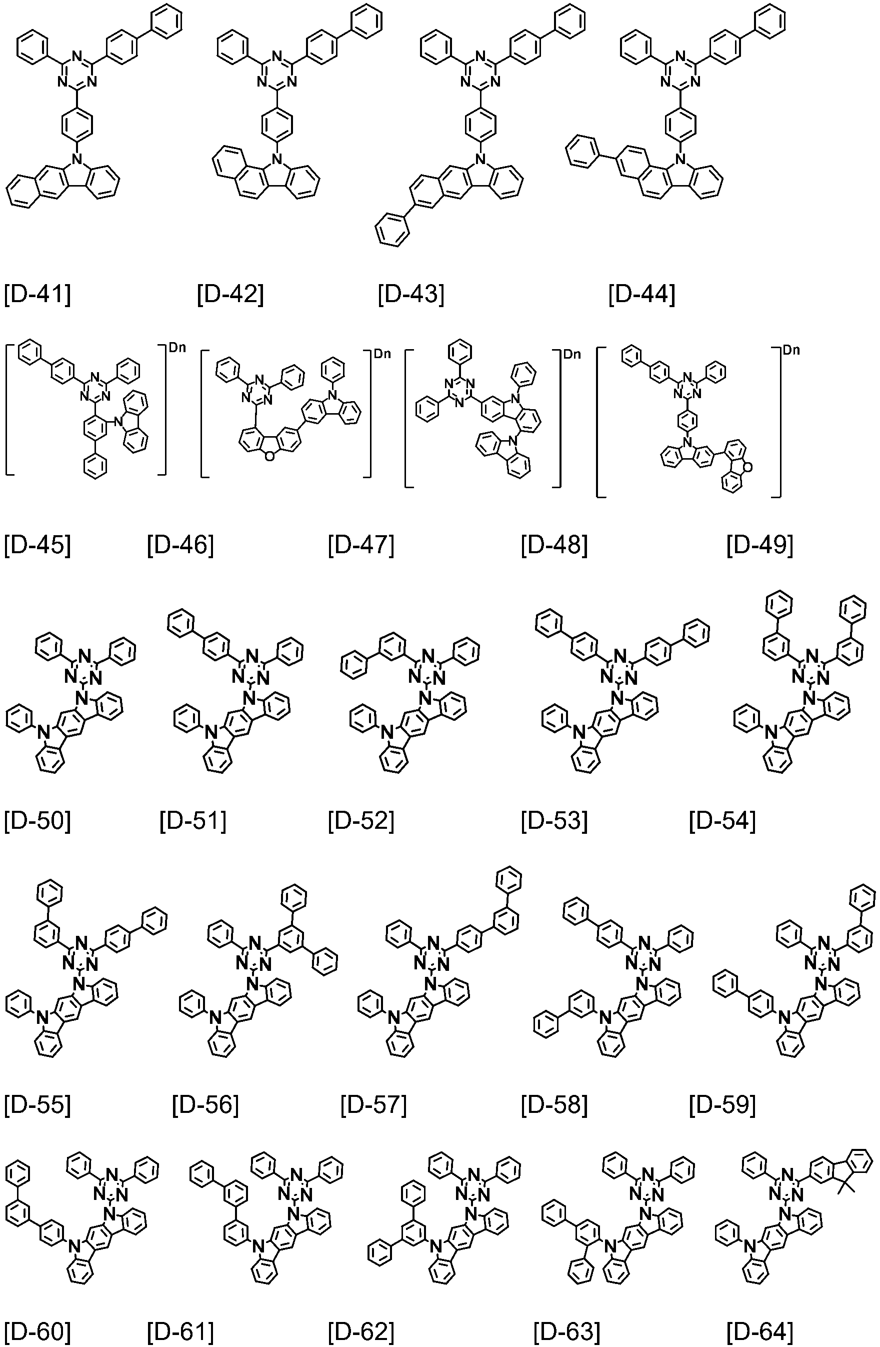

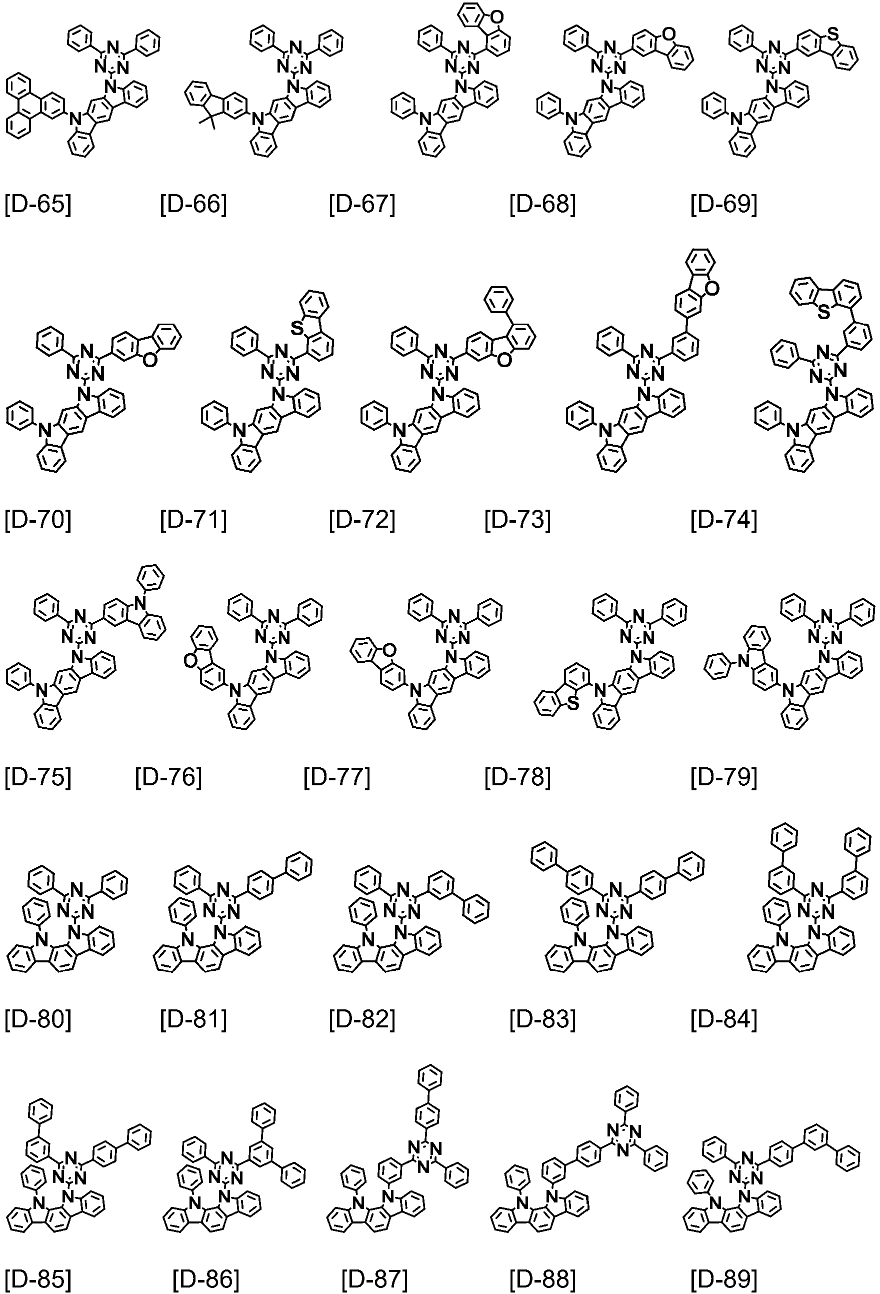

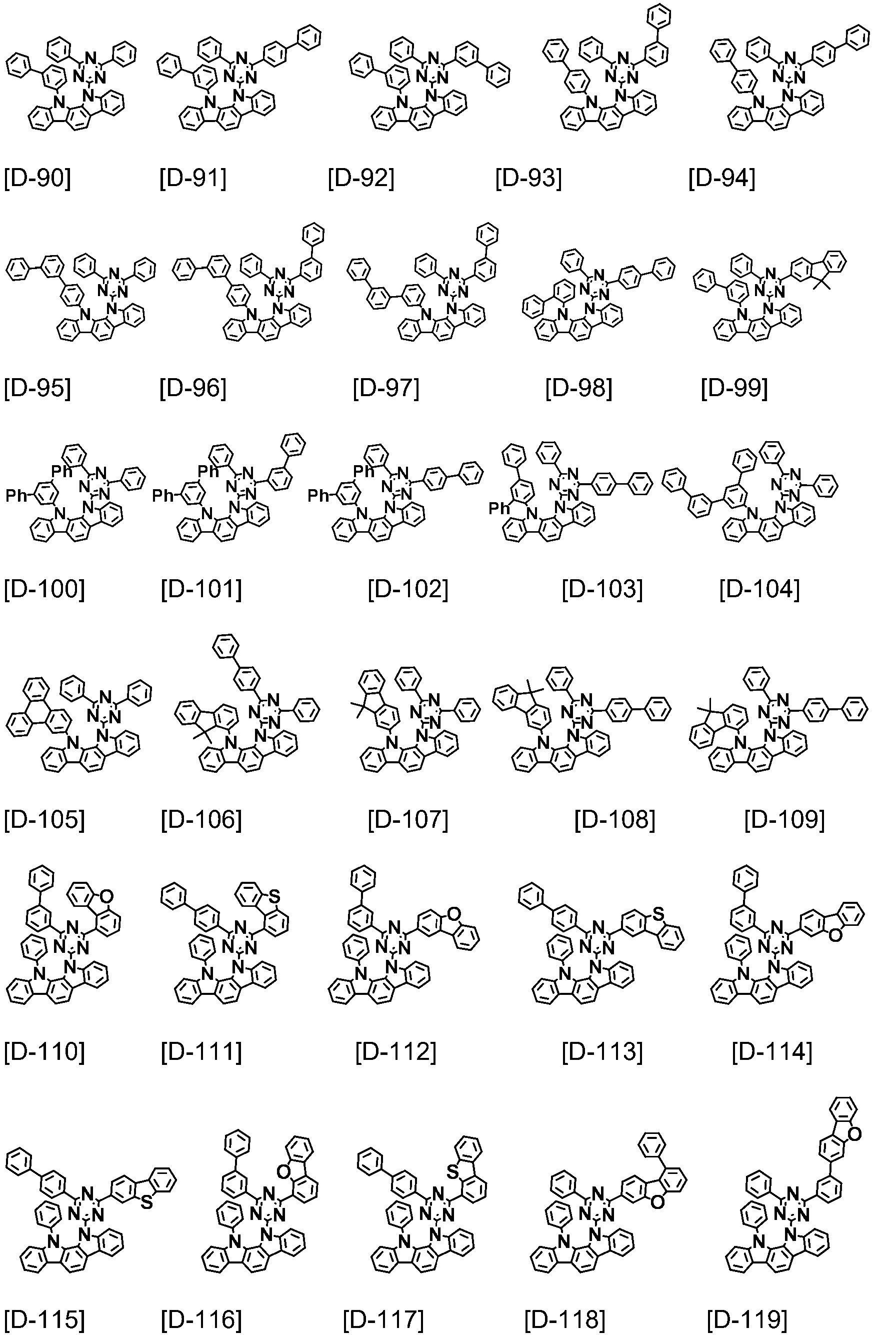

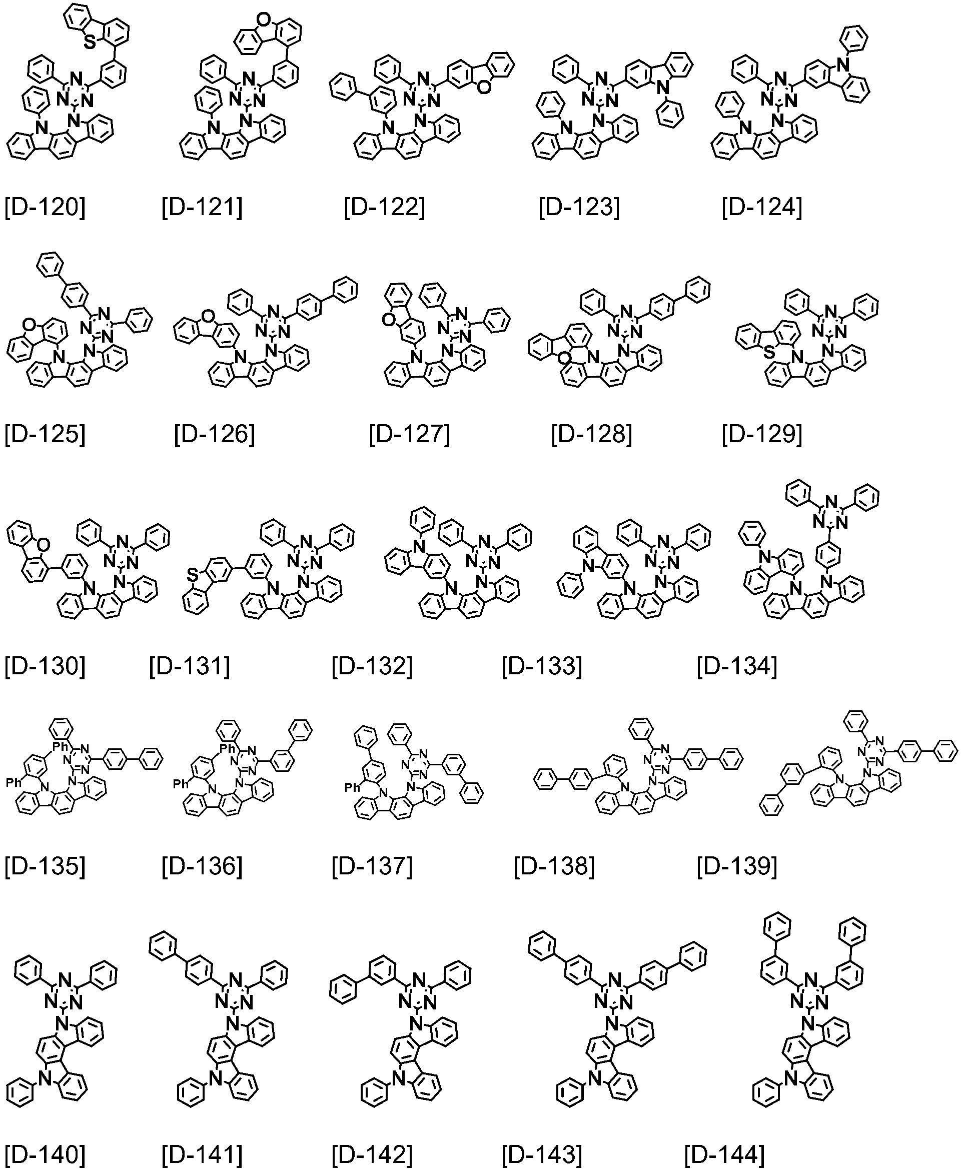

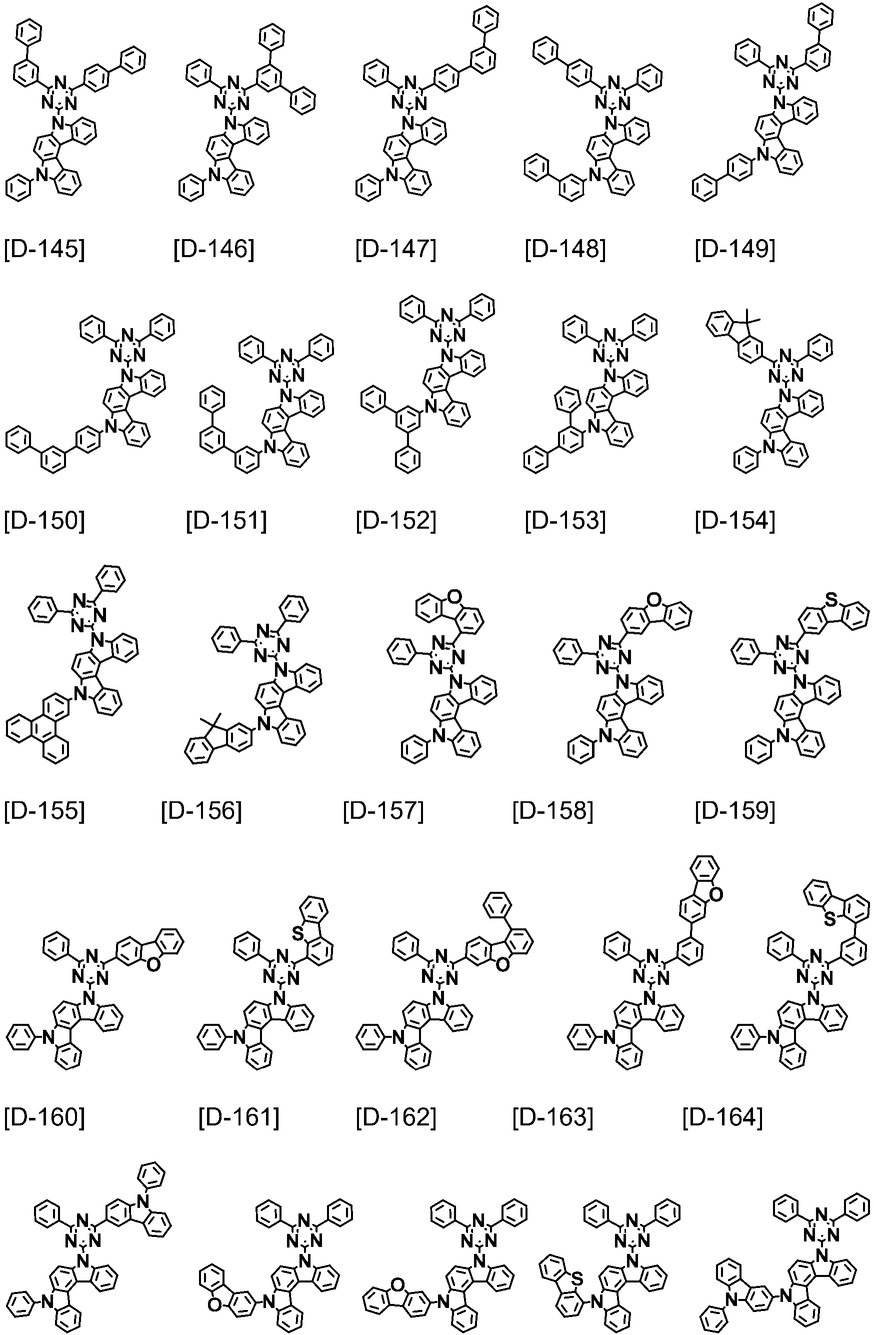

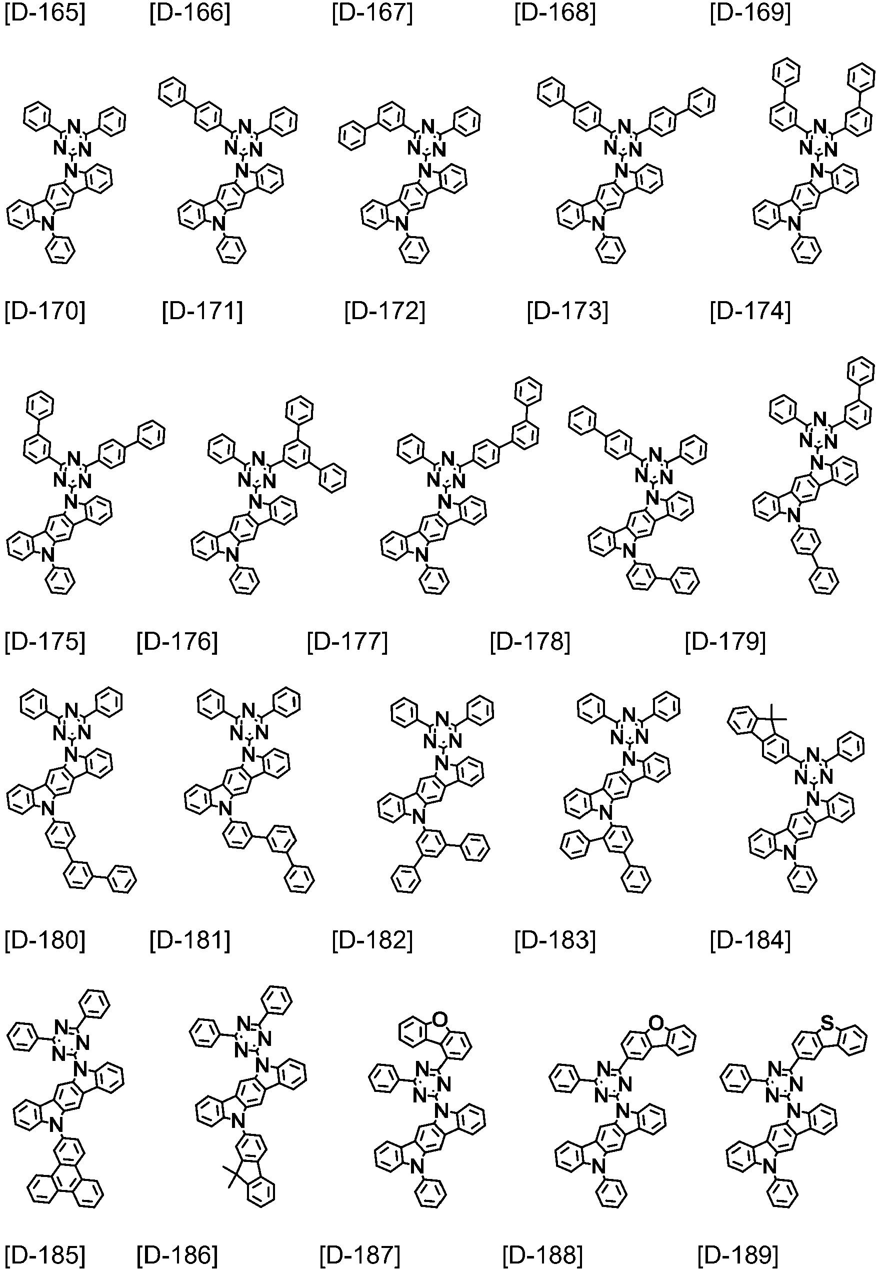

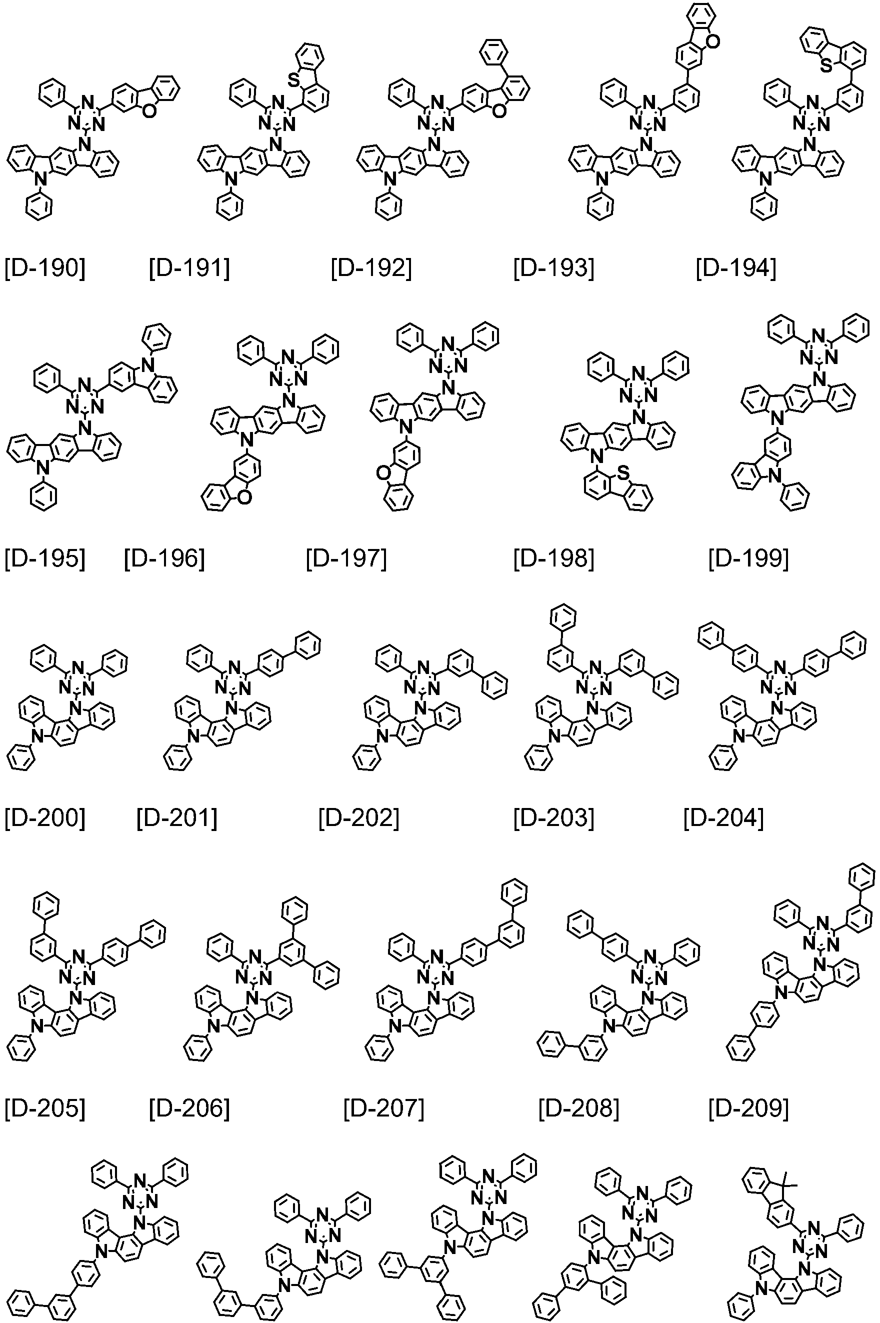

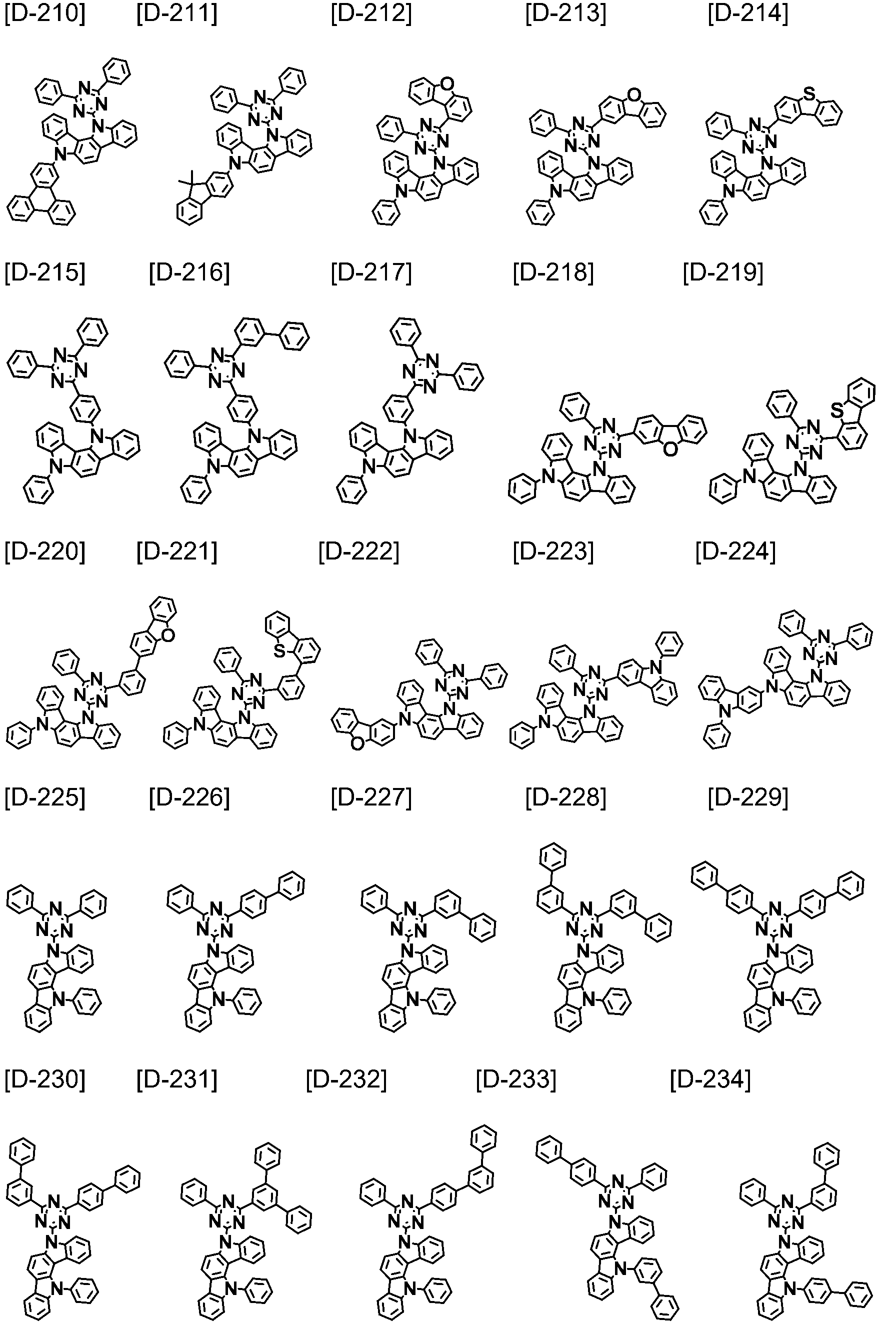

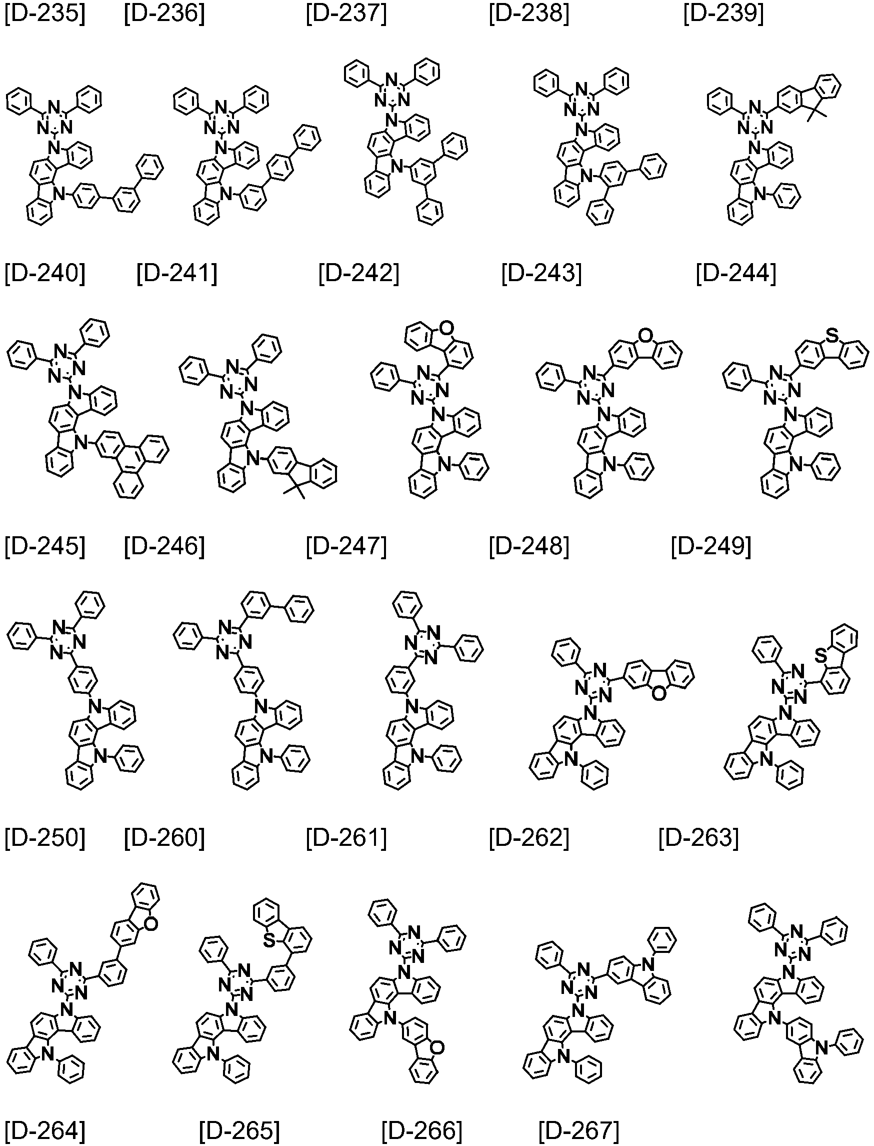

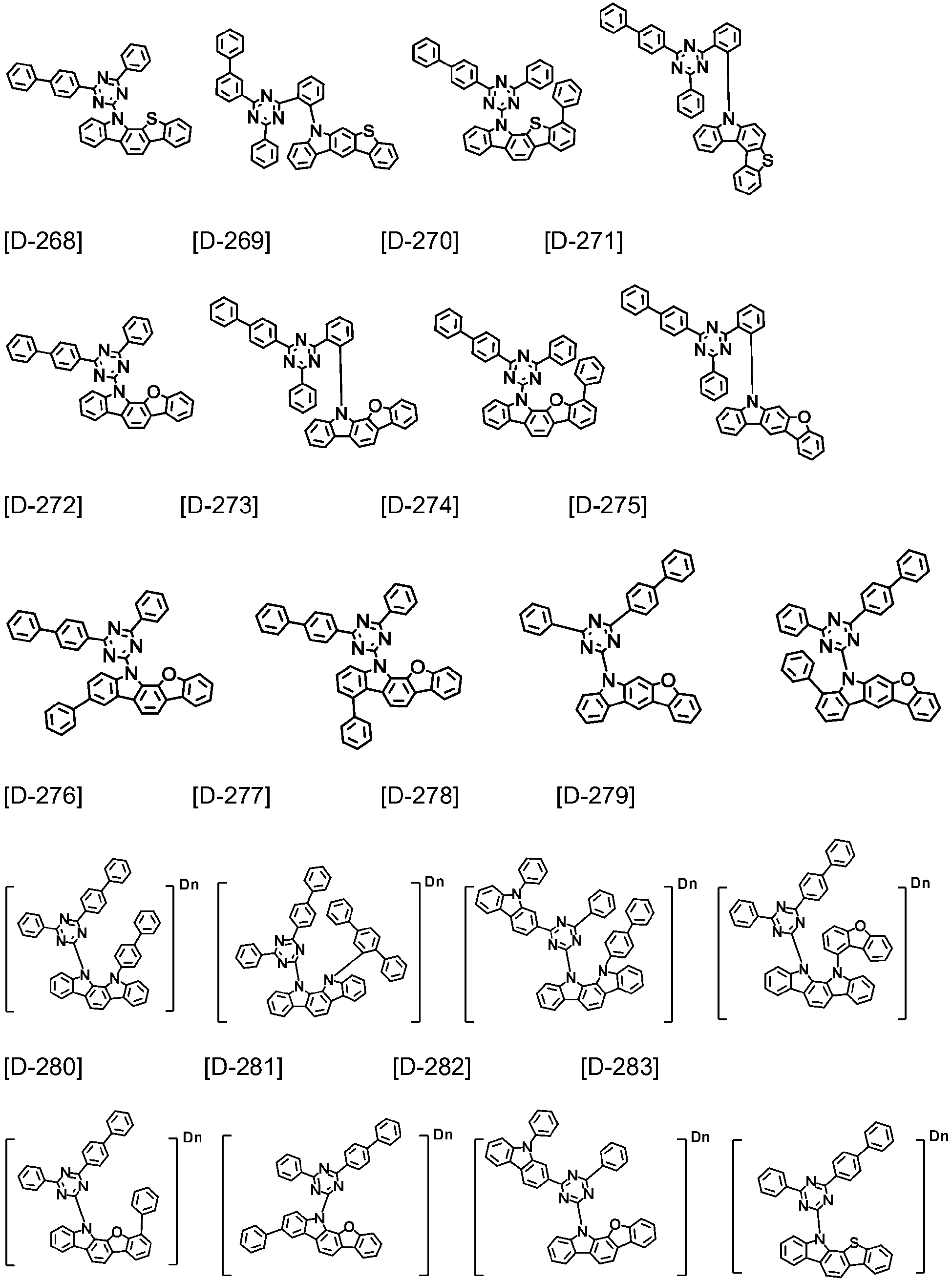

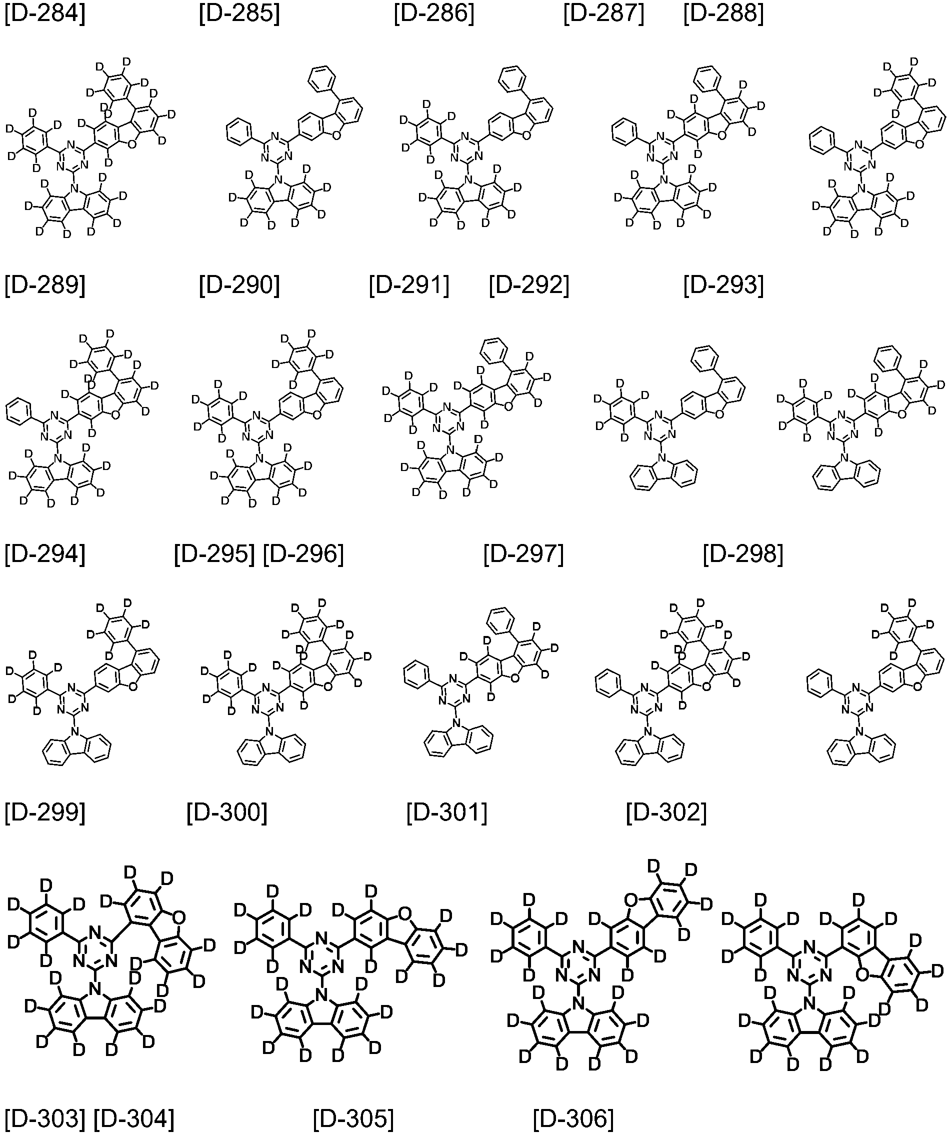

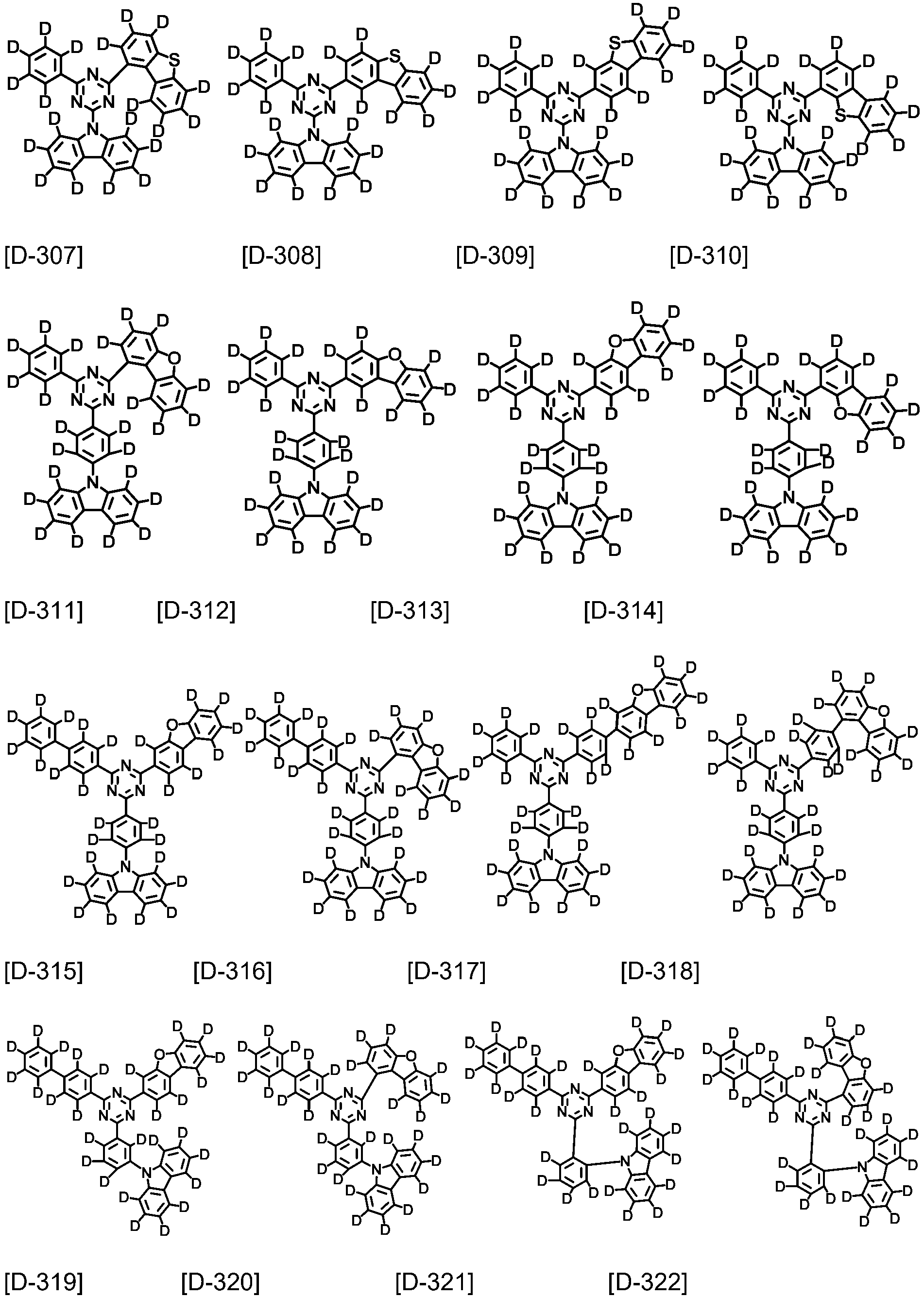

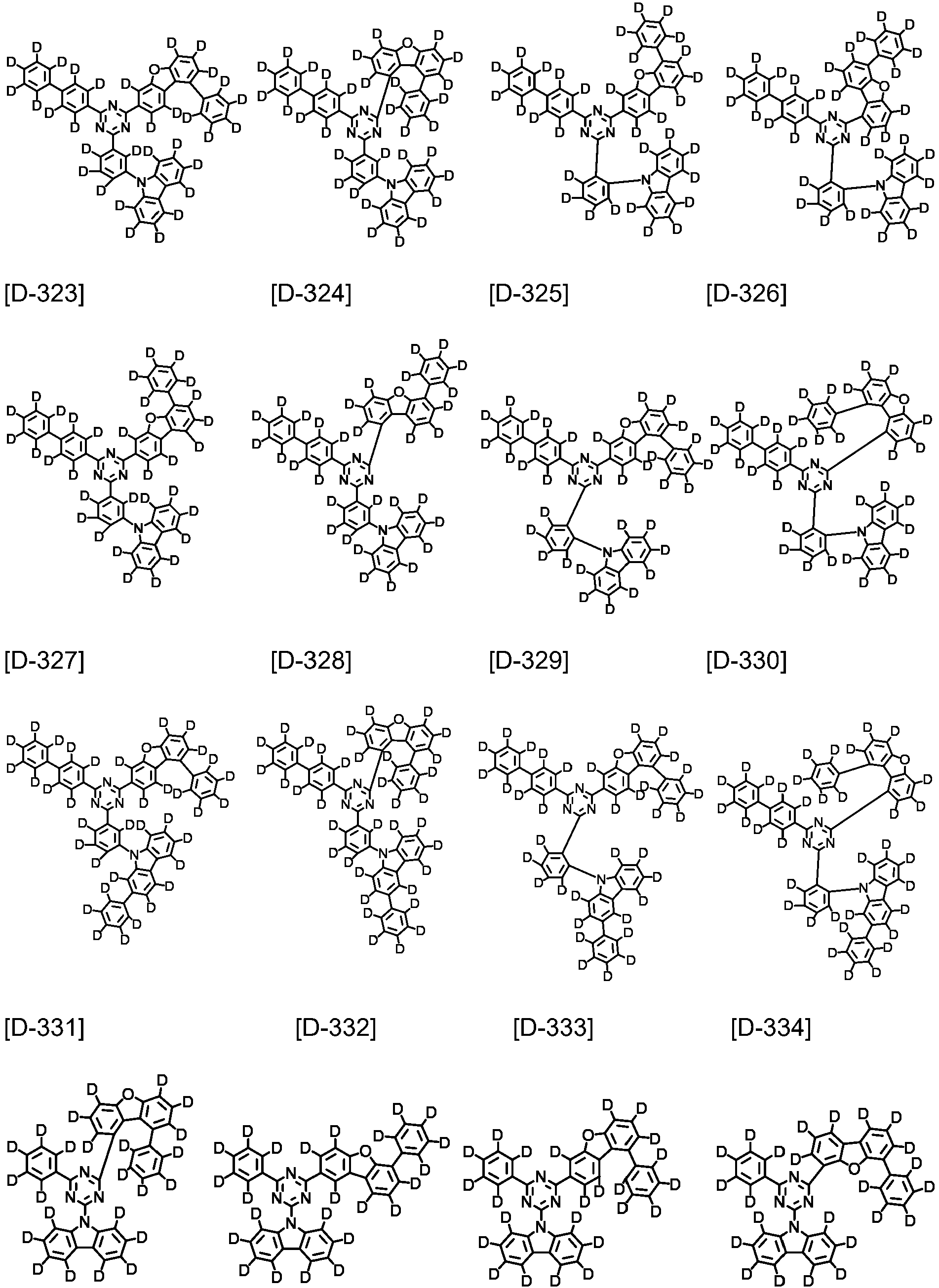

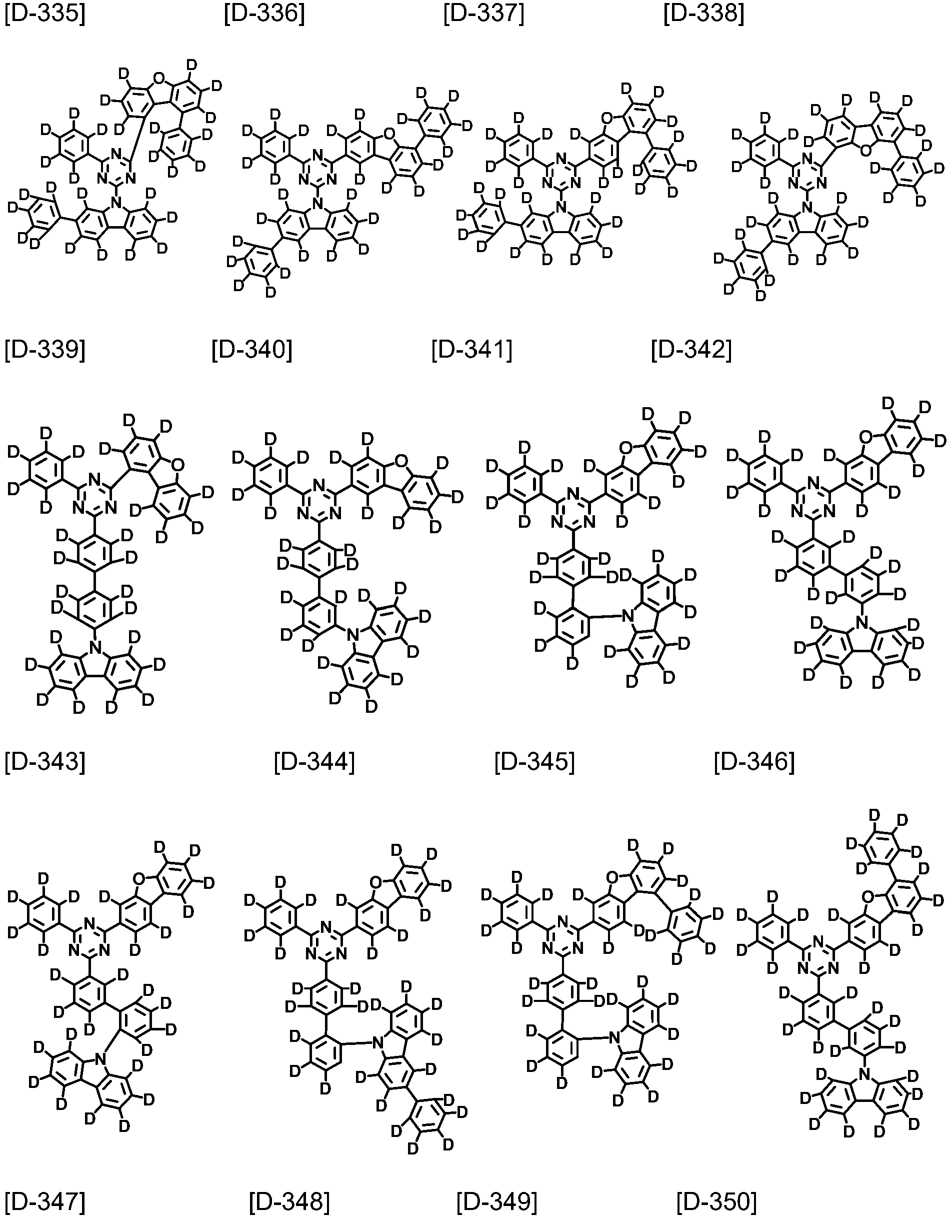

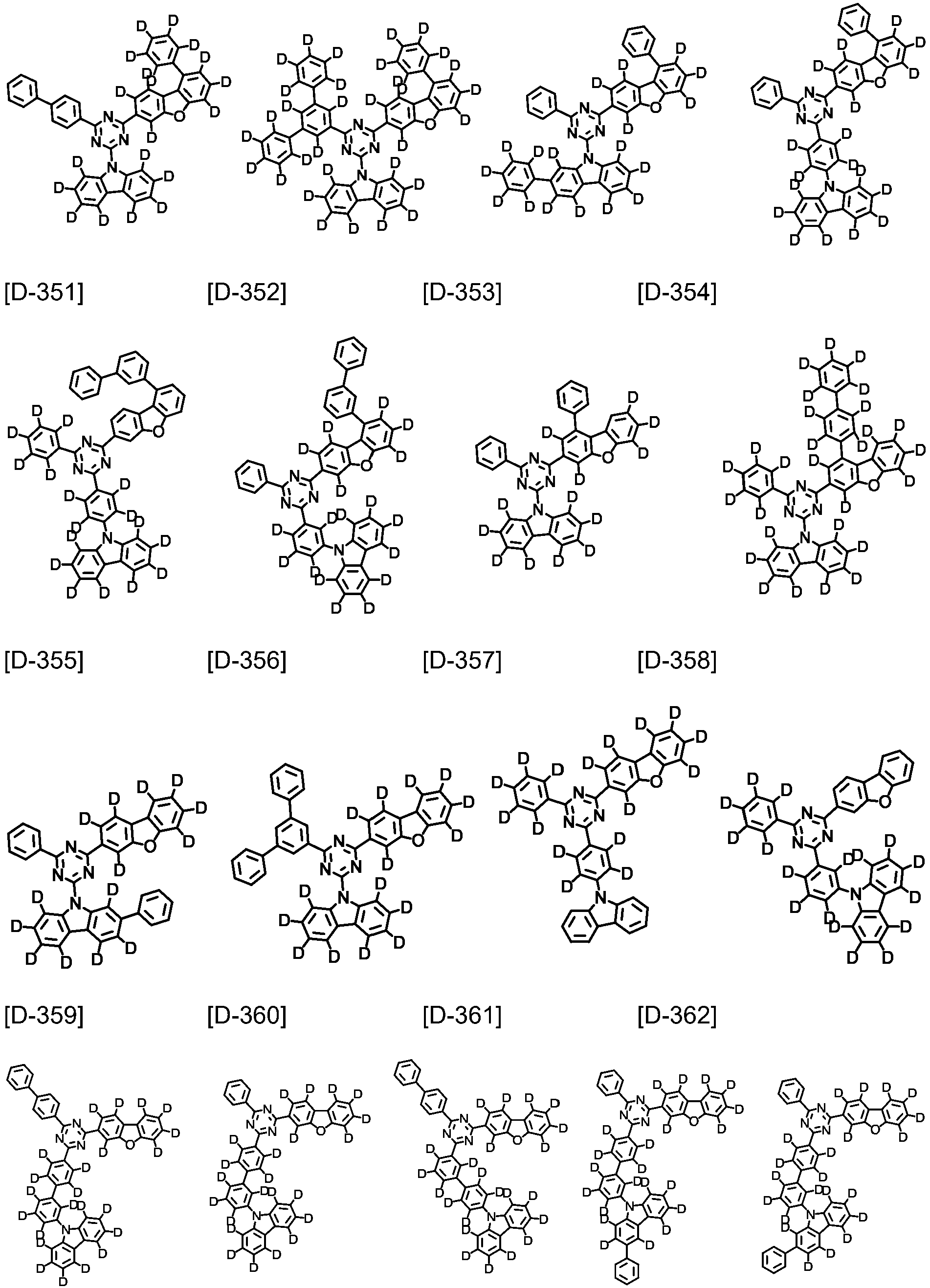

The second compound and the fourth compound may be hole transporting hosts, may be the same or different, and may each independently be a compound including at least one of carbazole and indolocarbazole.

The second compound and the fourth compound may be each independently represented by Chemical Formula 3 or a combination of Chemical Formula 4 and Chemical Formula 5.

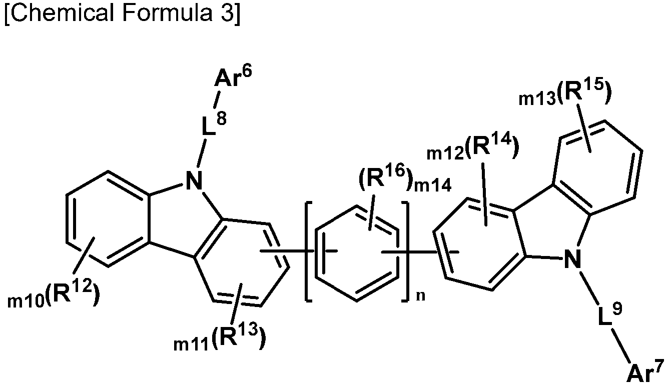

In Chemical Formula 3,
Ar⁶ and Ar⁷ are each independently a substituted or unsubstituted C6 to C30 aryl group or a substituted or unsubstituted C2 to C30 heterocyclic group,
L⁸ and L⁹ are each independently a single bond or a substituted or unsubstituted C6 to C20 arylene group,
R¹² to R¹⁶ are each independently hydrogen, deuterium, a cyano group, a halogen, a substituted or unsubstituted amine group, a substituted or unsubstituted C1 to C30 alkyl group, a substituted or unsubstituted silyl group, a substituted or unsubstituted C6 to C30 aryl group, or a substituted or unsubstituted C2 to C30 heterocyclic group,
m10, m13, and m14 are each independently one of integers of 1 to 4,
m11 and m12 are each independently one of integers of 1 to 3, and
n is one of integers of 0 to 2;

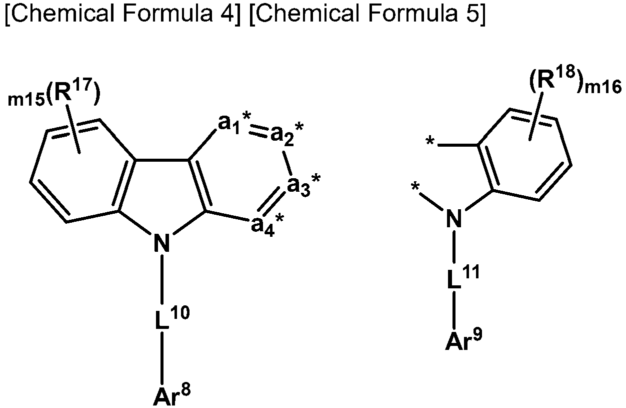

wherein, in Chemical Formula 4 and Chemical Formula 5,
Ar⁸ and Ar⁹ are each independently a substituted or unsubstituted C6 to C30 aryl group or a substituted or unsubstituted C2 to C30 heterocyclic group,
a₁* to a₄* in Chemical Formula 4 are each independently a linking carbon (C) or C-L^{d}-R^{f},
the two adjacent of a₁* to a₄* in Chemical Formula 4 are linked to *s in Chemical Formula 5,
L^{d}, L¹⁰, and L¹¹ are each independently a single bond or a substituted or unsubstituted C6 to C20 arylene group,
R^{f}, R¹⁷, and R¹⁸ are each independently hydrogen, deuterium, a cyano group, a halogen, a substituted or unsubstituted amine group, a substituted or unsubstituted C1 to C30 alkyl group, a substituted or unsubstituted silyl group, a substituted or unsubstituted C6 to C30 aryl group, or a substituted or unsubstituted C2 to C30 heterocyclic group, and
m15 and m16 are each independently one of integers of 1 to 4.

In Chemical Formula 3, when m10 is greater than or equal to 2, each R¹² may be same or different from each other.

In Chemical Formula 2, when m11 is greater than or equal to 2, each R¹³ may be same or different from each other.

In Chemical Formula 2, when m12 is greater than or equal to 2, each R¹⁴ may be same or different from each other.

In Chemical Formula 2, when m13 is greater than or equal to 2, each R¹⁵ may be same or different from each other.

In Chemical Formula 2, when m14 is greater than or equal to 2, each R¹⁶ may be same or different from each other.

For example, Ar⁶ and Ar⁷ in Chemical Formula 3 may each independently be a substituted or unsubstituted C6 to C20 aryl group or a substituted or unsubstituted C2 to C20 heterocyclic group.

For example, Ar⁶ and Ar⁷ in Chemical Formula 3 may each independently be a substituted or unsubstituted C6 to C20 aryl group or a substituted or unsubstituted C2 to C20 heterocyclic group.

For example, R¹² to R¹⁶ in Chemical Formula 3 may each independently be hydrogen, deuterium, a cyano group, a halogen group, a substituted or unsubstituted amine group, a substituted or unsubstituted C1 to C10 alkyl group, a substituted or unsubstituted C6 to C20 aryl group, or a substituted or unsubstituted C2 to C20 heterocyclic group.

As a specific example Ar⁶ and Ar⁷ in Chemical Formula 3 may each independently be a substituted or unsubstituted C6 to C20 aryl group, a substituted or unsubstituted dibenzofuranyl group, a substituted or unsubstituted dibenzothiophenyl group, or a substituted or unsubstituted carbazolyl group.

In Chemical Formula 4 and Chemical Formula 5, when m15 is greater than or equal to 2, each R¹⁷ may be same or different from each other.

In Chemical Formula 4 and Chemical Formula 5, when m16 is greater than or equal to 2, each R¹⁸ may be same or different from each other.

For example, Ar⁸ and Ar⁹ in Chemical Formula 4 and Chemical Formula 5 may each independently be a substituted or unsubstituted C6 to C20 aryl group or a substituted or unsubstituted C2 to C20 heterocyclic group.

For example, R^{f}, R¹⁷ and R¹⁸ in Chemical Formula 4 and Chemical Formula 5 may each independently be hydrogen, deuterium, a cyano group, a halogen group, a substituted or unsubstituted amine group, a substituted or unsubstituted C1 to C10 alkyl group, a substituted or unsubstituted C6 to C20 aryl group, or a substituted or unsubstituted C2 to C20 heterocyclic group.

As a specific example, Ar⁸ and Ar⁹ in Chemical Formula 4 and Chemical Formula 5 may each independently be a substituted or unsubstituted C6 to C20 aryl group, a substituted or unsubstituted dibenzofuranyl group, a substituted or unsubstituted dibenzothiophenyl group, or a substituted or unsubstituted carbazolyl group.

As a more specific example, Ar⁶ and Ar⁷ in Chemical Formula 3 may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted triphenylene group, a substituted or unsubstituted carbazolyl group, a substituted or unsubstituted dibenzothiophenyl group, a substituted or unsubstituted dibenzofuranyl group, or a substituted or unsubstituted fluorenyl group,

L⁸ and L⁹ in Chemical Formula 3 may each independently be a single bond, a substituted or unsubstituted phenylene group, a substituted or unsubstituted biphenylene group, or a substituted or unsubstituted naphthalenylene group,

R¹² to R¹⁶ in Chemical Formula 3 may each independently be hydrogen, deuterium, a substituted or unsubstituted C6 to C12 aryl group, a substituted or unsubstituted carbazolyl group, a substituted or unsubstituted dibenzofuranyl group, or a substituted or unsubstituted a dibenzothiophenyl group, and
n may be 0 or 1.

For example, "substituted" in Chemical Formula 3 refers to replacement of at least one hydrogen by deuterium, a C1 to C4 alkyl group, a C6 to C18 aryl group, or a C2 to C30 heteroaryl group.

In a specific embodiment of the present invention, Chemical Formula 3 may be represented by any one of Chemical Formula 3-1 to Chemical Formula 3-15.

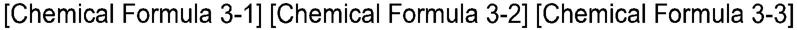

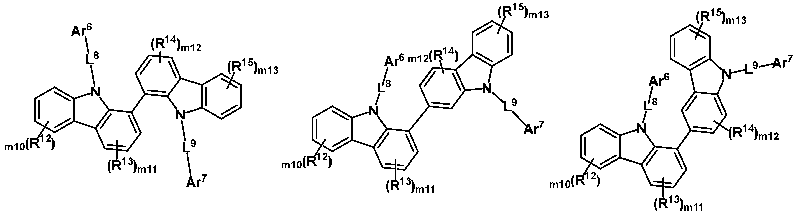

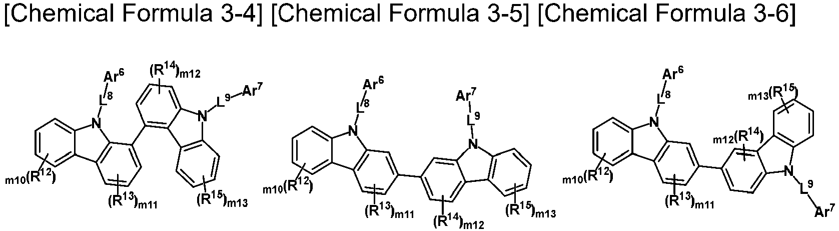

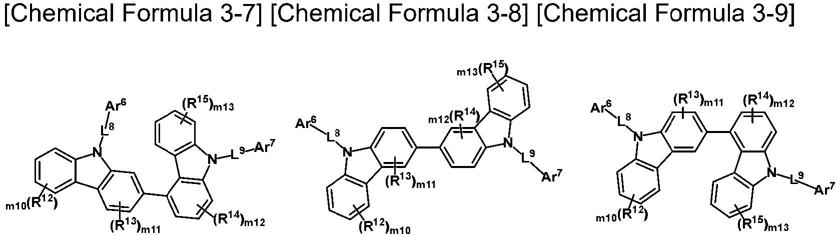

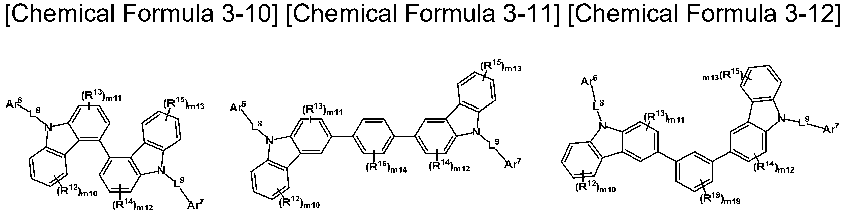

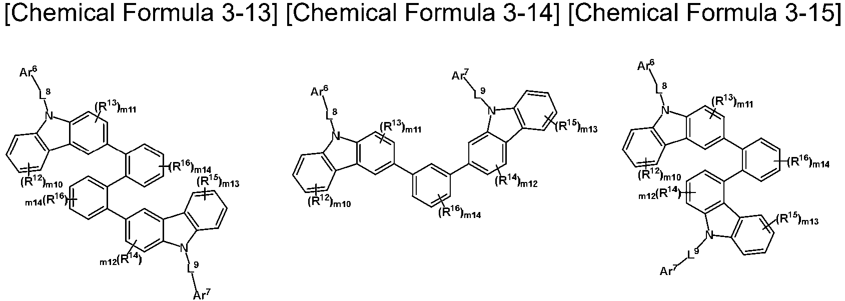

In Chemical Formula 3-1 to Chemical Formula 3-15, R¹² to R¹⁶ may each independently be hydrogen, deuterium, a substituted or unsubstituted C6 to C12 aryl group, a substituted or unsubstituted carbazolyl group, a substituted or unsubstituted dibenzofuranyl group, or a substituted or unsubstituted dibenzothiophenyl group, and *-L⁸-Ar⁶ and *-L⁹-Ar⁷ may each independently be one of the substituents listed in Group I .

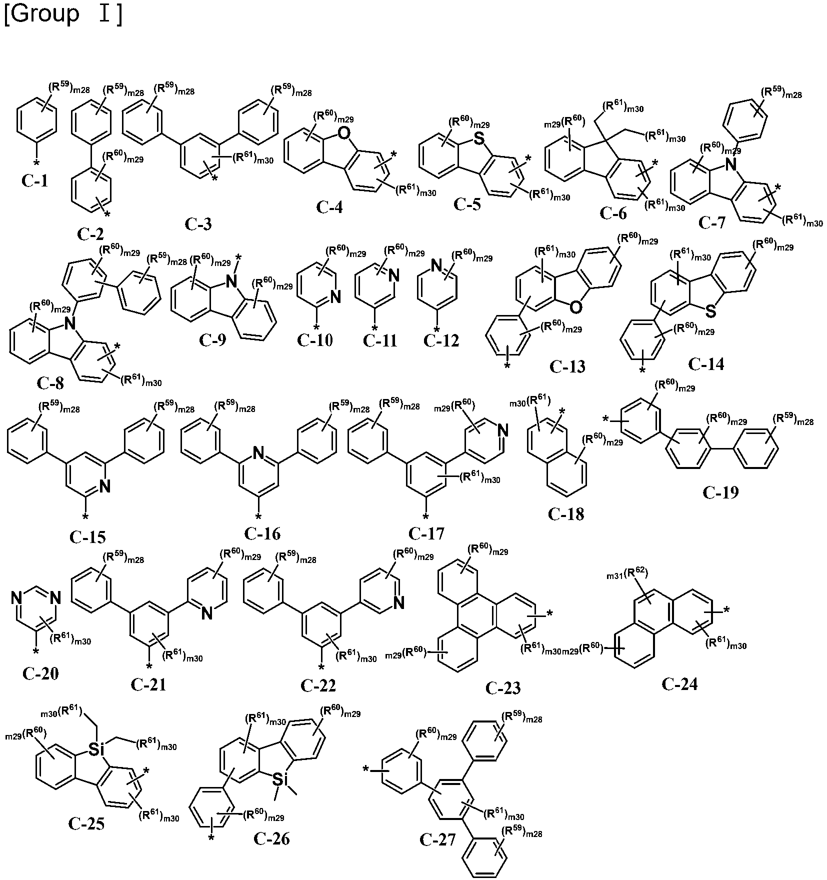

In Group I ,
R⁵⁹ to R⁶² are each independently hydrogen, deuterium, a C1 to C4 alkyl group, a C6 to C18 aryl group, or a C2 to C30 heteroaryl group,
m28 is an integer from 1 to 5,
m29 is an integer from 1 to 4,
m30 is an integer from 1 to 3,
m31 is an integer from 1 to 2, and
* is a linking point.

In Group I , when m28 is greater than or equal to 2, each R⁵⁹ may be same or different from each other.

In Group I , when m29 is greater than or equal to 2, each R⁶⁰ may be same or different from each other.

In Group I , when m30 is greater than or equal to 2, each R⁶¹ may be same or different from each other.

In Group I , when m31 is greater than or equal to 2, each R⁶² may be same or different from each other.

In an embodiment, Chemical Formula 3 may be represented by Chemical Formula 3-8.

In addition, *-L⁸-Ar⁶ and *-L⁹-Ar⁷ of Chemical Formula 3-8 may each independently be selected from Group I , and may be for example, any one of C-1, C-2, C-3, C-4, C-7, C-8, and C-9.

For example, the compound represented by the combination of Chemical Formula 4 and Chemical Formula 5 may be represented by any one of Chemical Formula 4A, Chemical Formula 4B, Chemical Formula 4C, Chemical Formula 4D and Chemical Formula 4E.

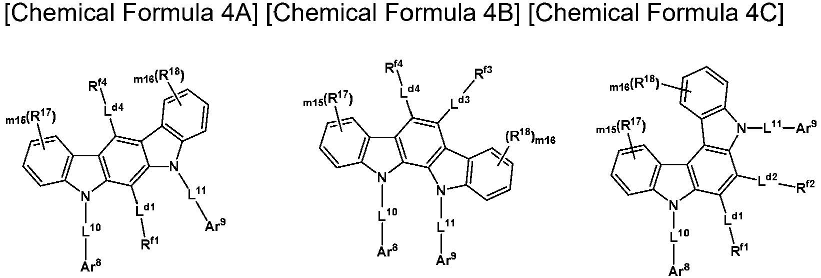

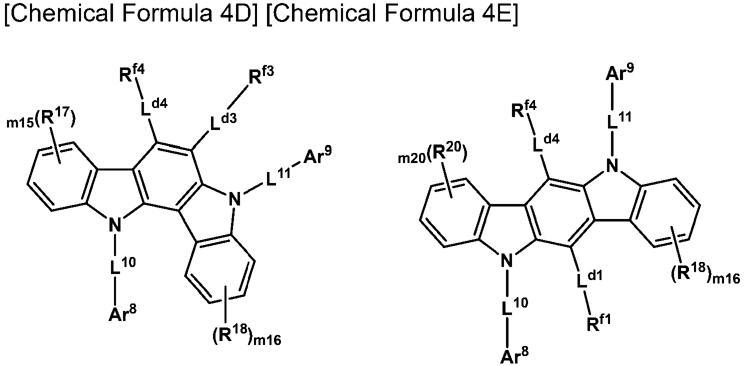

In Chemical Formula 4A to Chemical Formula 4E, Ar⁸, Ar⁹, L¹⁰, L¹¹, R¹⁷, and R¹⁸ are the same as described above,
L^{d1} to L^{d4} are the same as defined for the aforementioned L¹⁰ and L¹¹, and
R^{f1} to R^{f4} are the same as defined for the aforementioned R¹⁷ and R¹⁸.

For example, in Chemical Formula 4 and Chemical Formula 5, Ar⁸ and Ar⁹ may each independently be a substituted or unsubstituted phenyl group, a substituted or unsubstituted biphenyl group, a substituted or unsubstituted naphthyl group, a substituted or unsubstituted triphenylene group, a substituted or unsubstituted carbazolyl group, a substituted or unsubstituted dibenzofuranyl group, or a substituted or unsubstituted dibenzothiophenyl group, and
R^{f1} to R^{f4}, R¹⁷, and R¹⁸ may each independently be hydrogen, deuterium, a cyano group, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

In a specific embodiment of the present invention, *-L¹⁰-Ar⁸ and *-L¹¹-Ar⁹ of Chemical Formula 4 and Chemical Formula 5 may each independently be selected from the substituents listed in Group I .

In an embodiment, R^{f1} to R^{f4}, R¹⁷, and R¹⁸ may each independently be hydrogen, deuterium, a cyano group, a substituted or unsubstituted phenyl group, a substituted or unsubstituted biphenyl group, a substituted or unsubstituted naphthyl group, a substituted or unsubstituted triphenylene group, a substituted or unsubstituted carbazolyl group, a substituted or unsubstituted dibenzofuranyl group, or a substituted or unsubstituted dibenzothiophenyl group.

For example, R^{f1} to R^{f4}, R¹⁷, and R¹⁸ may each independently be hydrogen, deuterium, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group, and
in a specific embodiment, R^{f1} to R^{f4}, R¹⁷, and R¹⁸ may each independently be hydrogen, deuterium, a phenyl group, a carbazolyl group, a dibenzofuranyl group, or a dibenzothiophenyl group.

In a specific embodiment of the present invention, the second compound and the fourth compound may each independently be represented by the Chemical Formula 3-8, Ar⁶ and Ar⁷ of the Chemical Formula 3-8 may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted triphenylene group, a substituted or unsubstituted carbazolyl group, a substituted or unsubstituted dibenzothiophenyl group, a substituted or unsubstituted dibenzofuranyl group, or a substituted or unsubstituted fluorenyl group, L⁸ and L⁹ may each independently be a single bond, or a substituted or unsubstituted C6 to C20 arylene group, and R¹² to R¹⁵ may each independently be hydrogen, deuterium, a cyano group, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

In another specific embodiment of the present invention, the second compound and the fourth compound may each independently be represented by Chemical Formula 4C, L^{d1} and L^{d2} in Chemical Formula 4C may be a single bond, L¹⁰ and L¹¹ may each independently be a single bond or a substituted or unsubstituted C6 to C12 arylene group, R^{f1}, R^{f2}, R¹⁷, and R¹⁸ may each independently be hydrogen, deuterium, a phenyl group, a triphenylene group, a carbazolyl group, a dibenzofuranyl group, or a dibenzothiophene group, and Ar⁸ and Ar⁹ may each independently be a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

For example, the second compound and the fourth compound may each independently be selected from the compounds listed in Group 3, but are not limited thereto.

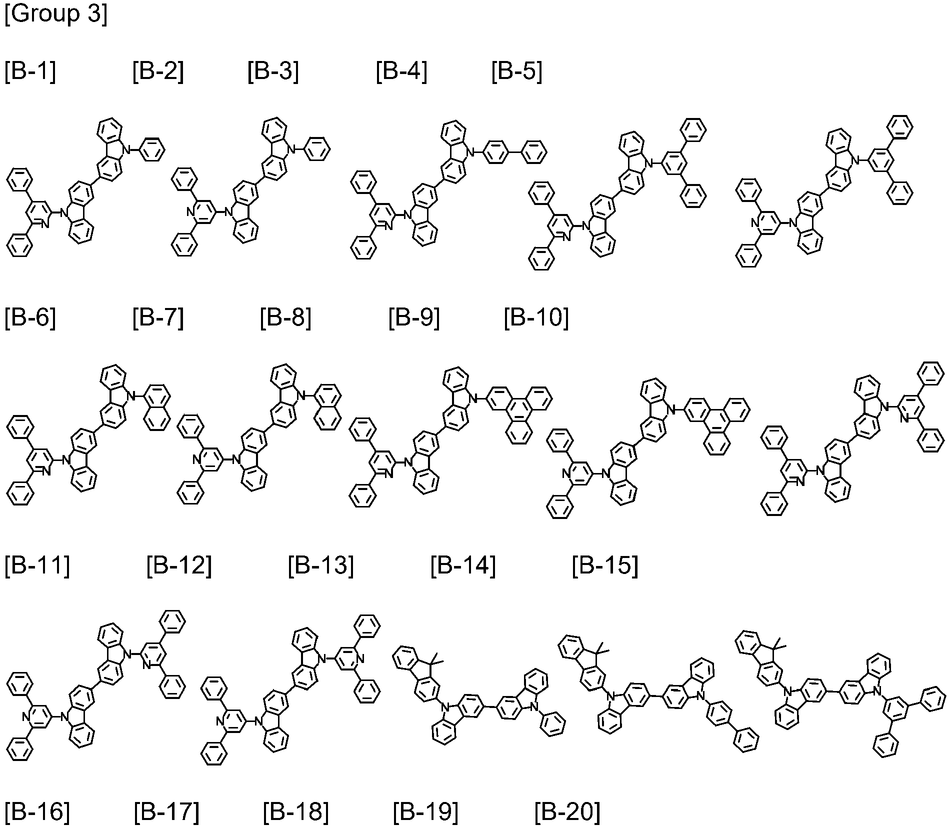

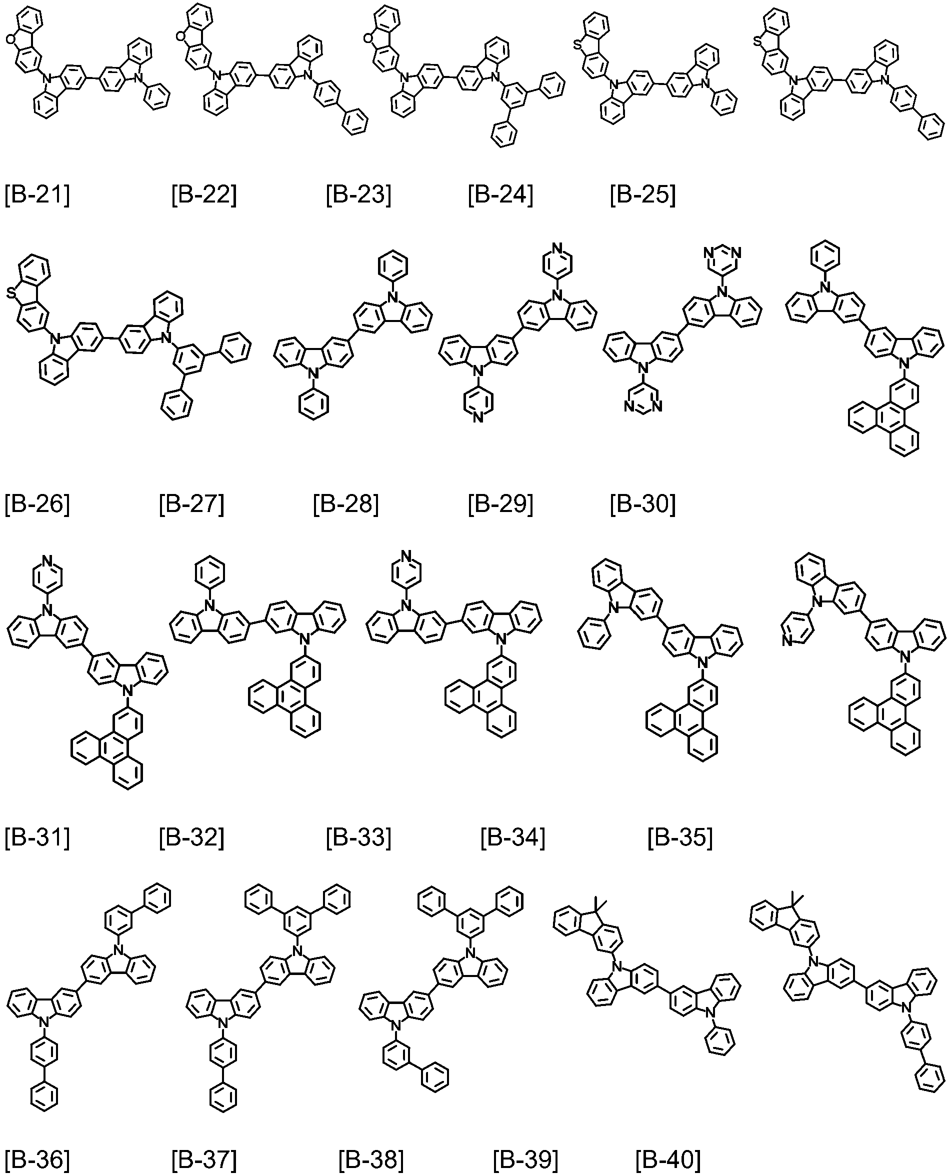

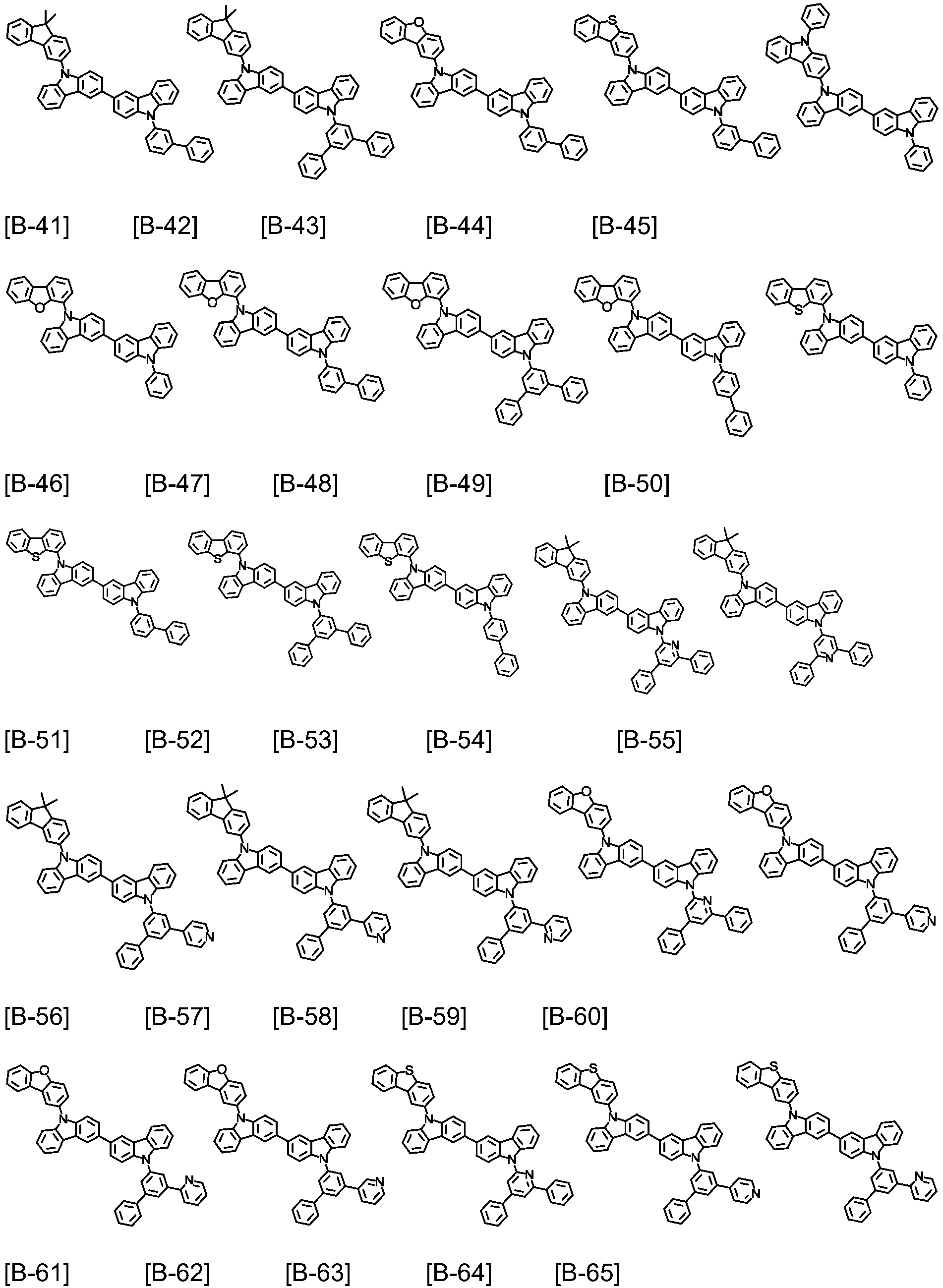

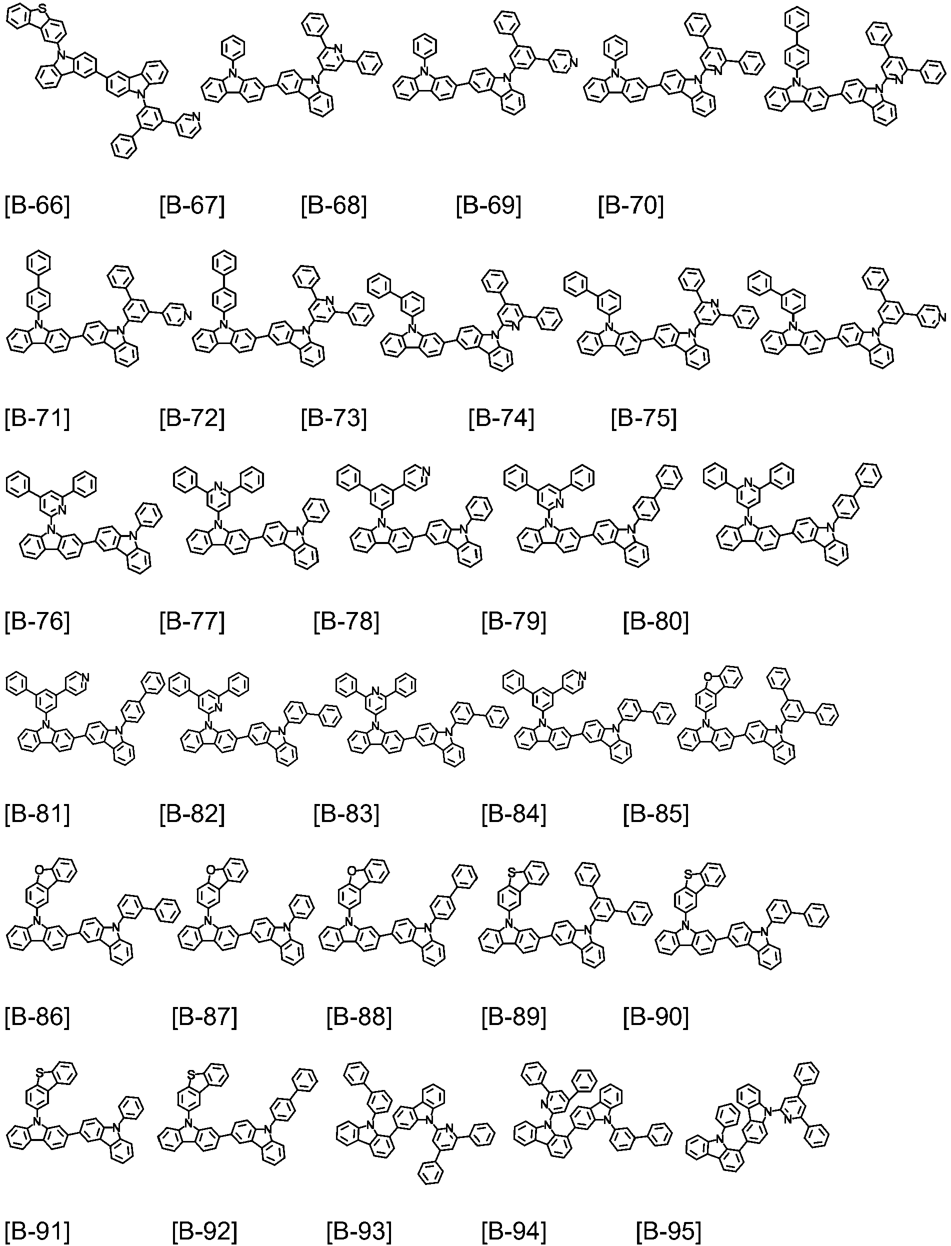

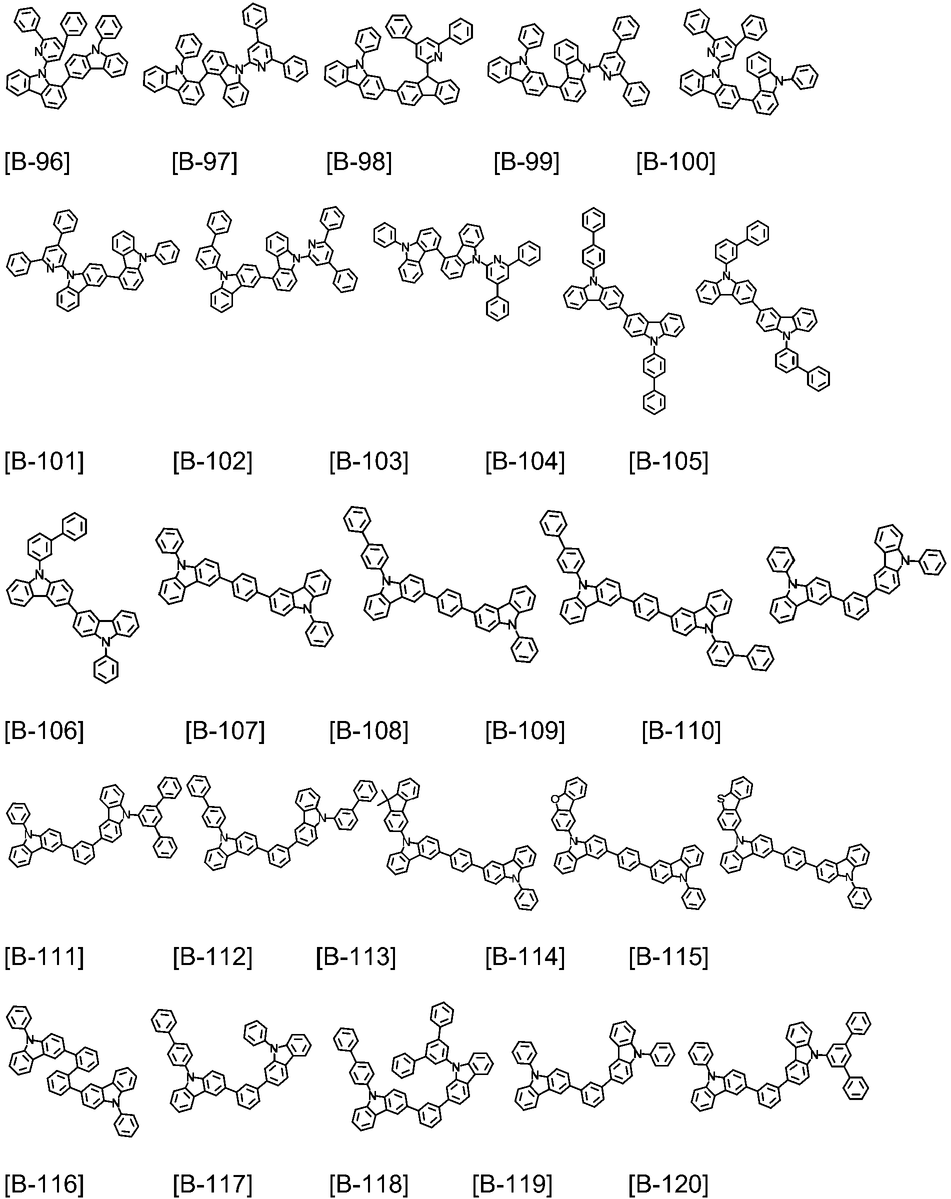

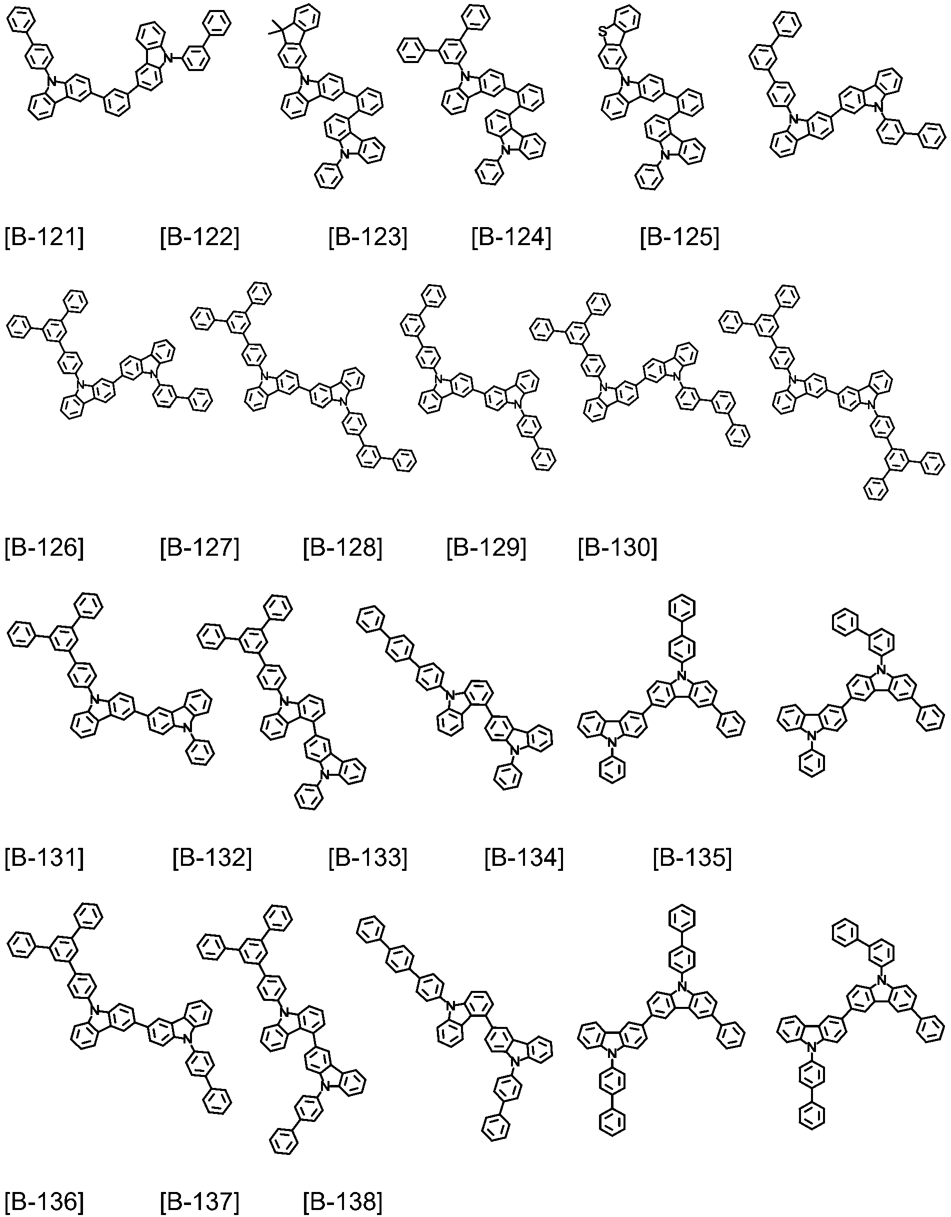

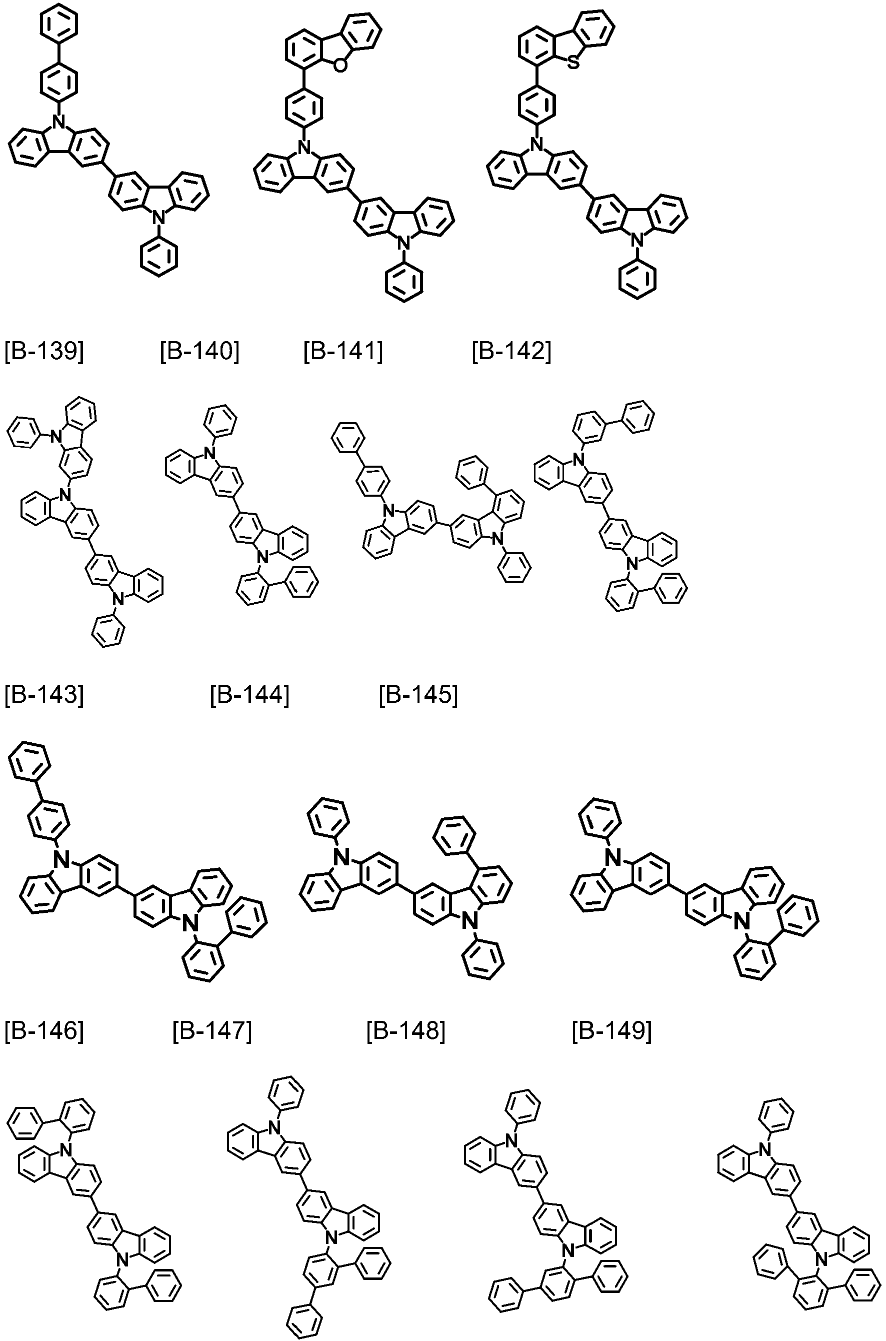

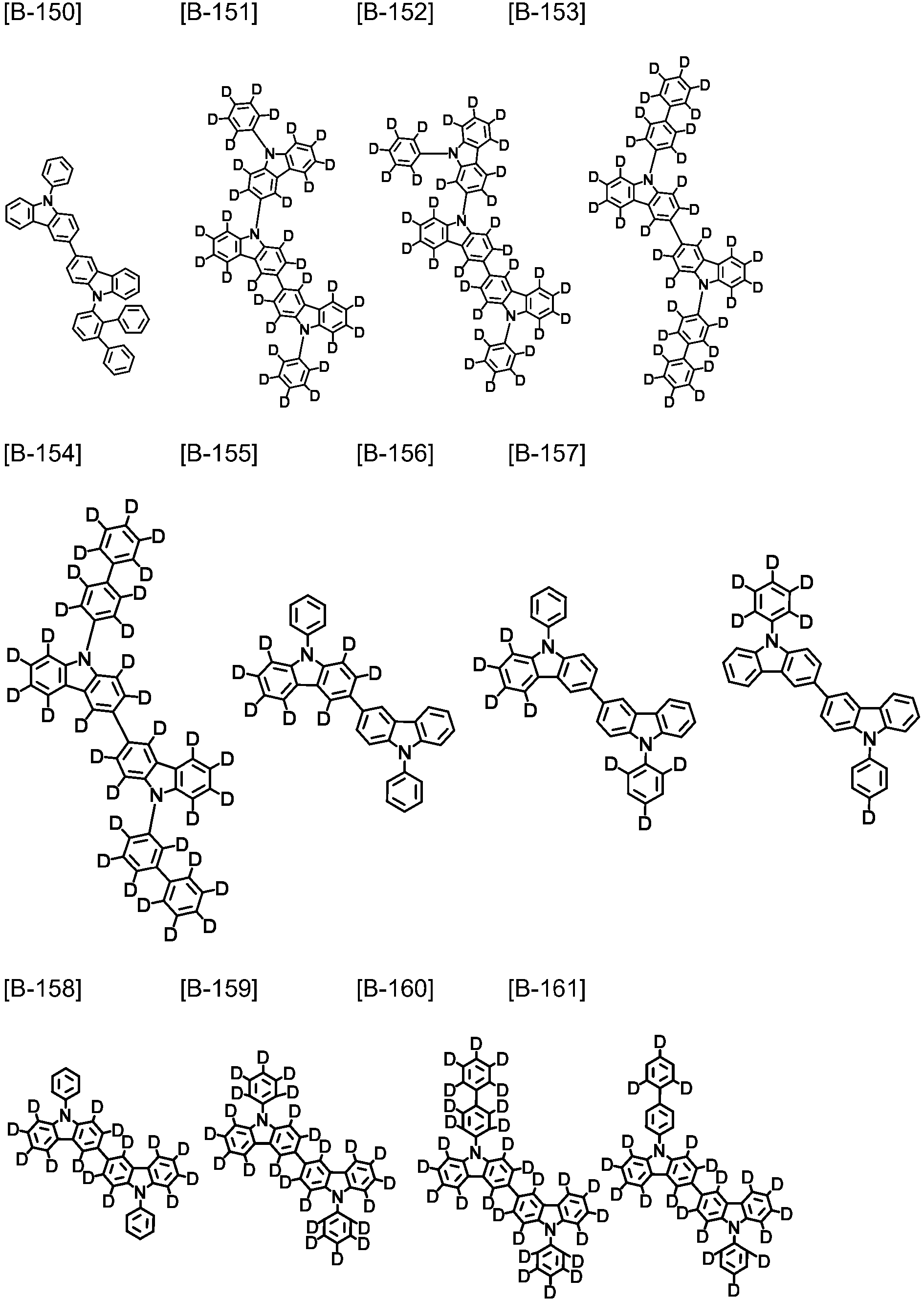

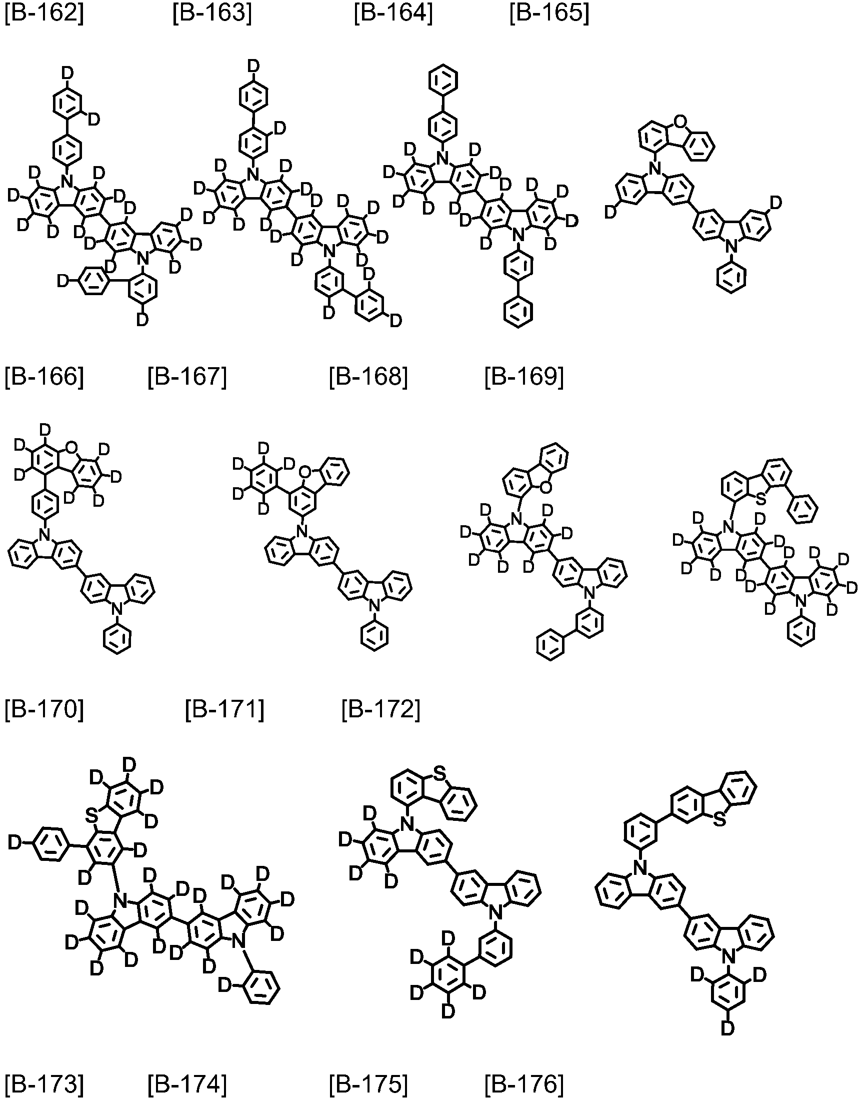

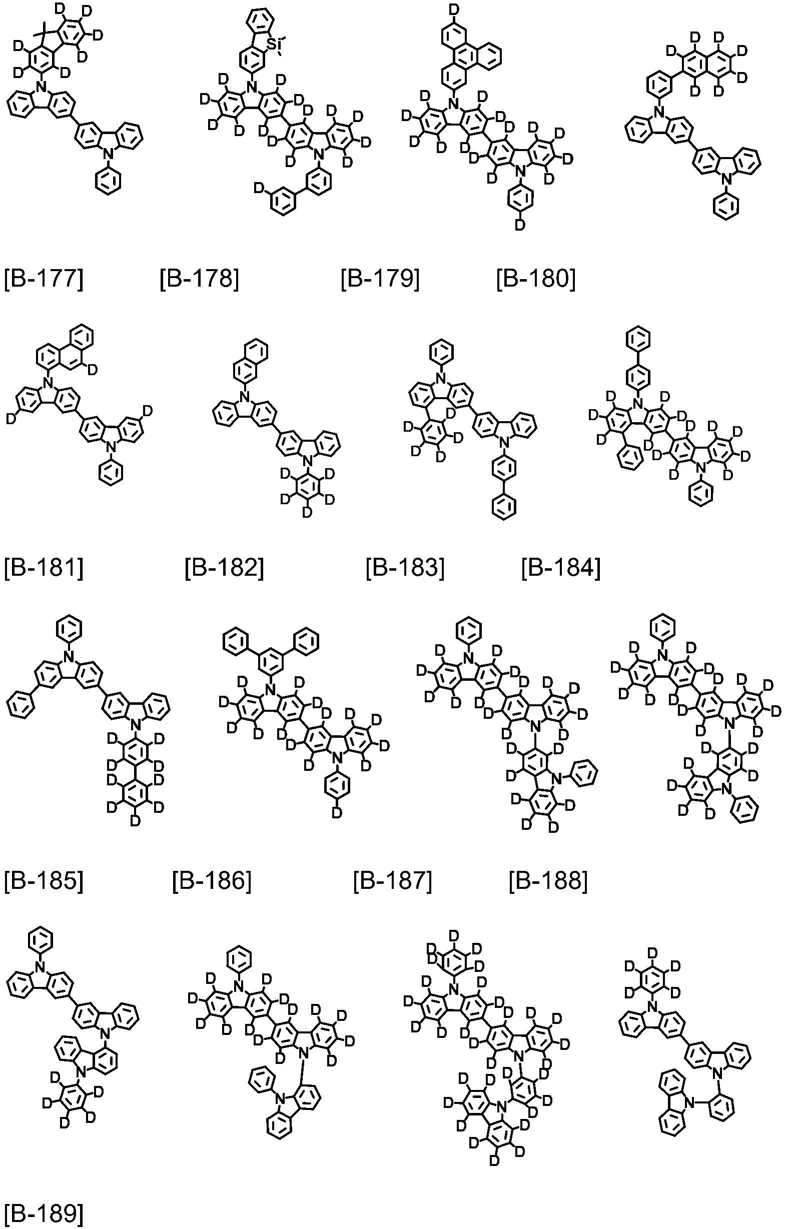

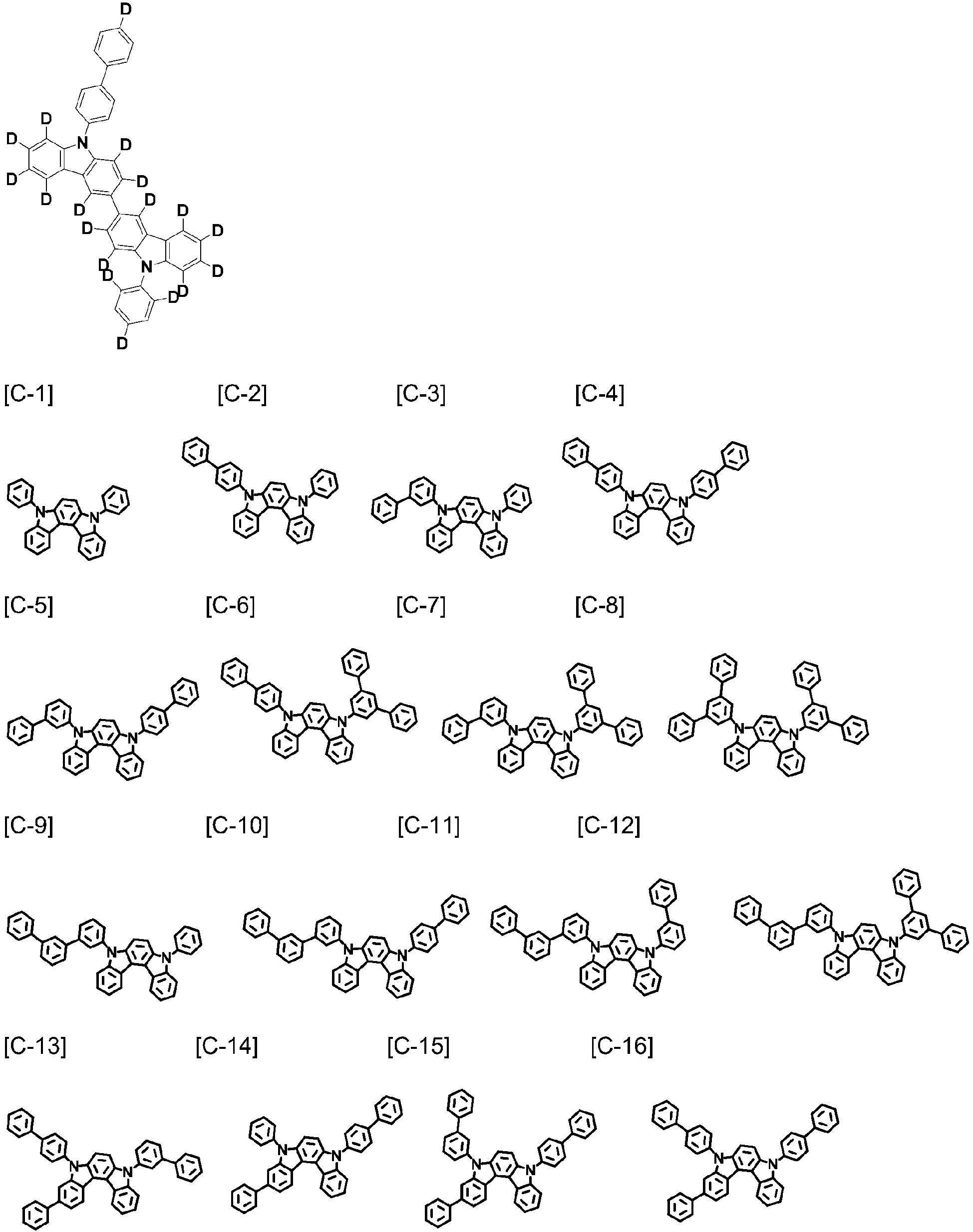

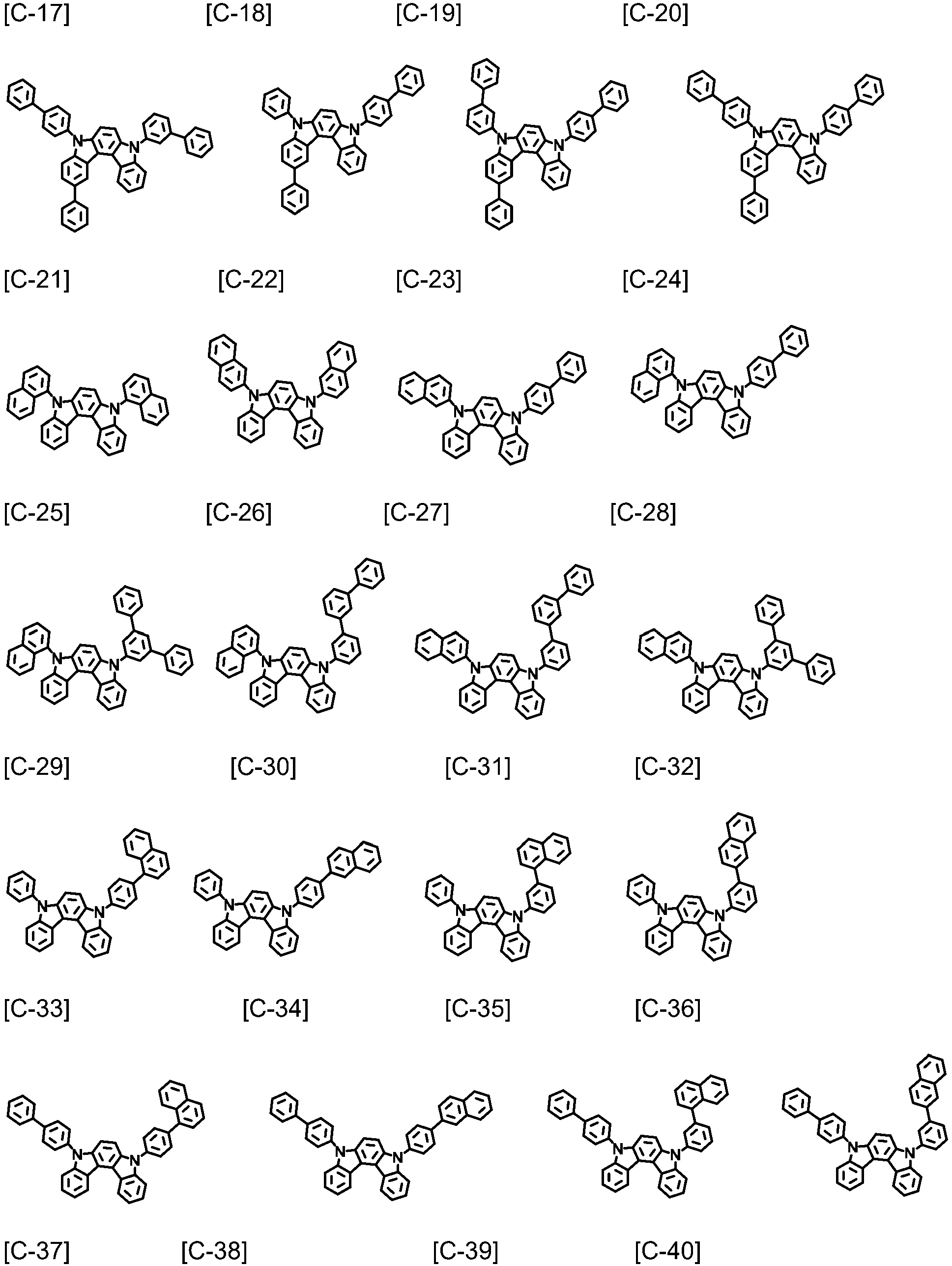

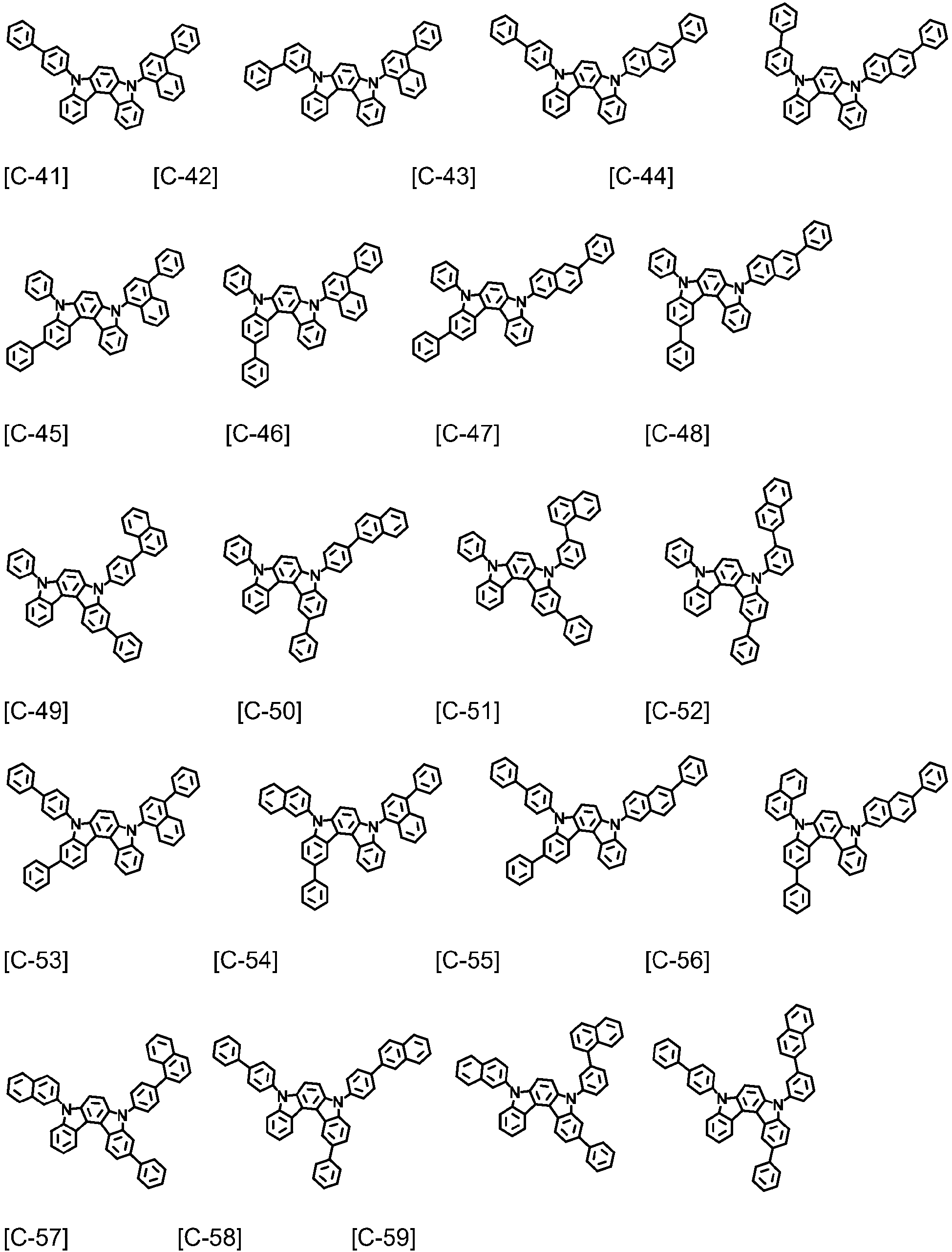

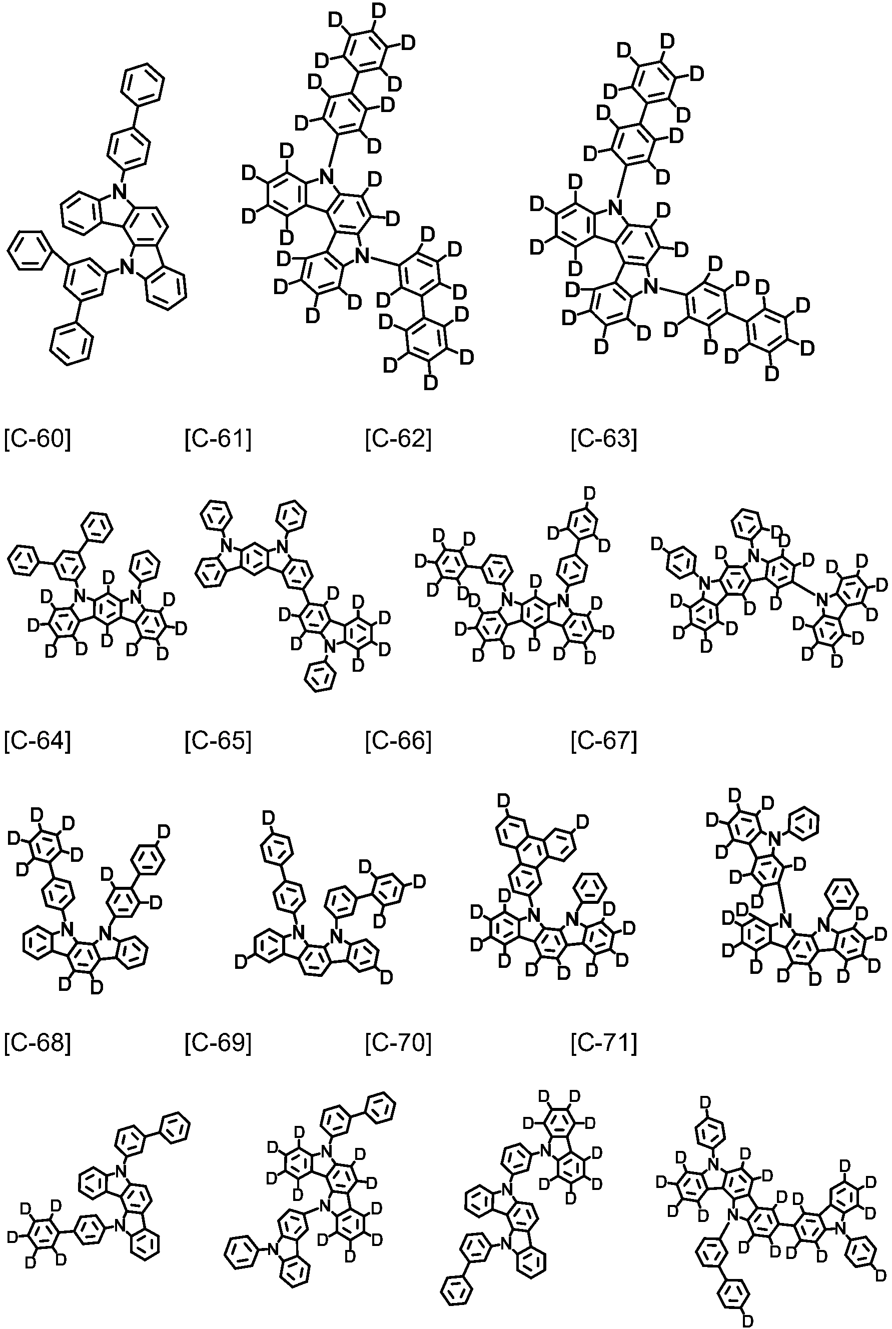

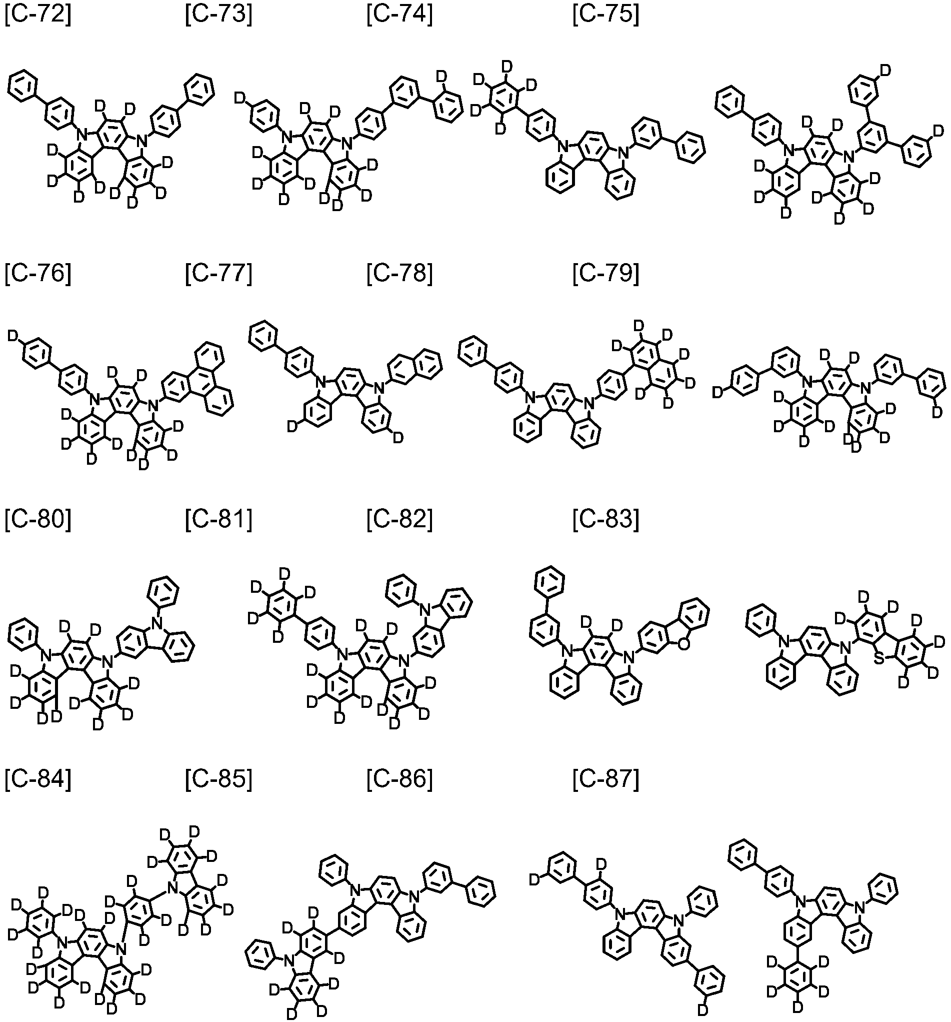

The dopant is a material mixed host in a trace amount to cause light emission and may be generally a material such as a metal complex that emits light by multiple excitation into a triplet or more. The dopant C-88 may be, for example an inorganic, organic, or organic-inorganic compound, and one or more types thereof may be used.

In particular, an example of the first dopant may be an organic metal compound including Ir.

For example, a compound represented by Chemical Formula Z may be used.

[Chemical Formula Z] L¹²IrX²

In Chemical Formula Z, L¹² and X² are the same or different and are a ligand to form a complex compound with Ir.

For example, L¹² and X² may be a bidentate ligand.

Examples of the ligands represented by L¹² and X² may be selected from the chemical formulas listed in Group A, but are not limited thereto.

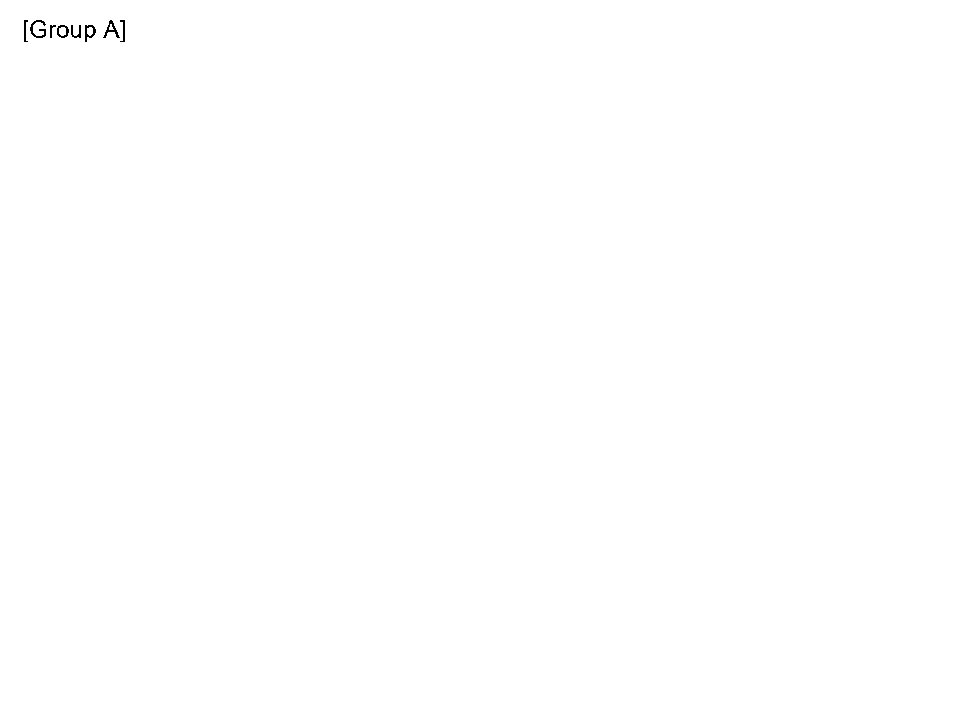

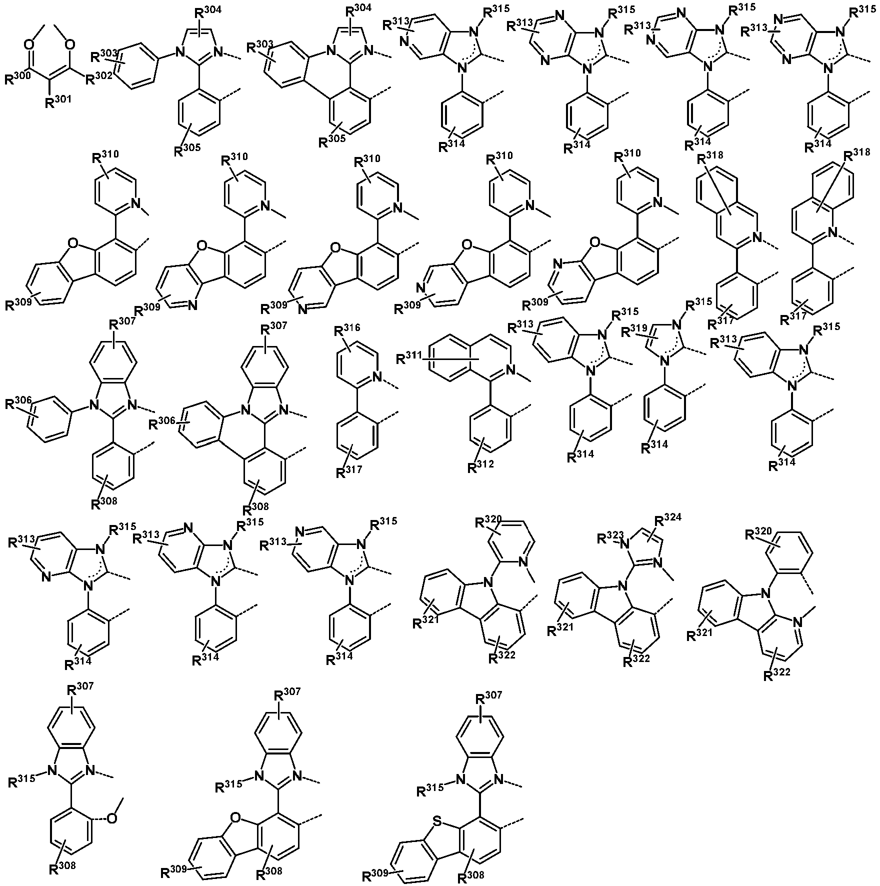

In Group A,
R³⁰⁰ to R¹⁰² are each independently hydrogen, deuterium, a C1 to C30 alkyl group that is substituted or unsubstituted with a halogen, a C6 to C30 aryl group that is substituted or unsubstituted with a C1 to C30 alkyl, or a halogen, and
R³⁰³ to R³²⁴ are each independently hydrogen, deuterium, a halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and C6 to C30 aryl group, or a triarylsilyl group having a substituted or unsubstituted C6 to C30 aryl group.

For example, the first dopant may be represented by Chemical Formula V.

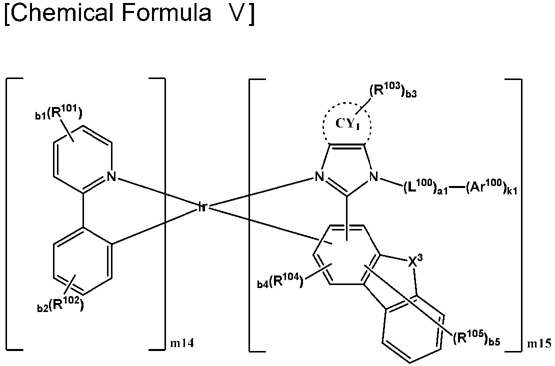

In Chemical Formula V,
X³ is O, S, or Se,
CY₁ is a substituted or unsubstituted C5 to C30 carbocyclic group or a substituted or unsubstituted C1 to C30 heterocyclic group,
L¹⁰⁰ is a substituted or unsubstituted C3 to C10 cycloalkylene group, a substituted or unsubstituted C1 to C10 heterocycloalkylene group, a substituted or unsubstituted C3 to C10 cycloalkenylene group, a substituted or unsubstituted C2 to C10 heterocycloalkenylene group, a substituted or unsubstituted C6 to C60 arylene group, a substituted or unsubstituted C1 to C60 heteroarylene group, a substituted or unsubstituted divalent non-aromatic condensed polycyclic group, or a substituted or unsubstituted divalent non-aromatic heterocondensed polycyclic group,
a1 is an integer of 0 to 3,
Ar¹⁰⁰, R¹⁰¹, R¹⁰², R¹⁰³, R¹⁰⁴, and R¹⁰⁵ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C2 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted C1 to C60 heteroaryloxy group, a substituted or unsubstituted C1 to C60 heteroarylthio group, a substituted or unsubstituted monovalent non-aromatic condensed polycyclic group, a substituted or unsubstituted monovalent non-aromatic heterocondensed polycyclic group, -N(Q1)(Q2), -Si(Q3)(Q4)(Q5), -Ge(Q3)(Q4)(Q5), -B(Q6)(Q7), or -P(=O)(Q8)(Q9),
k1 is an integer of 1 to 8,
b1 and b2 are each independently an integer of 1 to 4,
b3 is an integer of 1 to 8,
b4 is an integer of 1 to 6,
m14 is an integer of 1 to 2,
m15 is an integer of 1 to 3, and
Q1 to Q9 are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C1 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted C1 to C60 heteroaryloxy group, a substituted or unsubstituted C1 to C60 heteroarylthio group, a substituted or unsubstituted monovalent non-aromatic condensed polycyclic group, or a substituted or unsubstituted monovalent non-aromatic heterocondensed polycyclic group.

Meanwhile, an example of the second dopant may be an organic metal compound including Pt. For example, a dopant represented by Chemical Formula Z-1 may be mentioned.

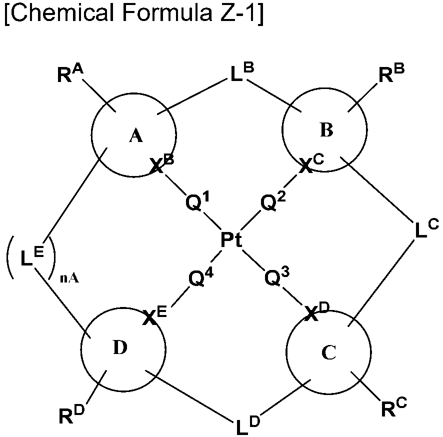

In Chemical Formula Z-1, rings A, B, C, and D are each independently 5- or 6-membered carbocyclic or heterocyclic ring;
R^{A}, R^{B}, R^{C}, and R^{D} each independently represent mono-, di-, tri-, or tetra-substitution, or unsubstitution;
L^{B}, L^{C}, and L^{D} are each independent selected from a direct bond, BR, NR, PR, O, S, Se, C=O, S=O, SO₂, CRR', SiRR', GeRR', and a combination thereof;
when nA is 1, L^{E} is selected from a direct bond, BR, NR, PR, O, S, Se, C=O, S=O, SO₂, CRR', SiRR', GeRR', and a combination thereof; when nA is 0, L^{E} does not exist; and
R^{A}, R^{B}, R^{C}, R^{D}, R, and R' are each independently selected from hydrogen, deuterium, a halogen, a substituted or unsubstituted C1 to C60 alkyl group, a substituted or unsubstituted C3 to C10 cycloalkyl group, a substituted or unsubstituted C3 to C10 heteroalkyl group, a substituted or unsubstituted C6 to C60 arylalkyl group, a substituted or unsubstituted C1 to C60 alkoxy group, a substituted or unsubstituted C6 to C60 aryloxy group, an amino group, a silyl group, a substituted or unsubstituted C2 to C60 alkenyl group, a substituted or unsubstituted C3 to C10 cycloalkenyl group, a substituted or unsubstituted C1 to C10 heteroalkenyl group, a substituted or unsubstituted C2 to C60 alkynyl group, a substituted or unsubstituted C6 to C60 aryl group, a C1 to C60 heteroaryl group, an acyl group, a carbonyl group, a carboxylic acid group, an ester group, a nitrile group, an isonitrile group, a sulfanyl group, a sulfinyl group, a sulfonyl group, a phosphino group, and a combination thereof; any adjacent R^{A}, R^{B}, R^{C}, R^{D}, R, and R' are optionally linked to each other to form a ring; X^{B}, X^{C}, X^{D}, and X^{E} are each independently selected from carbon and nitrogen; and Q¹, Q², Q³, and Q⁴ are each oxygen or a direct bond.

The second dopant according to an embodiment may be represented by Chemical Formula VI.

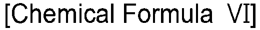

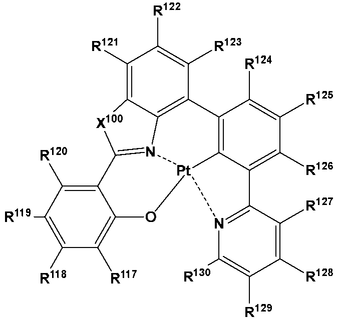

In Chemical Formula VI,
X¹⁰⁰ is selected from O, S and NR¹³¹,
R¹¹⁷ to R¹³¹ are each independently hydrogen, deuterium, a substituted or unsubstituted C1 to C10 alkyl group, a substituted or unsubstituted C6 to C20 aryl group, or - SiR¹³²R¹³³R¹³⁴,
R¹³² to R¹³⁴ are each independently a substituted or unsubstituted C1 to C6 alkyl group,
at least one of R¹¹⁷ to R¹³¹ is -SiR¹³²R¹³³R¹³⁴ or a tert-butyl group, and
R¹³² to R¹³⁴ are each independently a substituted or unsubstituted C1 to C6 alkyl group.

A position of the light emitting zone may be appropriately adjusted by placing the Ir complex, which has relatively strong hole trapping characteristics, near the hole transport region and the Pt complex, which has weak hole trapping characteristics, near the electron transport region.

In an embodiment, the first light emitting layer and the second light emitting layer may be in contact with each other.

In another embodiment, at least one of a hole transport region, an electron transport region, and a charge generation layer (CGL) may be further included between the first light emitting layer and the second light emitting layer.

The hole transport regions 3, 3', and 3" may further increase hole injection and/or hole mobility between the anode 10 and the light emitting layers 1, 1', and 1" and block electrons.

Specifically, the hole transport regions 3, 3', and 3" may include hole transport layers between the anode 10 and the light emitting layers 1, 1', and 1", and hole transport auxiliary layers between the light emitting layers 1, 1', and 1" and the hole transport layers.

At least one of the compounds listed in Group B may be included in at least one layer of the hole transport layer and the hole transport auxiliary layer.

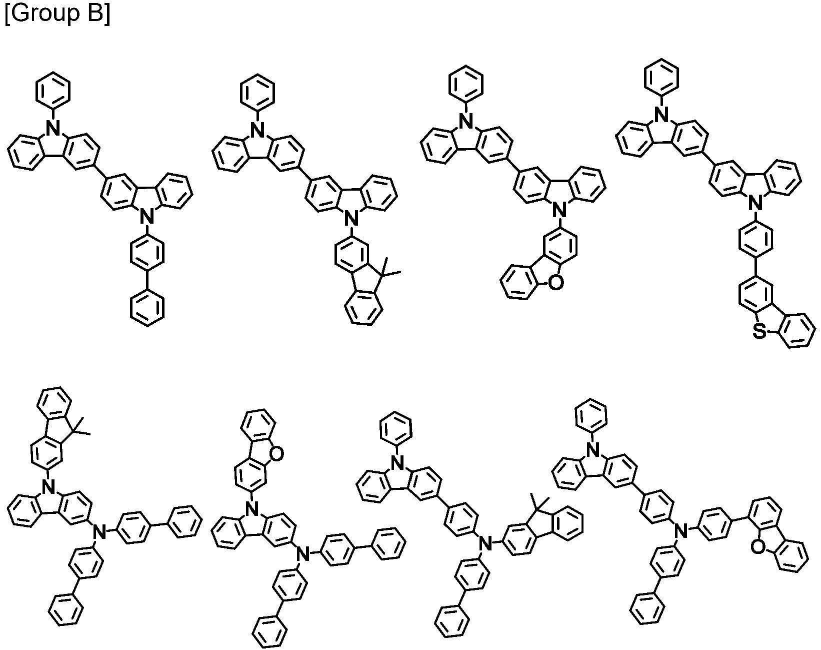

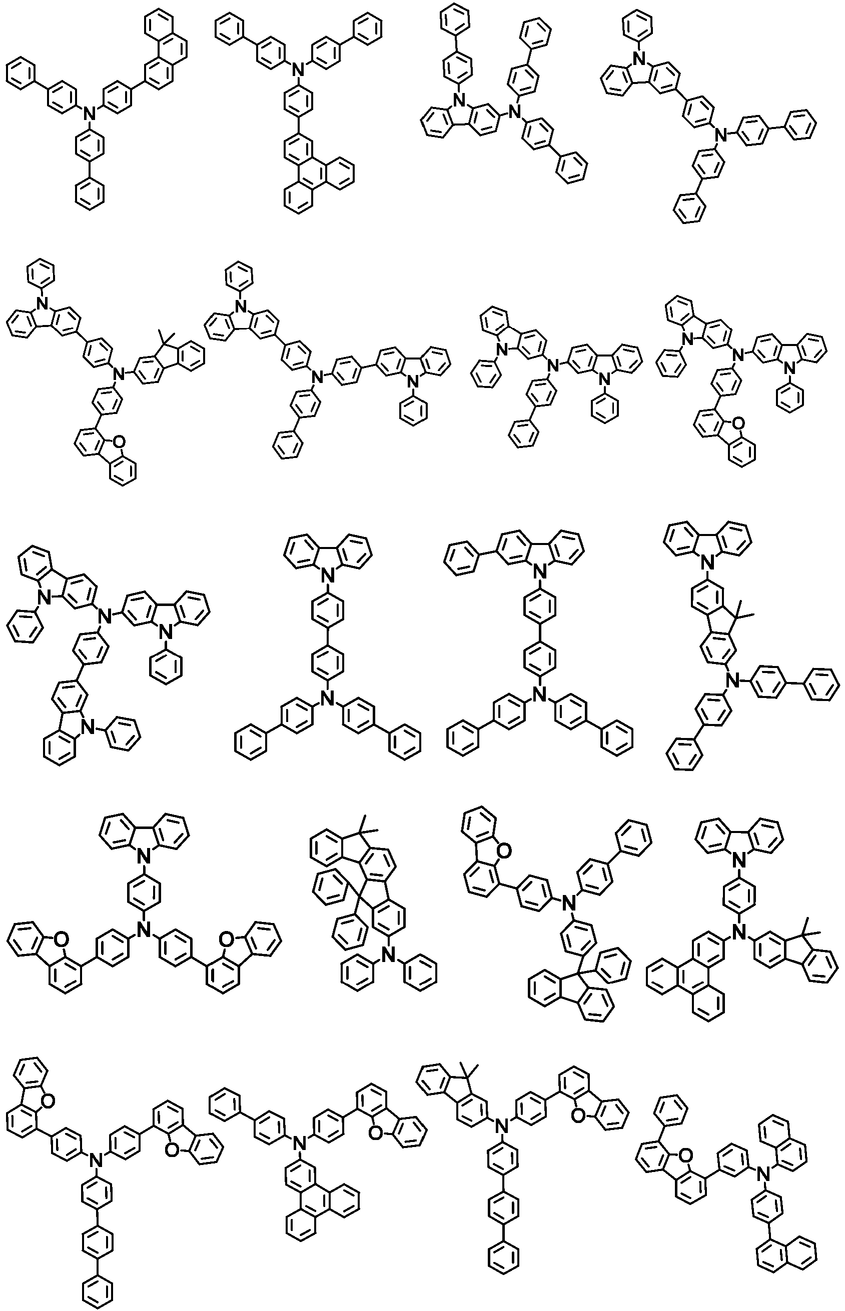

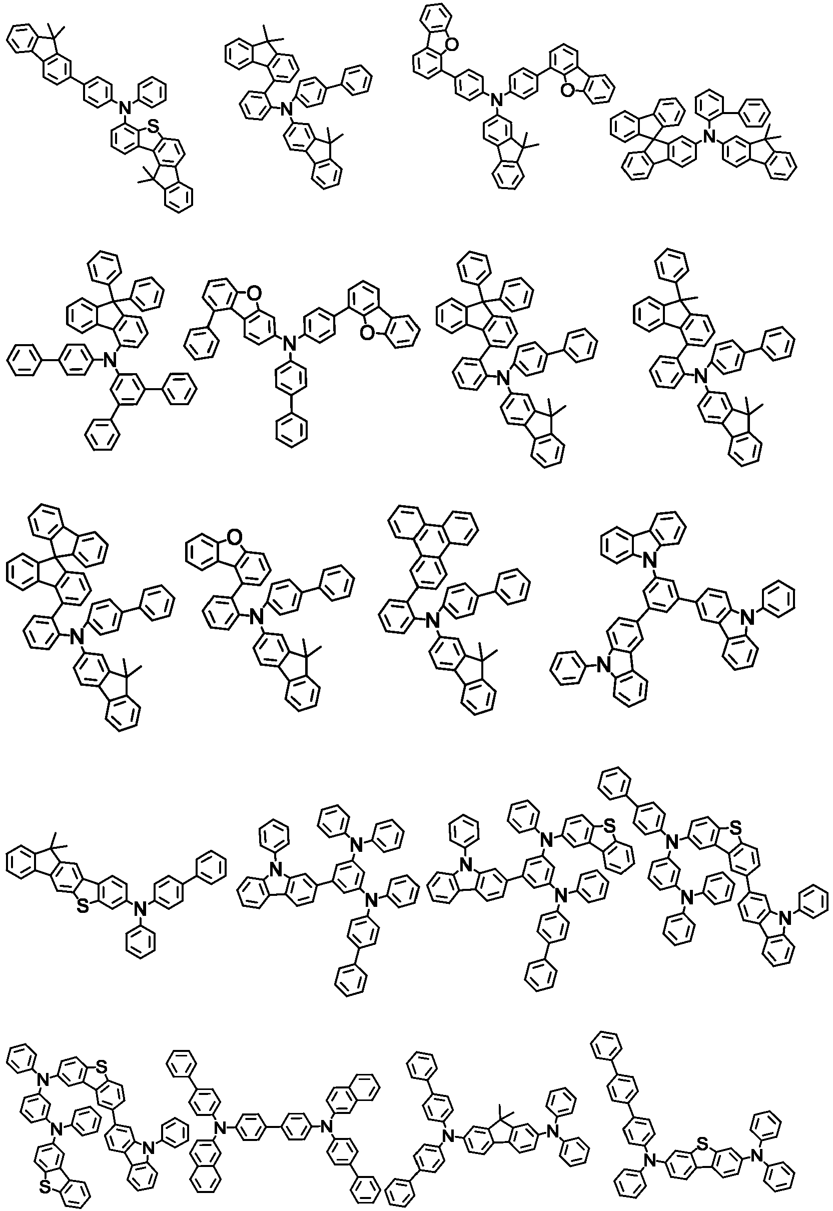

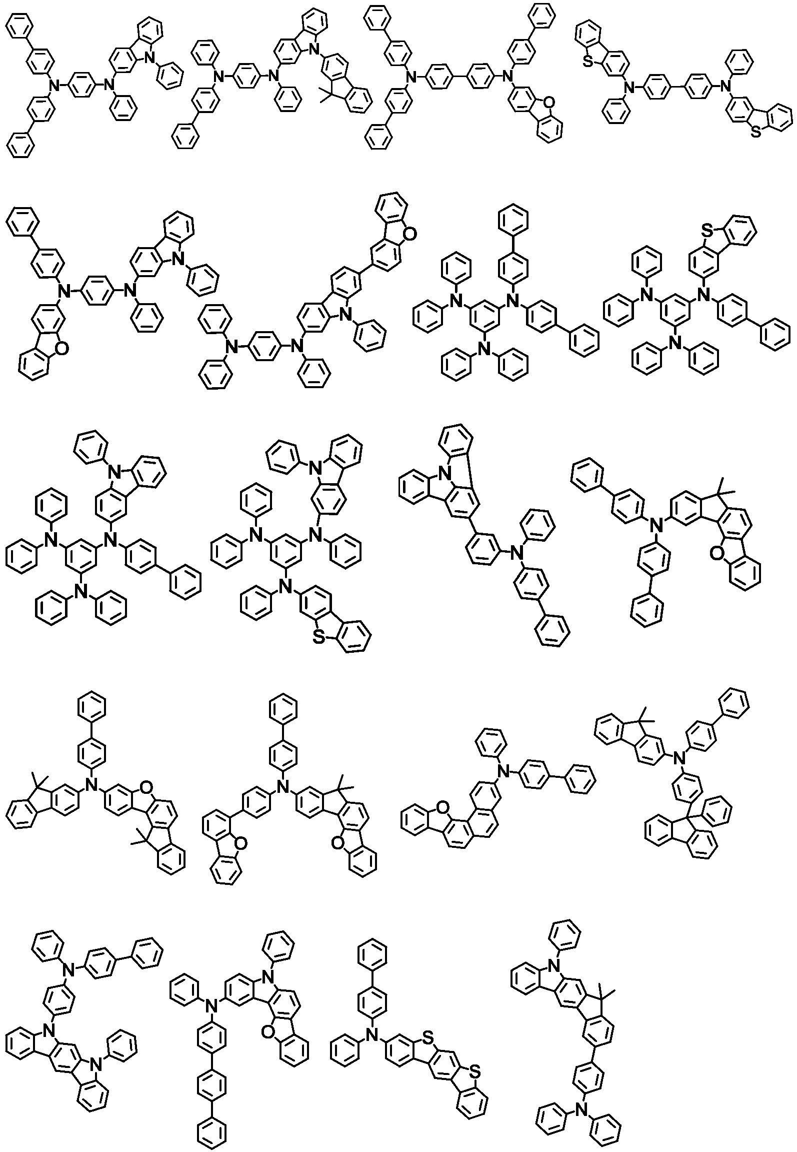

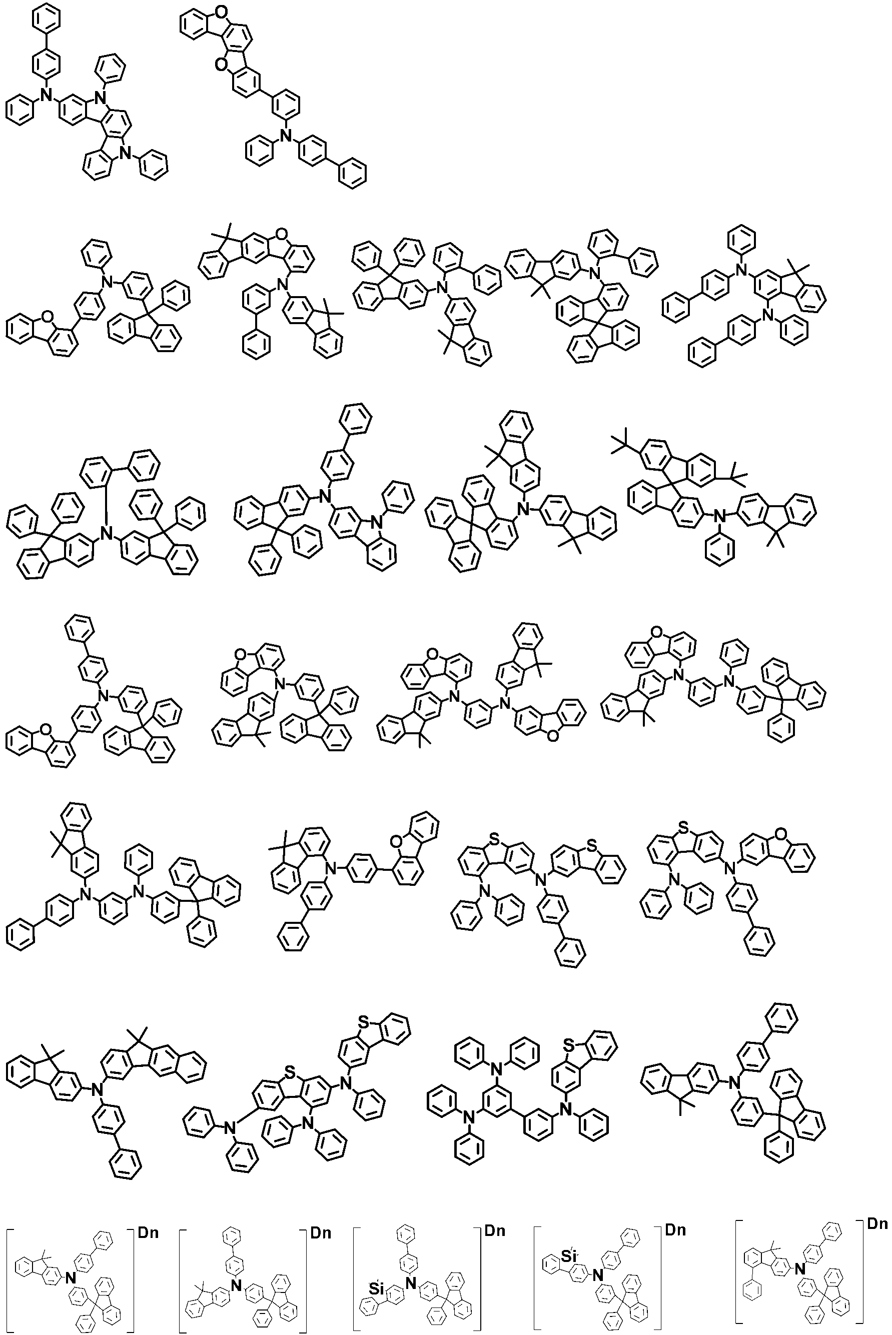

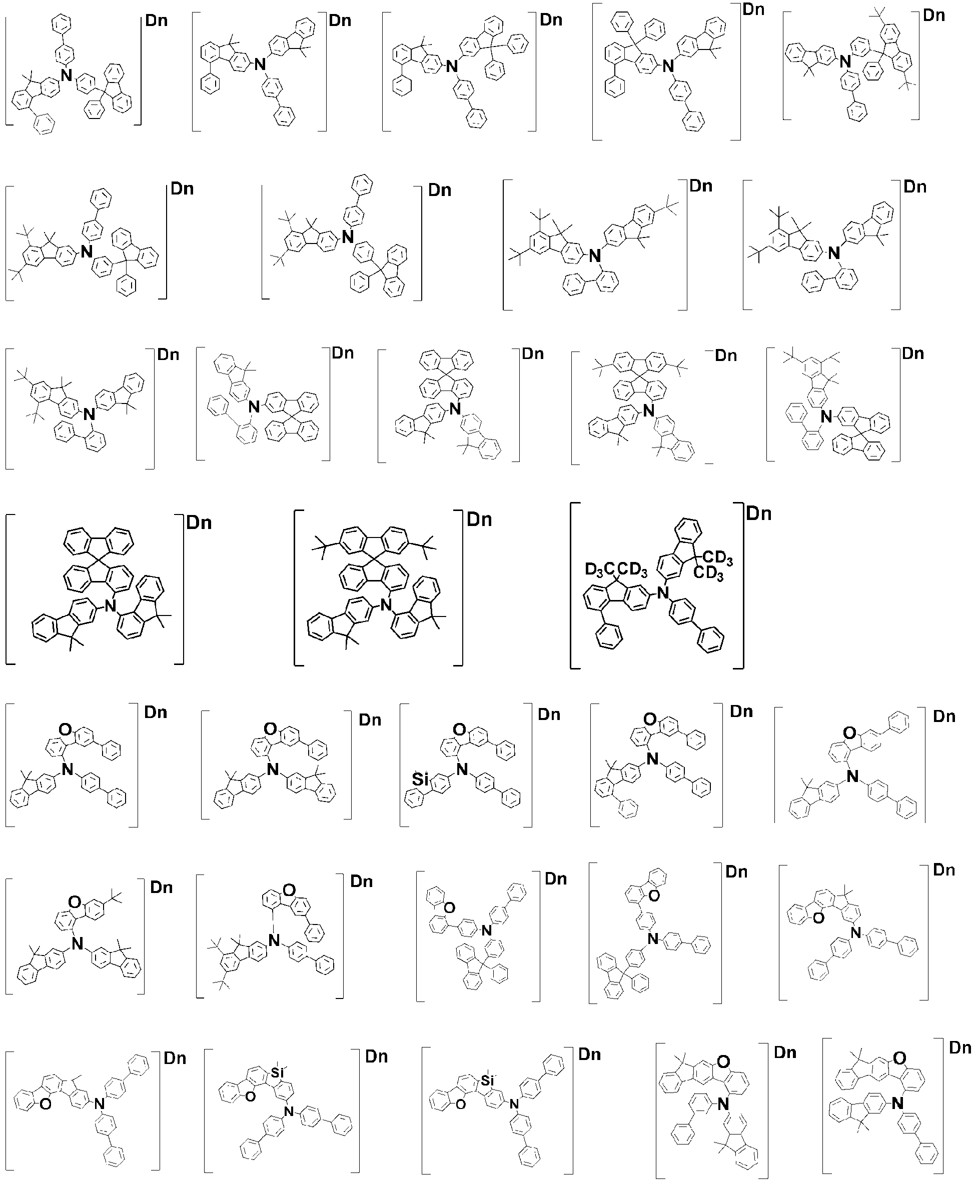

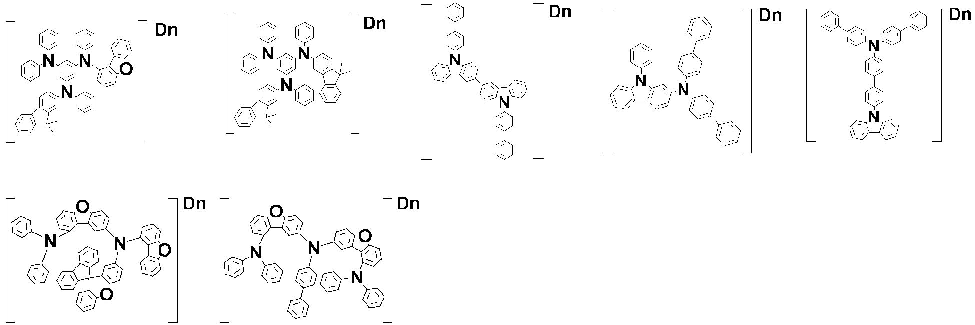

In the hole transport regions 3, 3', and 3", known compounds disclosed in US5061569A, JP1993-009471A, WO1995-009147A1, JP1995-126615A, JP1998-095973A, and the like and compounds similar thereto may be used in addition to the compounds.

The electron transport regions **4, 4',** and 4" can further increase electron injection and/or electron mobility between the cathode 20 and the light emitting layers 1, 1', and 1" and block holes.

Specifically, the electron transport regions **4,** 4', and 4" may include electron transport layers between the cathode 20 and the light emitting layers 1, 1', and 1"; and electron transport auxiliary layers between the light emitting layers 1, 1', and 1" and the electron transport layers, and at least one of the compounds listed in Group C may be included in at least one of the electron transport layer and the electron transport auxiliary layer.

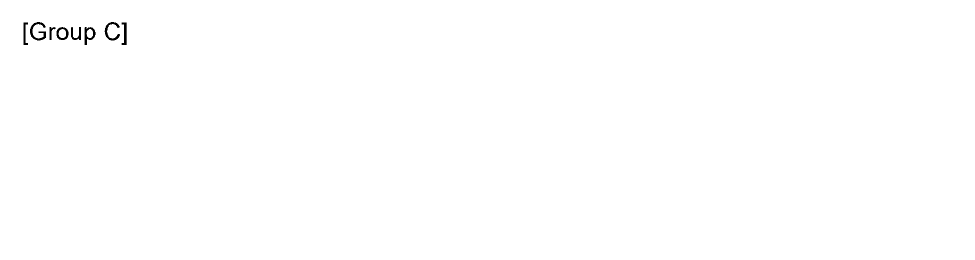

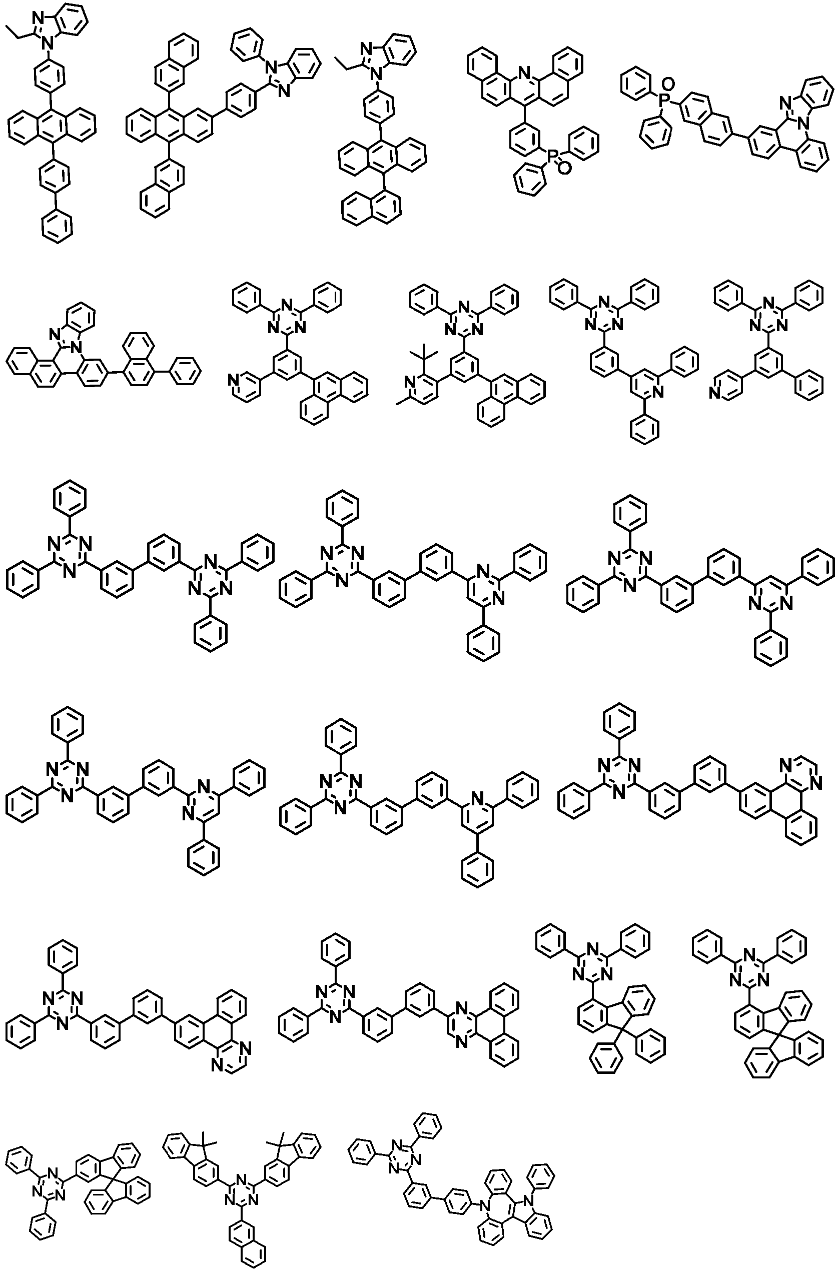

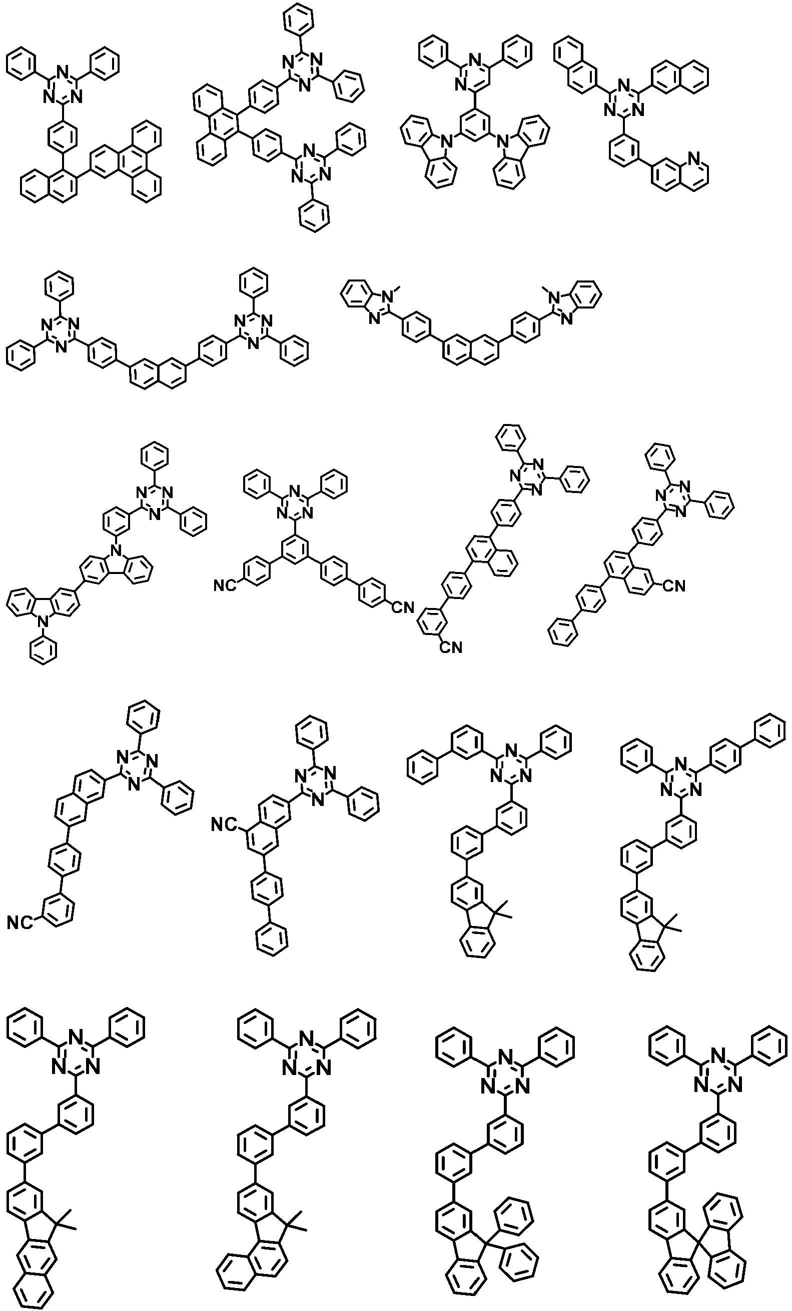

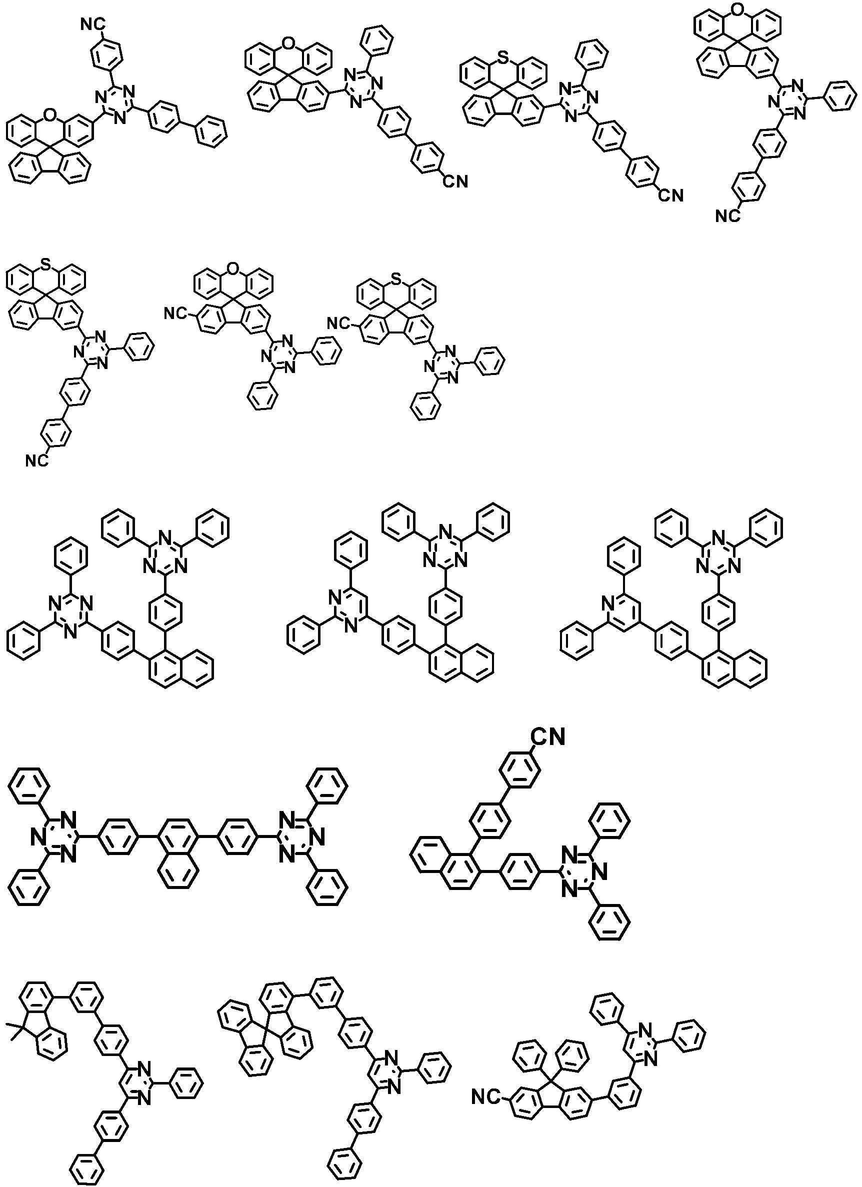

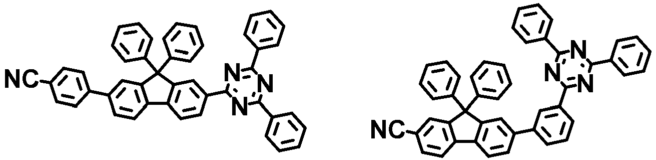

Meanwhile, the organic light emitting diode may further include an electron injection layer (not shown) in addition to the above-described intermediate layer.

Additionally, a capping layer (not shown) may be further included on the anode and/or cathode.

The capping layer may be included to increase thermal stability, increase environmental stability, and improve performance of the organic light emitting diode. Examples of capping layer for improving the thermal stability of the organic light emitting diode may include SiO, SiO₂, an amine compound, or a mixture thereof, but are not limited thereto.

The organic light emitting diode may be manufactured by forming an anode or cathode on a substrate, then forming an intermediate layer using a dry film deposition method such as vacuum evaporation, sputtering, plasma plating, and ion plating, and then forming a cathode or anode thereon.

The organic light emitting diode may be applied to an organic light emitting display device.

### [Mode for Invention]

Hereinafter, the embodiments are illustrated in more detail with reference to examples. However, these examples are exemplary, and the present scope is not limited thereto.

Hereinafter, starting materials and reactants used in examples and synthesis examples were purchased from Sigma-Aldrich Co. Ltd., Tokyo chemical industry (TCI) Inc., or P&H tech as far as there is no particular comment or were synthesized by known methods.

### (Preparation of First Compound)

### Synthesis Example 1: Synthesis of Compound A-3

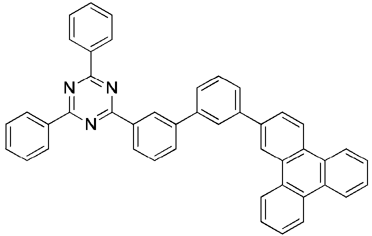

Compound A-3 was synthesized by referring to the method known in KR 10-1649683 B1.

### Synthesis Example 2: Synthesis of Compound D-130

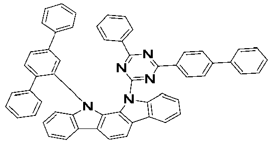

Compound D-130 was synthesized by referring to the method known in KR 10-2193015 B1.

### Synthesis Example 3: Synthesis of Compound D-12

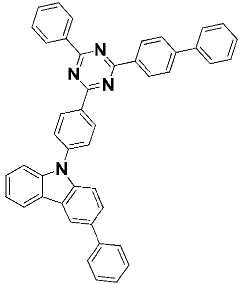

Compound D-12 was synthesized by referring to the method known in KR 10-2430047 B1.

### Synthesis Example 4: Synthesis of Compound B-136

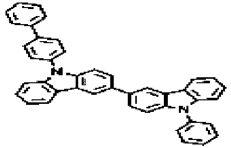

Compound B-136 was synthesized by referring to the method known in KR 10-1649683 B1.

### Synthesis Example 5: Synthesis of Compound B-40

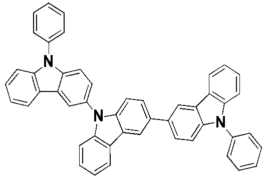

Compound **B-40** was synthesized by referring to a method known in KR 10-2023-0007931 A.

### Synthesis Example 6: Synthesis of Compound B-139

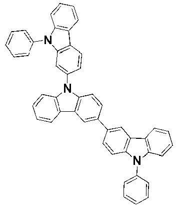

Compound B-139 was synthesized by referring to a method known in KR 10-2023-0007931 A.

### Synthesis Example 7: Synthesis of IrGD

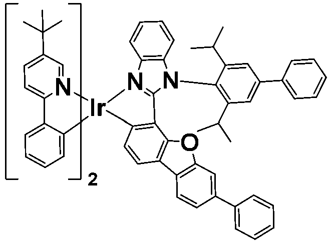

IrGD was synthesized by referring to a method known in KR 10-2022-0125767 A.

### Synthesis Example 8: Synthesis of PtGD

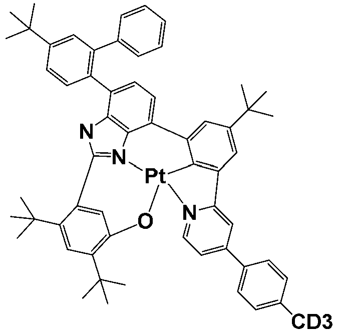

PtGD was synthesized by referring to a method known in KR 10-2022-0136951 A.

### Example 1

A glass substrate coated with ITO (indium tin oxide) was washed with distilled water ultrasonic wave. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This prepared ITO transparent electrode was used as an anode, Compound A doped with 3% NDP-9 (Novaled GmbH) was vacuum-deposited on the ITO substrate to form a 100 Å-thick hole injection layer, and Compound A is deposited on the hole injection layer to a thickness of 1350 Å to form a hole transport layer. Compound B was deposited on the hole transport layer to a thickness of 350 Å to form a hole transport auxiliary layer, and a first light emitting layer (EML1) was formed on the hole transport auxiliary layer and then, a second light emitting layer (EML2) was formed thereon. The compositions of the first and second light emitting layers are described separately in the following examples and comparative examples. Subsequently, Compound C was deposited on the light emitting layer to form a 50 Å-thick electron transport auxiliary layer, and Compound D and Liq were simultaneously vacuum deposited in a weight ratio of 1:1 to form a 300 Å-thick electron transport layer. Yb was deposited to a thickness of 15 Å on the electron transport layer to form an electron injection layer, Mg and Ag were simultaneously vacuum deposited in a weight ratio of 1:9 to a thickness of 150 Å to form a cathode, and Compound E was deposited to a thickness of 300 Å on the cathode to form a capping layer.

The structure was ITO / Compound A (3 % NDP-9 doping, 100 Å) / Compound A (1350 Å) / Compound B (350 Å) / EML1 / EML2 / Compound C (50 Å) / Compound D : LiQ (300 Å) / Yb (15 Å) / Mg:Ag (150 Å) / Compound E (300 Å).
Compound A: N-(9,9-diphenyl-9H-fluoren-2-yl)-N,9-diphenyl-9H-carbazol-2-amine
Compound B: N-([1,1'-biphenyl]-4-yl)-9,9-dimethyl-N-(3-(9-phenyl-9H-fluoren-9-yl)phenyl)-9H-fluoren-2-amine
Compound C: 4-([1,1'-biphenyl]-4-yl)-6-(3'-(9,9-dimethyl-9H-fluoren-4-yl)-[1,1'-biphenyl]-4-yl)-2-phenylpyrimidine
Compound D: 6,6'-(naphthalene-1,2-diylbis (4,1-phenylene))bis(2,4-diphenyl-1,3,5-triazine)
Compound E: N-([1,1'-biphenyl]-4-yl)-9,9-dimethyl-N-(4-(9-phenyl-9H-carbazol-3-yl)phenyl)-9H-fluoren-2-amine

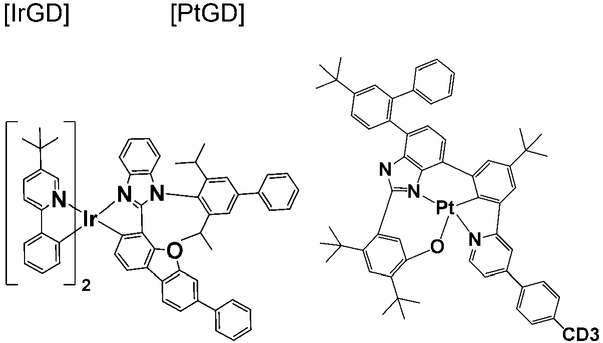

### Examples 2 to 6 and Comparative Examples 1 to 6

Organic light emitting diodes were manufactured in the same manner as in Example 1, except that the compositions were changed to those shown in Tables 1 and 2.

### Manufacturing Method of Hole Only Device (HOD)

ITO / Compound E (1400 Å)/ Compound F (1% NDP-9 doping, 100 Å) / Compound F (200 Å)/ EML (host, 400 Å) / HAT-CN (100 Å) / Ag (50 Å) / Mg:Ag (9:1, 550 Å)
Compound F: N-([1,1'-biphenyl]-4-yl)-N-(2-(9,9-diphenyl-9H-fluoren-4-yl)phenyl)-9,9-dimethyl-9H-fluoren-2-amine

### Hole Trap Index

A hole trap index of a light emitting layer by a dopant may be represented by Formula 2.

A current density decrease rate of HOD before and after doping the dopant on the light emitting layer may indicate a degree of trapping holes in the dopant, that is, the hole trap index. When the hole trap index is 100%, it means the holes are not trapped by the dopant, while when the hole trap index of 0%, it means that the holes are all trapped. 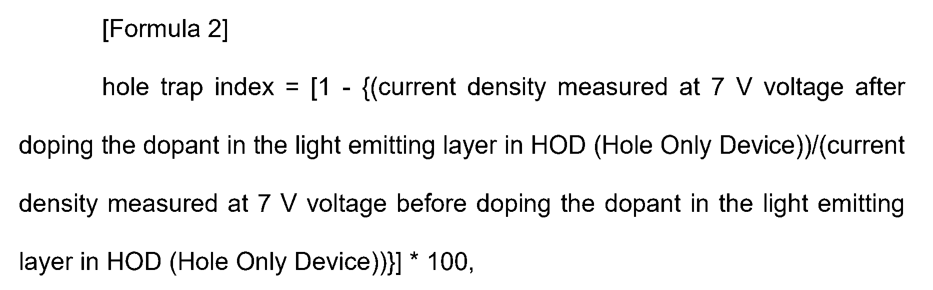 hole trap index = [1 - {(current density measured at 7 V voltage after doping the dopant in the light emitting layer in HOD (Hole Only Device))/(current density measured at 7 V voltage before doping the dopant in the light emitting layer in HOD (Hole Only Device))}] * 100,

HOD is as described above, and the hole trap index is as listed in Table 1.

### Evaluation

The compositions of the organic light emitting diodes according to Examples 1 to 6 and Comparative Examples 1 to 6 are as shown in Table 2, and each luminous efficiency and life-span characteristics were evaluated.

The specific measurement method is as follows, and the results are as shown in Tables 3 and 4.

### (1) Measurement of Current Density Change Depending on Voltage Change

The obtained organic light emitting diodes were measured regarding a current value flowing in the unit device, while increasing the voltage from 0 V to 10 V using a current-voltage meter (Keithley 2400), and the measured current value was divided by area to provide the results.

### (2) Measurement of Luminance Change Depending on Voltage Change

### Luminance was measured by using a luminance meter (Minolta Cs-1000A), while the voltage of the organic light emitting diodes was increased from 0 V to 10 V.

### (3) Measurement of Luminous Efficiency

Current efficiency (cd/A) at the same current density (10 mA/cm²) were calculated by using the luminance and current density from the items (1) and (2), and voltages (V).

The luminous efficiency values of Examples 1 to 3 and Comparative Examples 1 to 3 were calculated as relative values based on Example 1 and are listed in Table 3.

### (4) Measurement of Life-span

The results were obtained by maintaining the luminance (cd/m²) at 24000 cd/m² and measuring the time for the current efficiency (cd/A) to decrease to 97%.

The measured life-spans of Examples 4 to 6 and Comparative Examples 4 to 6 were calculated as relative values relative to Example 6 and are listed in Table 4.

**(Table 1)**

| Nos. | Host | | | Dopant (doping concentration, wt%) | HOD current density (mA/cm²) (@7V) | Hole trap index |
|---|---|---|---|---|---|---|
| | First compound or third compound | Second compound or fourth compound | Weight ratio | | | |
| 1 | Compound A-3 | Compound B-40 | 30:70 | - | 431 | 76% |
| | Compound A-3 | Compound B-40 | 30:70 | IrGD (7%) | 103 | |
| 2 | Compound A-3 | Compound B-139 | 30:70 | | 444 | 79% |
| | Compound A-3 | Compound B-139 | 30:70 | IrGD (7%) | 94 | |
| 3 | Compound D-130 | Compound B-136 | 40:60 | | 577 | 45% |
| | Compound D-130 | Compound B-136 | 40:60 | PtGD (15%) | 317 | |
| 4 | Compound D-12 | Compound B-139 | 30:70 | | 431 | 30% |
| | Compound D-12 | Compound B-139 | 30:70 | IrGD (7%) | 302 | |

**(Table 2)**

| | Host | | | Weight ratio | Dopant (doping concentration, wt%) | Thickness of light emitting layer (Å) |
|---|---|---|---|---|---|---|
| Example 1 | first light emitting layer | Compound A-3 | Compound B-40 | 3:7 | IrGD (3%) | 80 |
| | second light emitting layer | Compound D-130 | Compound B-136 | 4:6 | PtGD (15%) | 300 |
| Example 2 | first light emitting layer | Compound A-3 | CompoundB-40 | 3:7 | IrGD (5%) | 80 |
| | second light emitting layer | Compound D-130 | Compound B-136 | 4:6 | PtGD (15%) | 300 |
| Example 3 | first light emitting layer | Compound A-3 | Compound B-40 | 3:7 | IrGD (7%) | 80 |
| | second light emitting layer | Compound D-130 | Compound B-136 | 4:6 | PtGD (15%) | 300 |
| Example 4 | first light emitting layer | Compound A-3 | Compound B-139 | 3:7 | IrGD (7%) | 80 |
| | second light emitting layer | Compound D-130 | Compound B-136 | 4:6 | PtGD (15%) | 300 |
| Example 5 | first light emitting layer | Compound A-3 | Compound B-139 | 3:7 | IrGD (7%) | 130 |
| | second light emitting layer | Compound D-130 | Compound B-136 | 4:6 | PtGD (15%) | 250 |
| Example 6 | first light emitting layer | Compound A-3 | Compound B-139 | 3:7 | IrGD (7%) | 180 |
| | second light emitting layer | Compound D-130 | Compound B-136 | 4:6 | PtGD (15%) | 200 |
| Comparative Example 1 | first light emitting layer | Compound D-130 | Compound B-136 | 4:6 | PtGD (15%) | 300 |
| | second light emitting layer | Compound A-3 | Compound B-139 | 3:7 | IrGD (3%) | 80 |
| Comparative Example 2 | first light emitting layer | Compound D-130 | Compound B-136 | 4:6 | PtGD (15%) | 300 |
| | second light emitting layer | Compound A-3 | Compound B-139 | 3:7 | IrGD (5%) | 80 |
| Comparative Example 3 | first light emitting layer | Compound D-130 | Compound B-136 | 4:6 | PtGD (15%) | 300 |
| | second light emitting layer | Compound A-3 | Compound B-139 | 3:7 | IrGD (7%) | 80 |
| Comparative Example 4 | first light emitting layer | Compound D-12 | Compound B-139 | 3:7 | IrGD (7%) | 80 |
| | second light emitting layer | Compound D-130 | Compound B-136 | 4:6 | PtGD (15%) | 300 |
| Comparative Example 5 | first light emitting layer | Compound D-12 | Compound B-139 | 3:7 | IrGD (7%) | 130 |
| | second light emitting layer | Compound D-130 | Compound B-136 | 4:6 | PtGD (15%) | 250 |
| Comparative Example 6 | first light emitting layer | Compound D-12 | Compound B-139 | 3:7 | IrGD (7%) | 180 |
| | second light emitting layer | Compound D-130 | Compound B-136 | 4:6 | PtGD (15%) | 200 |

**(Table 3)**

| Nos. | Luminous efficiency (%) |
|---|---|
| Example 1 | 100% |
| Example 2 | 102% |
| Example 3 | 107% |
| Comparative Example 1 | 95% |
| Comparative Example 2 | 93% |
| Comparative Example 3 | 91% |

Referring to Table 3, the organic light emitting diodes according to Examples 1 to 3, compared with the organic light emitting diodes according to Comparative Examples 1 to 3, exhibited significantly improved luminous efficiency. Example 3, compared with Comparative Example 3, exhibited a hole trap index of 76% by a dopant of the first light emitting layer and a hole trap index of 45% by a dopant of the second light emitting layer, which confirmed that the first light emitting layer included a compound having strong hole trapping characteristics so that a light emitting zone was relatively adjacent to an anode, thereby improving efficiency. In addition, in Examples 1 to 3, as a doping concentration of the first light emitting layer was increased, hole-electron balance was optimized, resulting in improving luminous efficiency.

On the contrary, Comparative Example 1 exhibited a hole trap index of 45% by a dopant of the first light emitting layer and a hole trap index of 76% by a dopant of the second light emitting layer, wherein a light emitting zone was formed to be relatively adjacent to a cathode, where was not a proper position, and accordingly, in Comparative Examples 1 to 3, even though a doping concentration of the second light emitting layer was increased, the efficiency was rather deteriorated.

**(Table 4)**

| Nos. | Life-span (%) |
|---|---|
| Example 4 | 110% |
| Example 5 | 105% |
| Example 6 | 100% |
| Comparative Example 4 | 57% |
| Comparative Example 5 | 57% |
| Comparative Example 6 | 60% |

Referring to Table 4, the organic light emitting diodes according to Examples 4 to 6, compared with the organic light emitting diodes according to Comparative Examples 4 to 6, exhibited significantly improved life-span. As a thickness of the first light emitting layer decreased from Example 6 to Example 4, the light emitting zone shifted relatively toward the anode and thus exhibited improved life-span characteristics. Comparative Example 4, which included a carbazole compound having excellent hole transport capability in the first light emitting layer, exhibited a weak hole trap index of 30% by a dopant. On the contrary, Comparative Example 4 exhibited a hole trap index of 45% by a dopant of the second light emitting layer, wherein since a light emitting zone was located relatively in the center, life-span characteristics were deteriorated. In addition, since a compound with a weak hole trap index was included in the second light emitting layer, there was no effect of improving life-span according to a thickness change.

## Claims

1. An organic optoelectronic device, comprising
an anode and a cathode facing each other,
an intermediate layer between the anode and the cathode,
wherein the intermediate layer includes a first light emitting layer and a second light emitting layer,
the first light emitting layer is disposed between the anode and the second light emitting layer, and includes a first host including a composition of a first compound and a second compound, and a first dopant,
the second light emitting layer is disposed between the cathode and the first light emitting layer, and includes a second host including a composition of a third compound and a fourth compound, and a second dopant,
the first dopant is an iridium complex and the second dopant is a platinum complex, and
the organic optoelectronic device satisfies Formula 1: 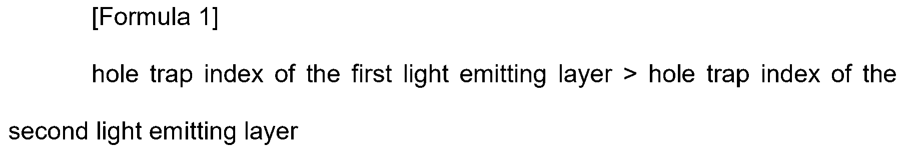 hole trap index of the first light emitting layer > hole trap index of the second light emitting layer
wherein the hole trap index is calculated according to Formula 2: 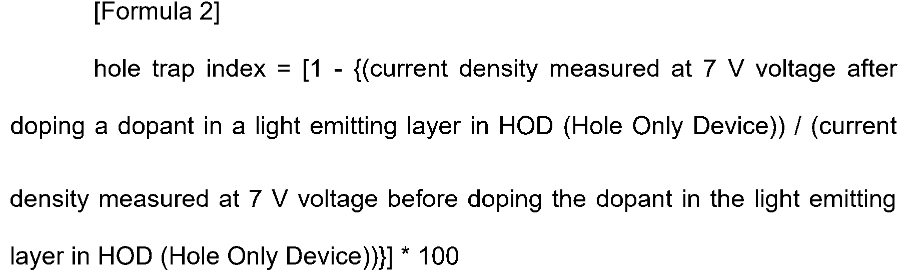 hole trap index = [1 - {(current density measured at 7 V voltage after doping a dopant in a light emitting layer in HOD (Hole Only Device)) / (current density measured at 7 V voltage before doping the dopant in the light emitting layer in HOD (Hole Only Device))}] * 100
HOD: ITO/Compound E (1,400 Å)/Compound F (1% NDP-9 doping, 100 Å)/Compound F (200 Å)/light emitting layer (400 Å)/ HAT-CN (100 Å) / Ag (50 Å) / Mg:Ag (9:1, 550 Å);
Compound E: N-([1,1'-biphenyl]-4-yl)-9,9-dimethyl-N-(4-(9-phenyl-9H-carbazol-3-yl)phenyl)-9H-fluoren-2-amine; and
Compound F: N-([1,1'-biphenyl]-4-yl)-N-(2-(9,9-diphenyl-9H-fluoren-4-yl)phenyl)-9,9-dimethyl-9H-fluoren-2-amine).

2. The organic optoelectronic device of claim 1, wherein
a difference between the hole trap index of the first light emitting layer and the hole trap index of the second light emitting layer is greater than or equal to 30%.

3. The organic optoelectronic device of claim 1, wherein
the first compound is an electron transporting host and does not include carbazole.

4. The organic optoelectronic device of claim 3, wherein
the first compound is represented by Chemical Formula 1: 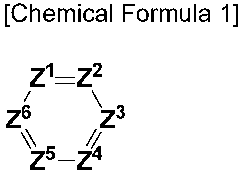
wherein, in Chemical Formula 1,
Z¹ to Z⁶ are each independently N or C-L^{a}-R^{a},
at least two of Z¹ to Z⁶ are N,
L^{a}s are each independently a single bond, a substituted or unsubstituted C6 to C20 arylene group, a substituted or unsubstituted dibenzofuranylene group, or a substituted or unsubstituted dibenzothiophenylene group,
R^{a} are each independently hydrogen, deuterium, a substituted or unsubstituted C1 to C30 alkyl group, a substituted or unsubstituted C6 to C30 aryl group, a substituted or unsubstituted dibenzofuranyl group, or a substituted or unsubstituted dibenzothiophenyl group, and
R^{a}s are each independently present or adjacent groups are linked to form a substituted or unsubstituted aliphatic, aromatic or heteroaromatic monocyclic or polycyclic ring.

5. The organic optoelectronic device of claim 4, wherein
Chemical Formula 1 is represented by any one of Chemical Formula 1A, Chemical Formula 1B and Chemical Formula 1C: 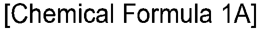 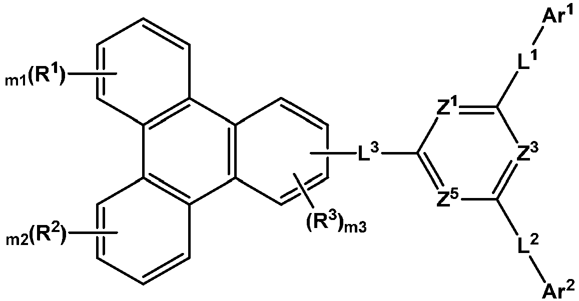 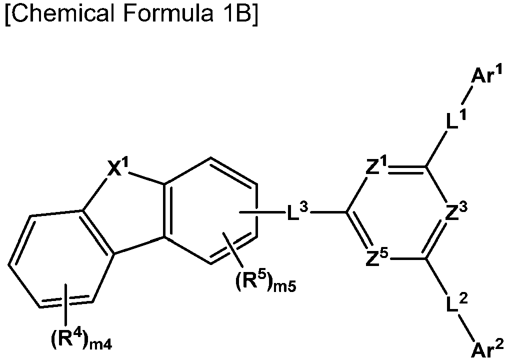 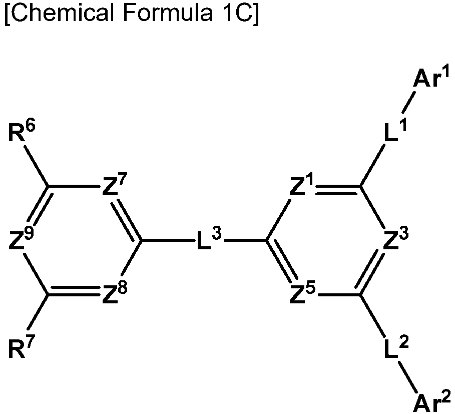
wherein, in Chemical Formula 1A, Chemical Formula 1B, and Chemical Formula 1C,
Z¹, Z³, and Z⁵ are each independently N or C-L^{a}-R^{a},
at least two of Z¹, Z³ and Z⁵ are N,
at least two of Z⁷ to Z⁹ are each independently N or C-L^{b}-R^{b},
X¹is O, S or CR^{c}R^{d},
L^{a}, L^{b}, and L¹ to L³ are each independently a single bond, a substituted or unsubstituted C6 to C20 arylene group, a substituted or unsubstituted dibenzofuranylene group, or a substituted or unsubstituted dibenzothiophenylene group,
Ar¹ and Ar² are each independently a substituted or unsubstituted C6 to C30 aryl group, a substituted or unsubstituted dibenzofuranyl group, or a substituted or unsubstituted dibenzothiophenyl group,
R^{a}, R^{b}, R^{c}, R^{d}, and R¹ to R⁷ are each independently hydrogen, deuterium, a substituted or unsubstituted C1 to C30 alkyl group, a substituted or unsubstituted C6 to C30 aryl group, a substituted or unsubstituted dibenzofuranyl group, a substituted or unsubstituted dibenzothiophenyl group, a substituted or unsubstituted silyl group, a substituted or unsubstituted amine group, a halogen, a cyano group, or a combination thereof,
R⁴ and R⁵ are each independently present or adjacent groups are linked to form a substituted or unsubstituted C6 to C20 aryl group or a substituted or unsubstituted C2 to C30 heterocyclic group,
m1, m2, and m4 are each independently one of integers of 1 to 4, and
m3 and m5 are each independently one of integers of 1 to 3.

6. The organic optoelectronic device of claim 1, wherein
the third compound is an electron transporting host and includes at least one of carbazole and indolocarbazole.

7. The organic optoelectronic device of claim 6, wherein
the third compound is represented by Chemical Formula 2: 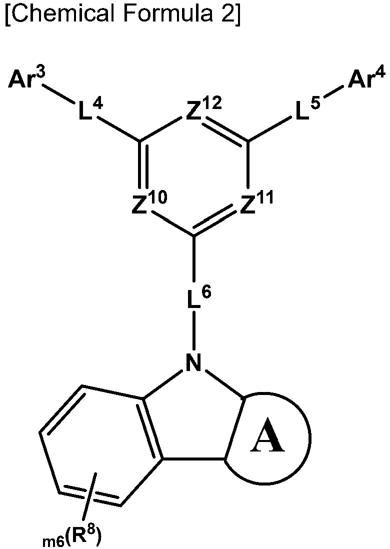
wherein, in Chemical Formula 2,
Z¹⁰ to Z¹² are each independently N or C-L^{c}-R^{e,}
at least two of Z¹⁰ to Z¹² are N,
L^{c} and L⁴ to L⁶ are each independently a single bond, a substituted or unsubstituted C6 to C20 arylene group, a substituted or unsubstituted C2 to C20 heterocyclic group, or a combination thereof,
Ar³ and Ar⁴ are each independently a substituted or unsubstituted C6 to C30 aryl group, a substituted or unsubstituted C2 to C30 heterocyclic group, or a combination thereof,
R^{e} and R⁸ are each independently hydrogen, deuterium, a substituted or unsubstituted C1 to C30 alkyl group, a substituted or unsubstituted C6 to C30 aryl group, a substituted or unsubstituted C2 to C30 heterocyclic group, a substituted or unsubstituted silyl group, a substituted or unsubstituted amine group, a halogen, a cyano group, or a combination thereof,
m6 is an integer of 1 to 4, and
ring A is represented by any one of Chemical Formula I -1 to Chemical Formula I -4, 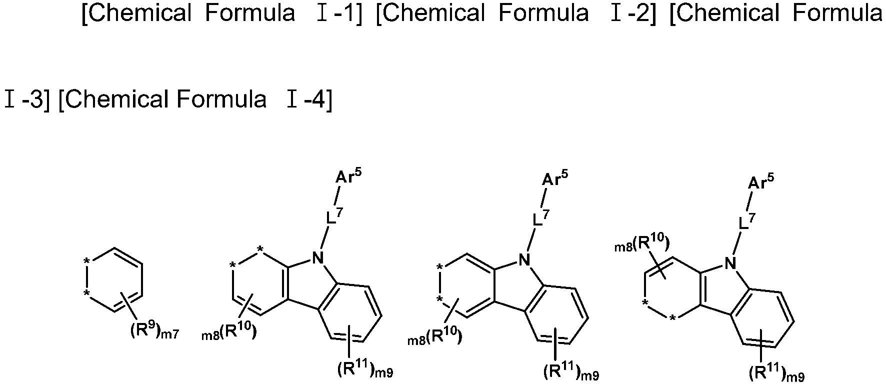
wherein, in Chemical Formula I -1 to Chemical Formula I-4,
R⁹ to R¹¹ are each independently hydrogen, deuterium, a substituted or unsubstituted C1 to C30 alkyl group, a substituted or unsubstituted C6 to C30 aryl group, a substituted or unsubstituted C2 to C30 heterocyclic group, a substituted or unsubstituted silyl group, a substituted or unsubstituted amine group, a halogen, a cyano group, or a combination thereof,
R⁸ and R⁹ are each independently present or adjacent groups are linked to form a substituted or unsubstituted C6 to C20 aryl group or a substituted or unsubstituted C2 to C30 heterocyclic group,
L⁷ is a single bond, a substituted or unsubstituted C6 to C20 arylene group, a substituted or unsubstituted C2 to C20 heterocyclic group, or a combination thereof,
Ar⁵ is a substituted or unsubstituted C6 to C30 aryl group, a substituted or unsubstituted C2 to C30 heterocyclic group, or a combination thereof,
m7 and m9 are each independently one of integers of 1 to 4,
m8 is an integer of 1 or 2, and
* is a linking point.

8. The organic optoelectronic device of claim 7, wherein
Chemical Formula 2 is represented by any one of Chemical Formula 2A, Chemical Formula 2B, Chemical Formula 2C, Chemical Formula 2D, Chemical Formula 2E, Chemical Formula 2F, and Chemical Formula 2G: 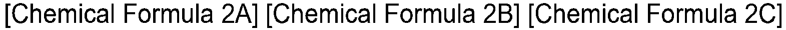 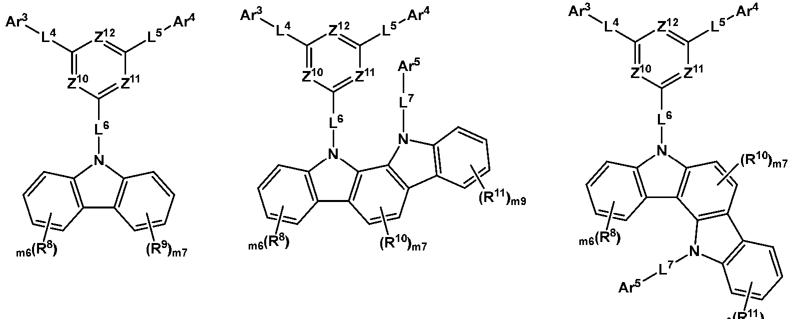 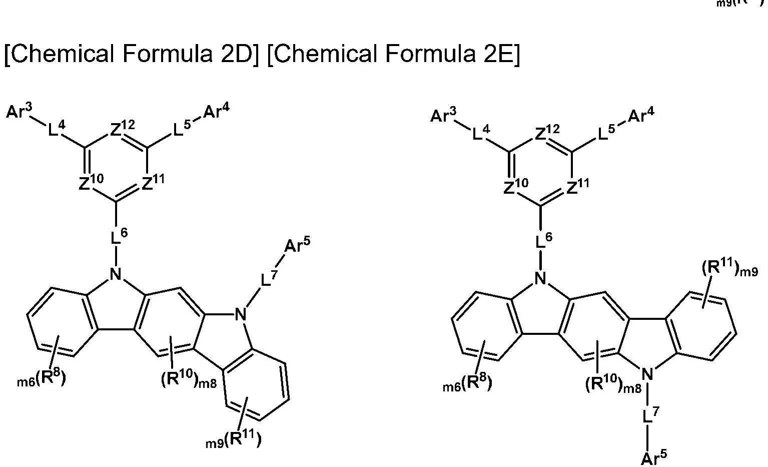 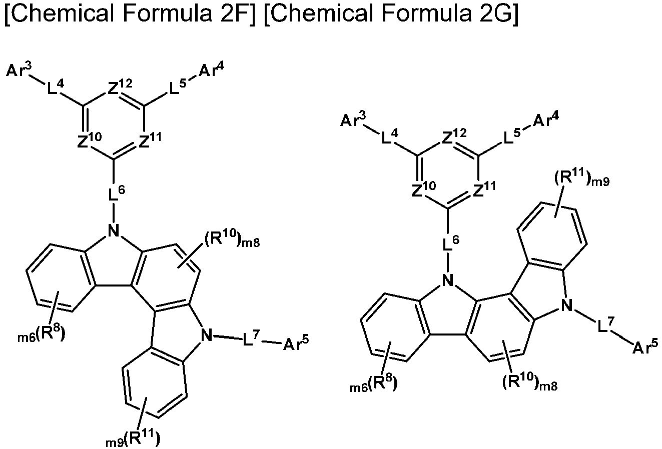 wherein, in Chemical Formula 2A to Chemical Formula 2G, definitions of Z¹⁰ to Z¹², L⁴ to L⁶, Ar³, Ar⁴, R⁸ to R¹¹, and m6 to m9 are the same as defined in claim 7.

9. The organic optoelectronic device of claim 1, wherein
the second compound and the fourth compound are hole transporting hosts, are the same or different from each other, and are each independently a compound including at least one of carbazole and indolocarbazole.

10. The organic optoelectronic device of claim 9, wherein
the second compound and the fourth compound are each independently represented by Chemical Formula 3 or a combination of Chemical Formula 4 and Chemical Formula 5: 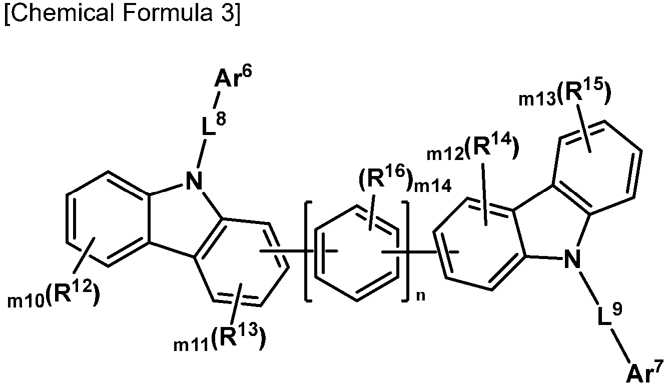
wherein, in Chemical Formula 3,
Ar⁶ and Ar⁷ are each independently a substituted or unsubstituted C6 to C30 aryl group or a substituted or unsubstituted C2 to C30 heterocyclic group,
L⁸ and L⁹ are each independently a single bond or a substituted or unsubstituted C6 to C20 arylene group,
R¹² to R¹⁶ are each independently hydrogen, deuterium, a cyano group, a halogen, a substituted or unsubstituted amine group, a substituted or unsubstituted C1 to C30 alkyl group, a substituted or unsubstituted silyl group, a substituted or unsubstituted C6 to C30 aryl group, or a substituted or unsubstituted C2 to C30 heterocyclic group,
m10, m13, and m14 are each independently one of integers of 1 to 4,
m11 and m12 are each independently one of integers of 1 to 3, and
n is one of integers of 0 to 2; 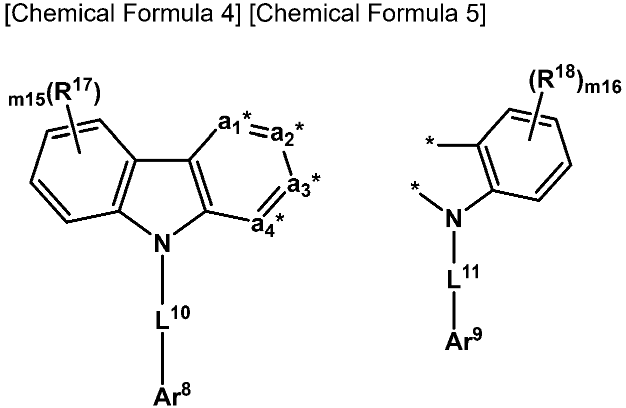
wherein, in Chemical Formula 4 and Chemical Formula 5,
Ar^{d} and Ar⁹ are each independently a substituted or unsubstituted C6 to C30 aryl group or a substituted or unsubstituted C2 to C30 heterocyclic group,
a₁* to a₄" in Chemical Formula 4 are each independently a linking carbon (C) or C-L^{d}-R^{f},
the two adjacent of a₁* to a₄* in Chemical Formula 4 are linked to *s in Chemical Formula 5,
L^{d}, L¹⁰, and L¹¹ are each independently a single bond or a substituted or unsubstituted C6 to C20 arylene group,
R^{f}, R¹⁷, and R¹⁸ are each independently hydrogen, deuterium, a cyano group, a halogen, a substituted or unsubstituted amine group, a substituted or unsubstituted C1 to C30 alkyl group, a substituted or unsubstituted silyl group, a substituted or unsubstituted C6 to C30 aryl group, or a substituted or unsubstituted C2 to C30 heterocyclic group, and
m15 and m16 are each independently one of integers of 1 to 4.

11. The organic optoelectronic device of claim 10, wherein
Chemical Formula 3 is represented by any one of Chemical Formula 3-1 to Chemical Formula 3-15: 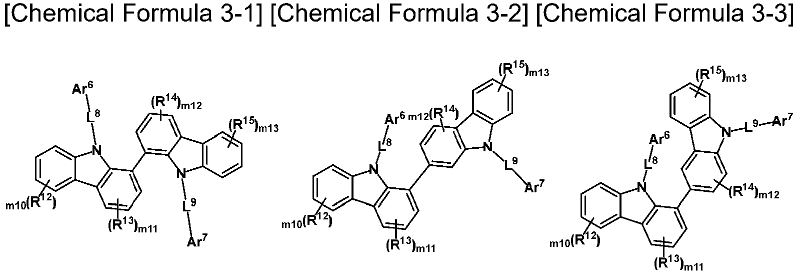 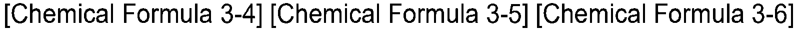 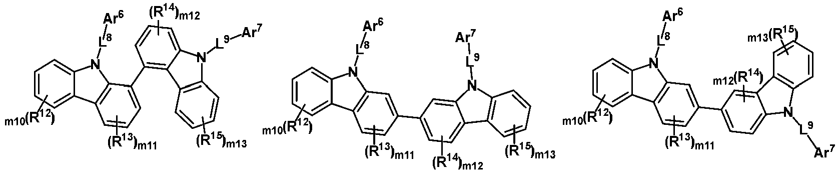 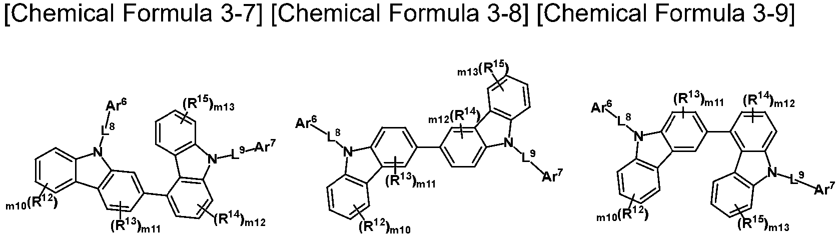 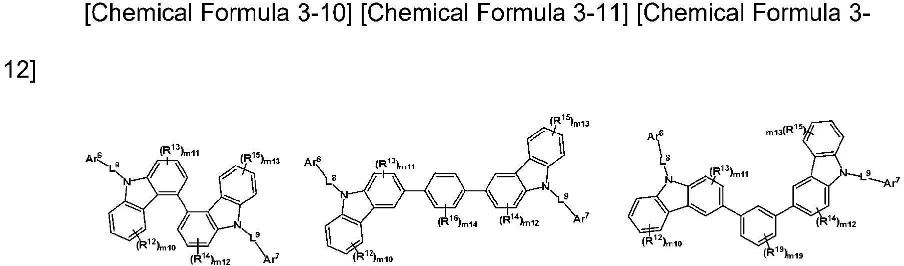 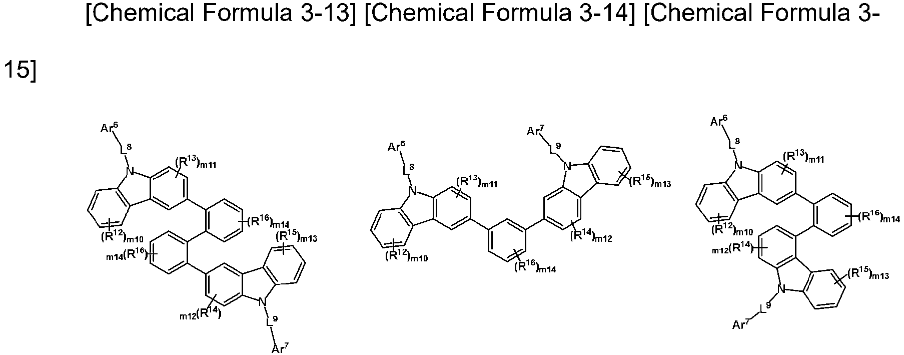
wherein, in Chemical Formula 3-1 to Chemical Formula 3-15,
R¹² to R¹⁶ are each independently hydrogen, deuterium, a substituted or unsubstituted C6 to C12 aryl group, a substituted or unsubstituted carbazolyl group, a substituted or unsubstituted dibenzofuranyl group, or a substituted or unsubstituted dibenzothiophenyl group, and
*-L⁸-Ar⁶ and *-L⁹-Ar⁵ are each independently one of substituents listed in Group I, 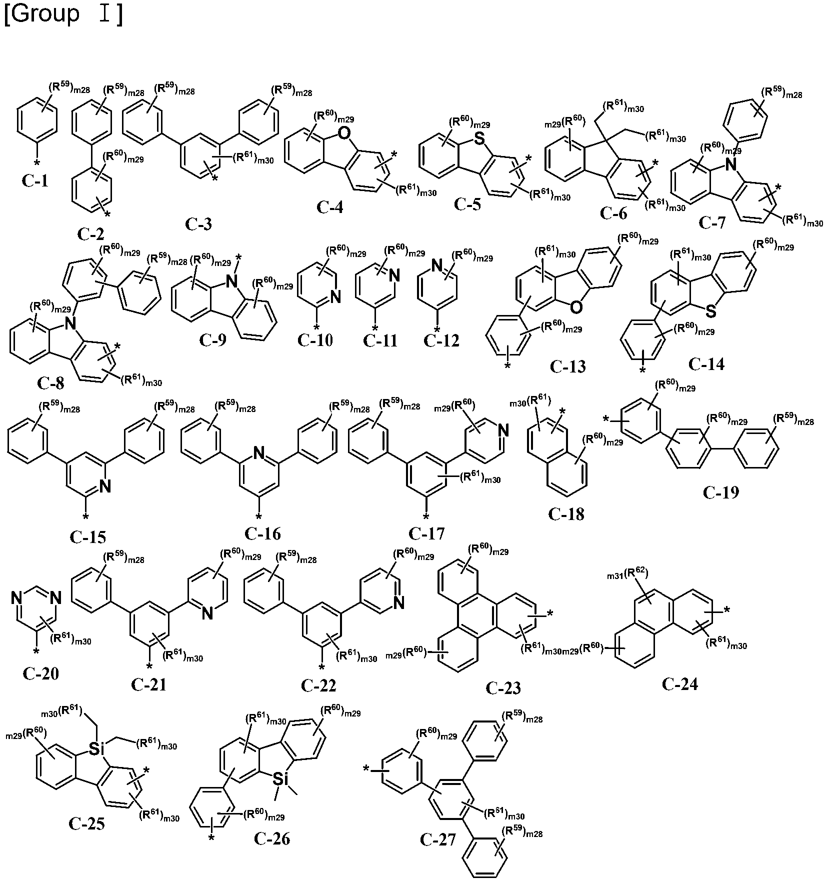
wherein, in Group I ,
R⁵⁹ to R⁶² are each independently hydrogen, deuterium, a C1 to C4 alkyl group, a C6 to C18 aryl group, or a C2 to C30 heteroaryl group,
m28 is an integer from 1 to 5,
m29 is an integer from 1 to 4,
m30 is an integer from 1 to 3,
m31 is an integer from 1 to 2, and
* is a linking point.

12. The organic optoelectronic device of claim 10, wherein
the combination of Chemical Formula 4 and Chemical Formula 5 is represented by any one of Chemical Formula 4A to Chemical Formula4E: 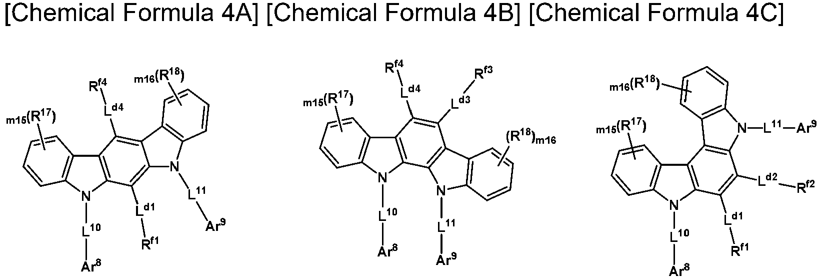 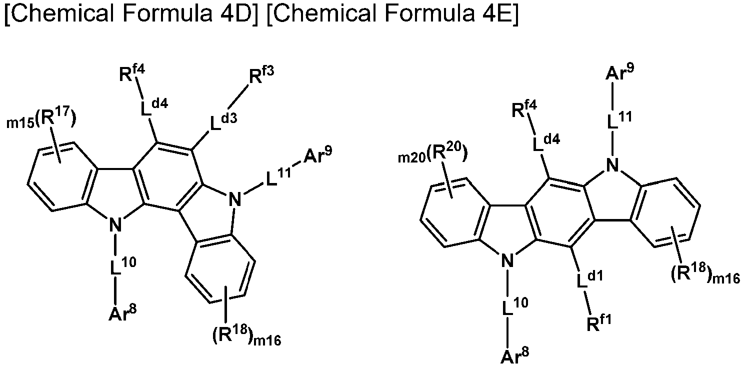
wherein, in Chemical Formula 4A to Chemical Formula 4E,
R¹⁷ and R¹⁸ are each independently hydrogen, deuterium, a substituted or unsubstituted C6 to C12 aryl group, a substituted or unsubstituted carbazolyl group, a substituted or unsubstituted dibenzofuranyl group, or a substituted or unsubstituted dibenzothiophenyl group, and
*-L¹⁰-Ar⁸ and *-L¹¹-Ar⁹ are each independently one of substituents listed in Group I , 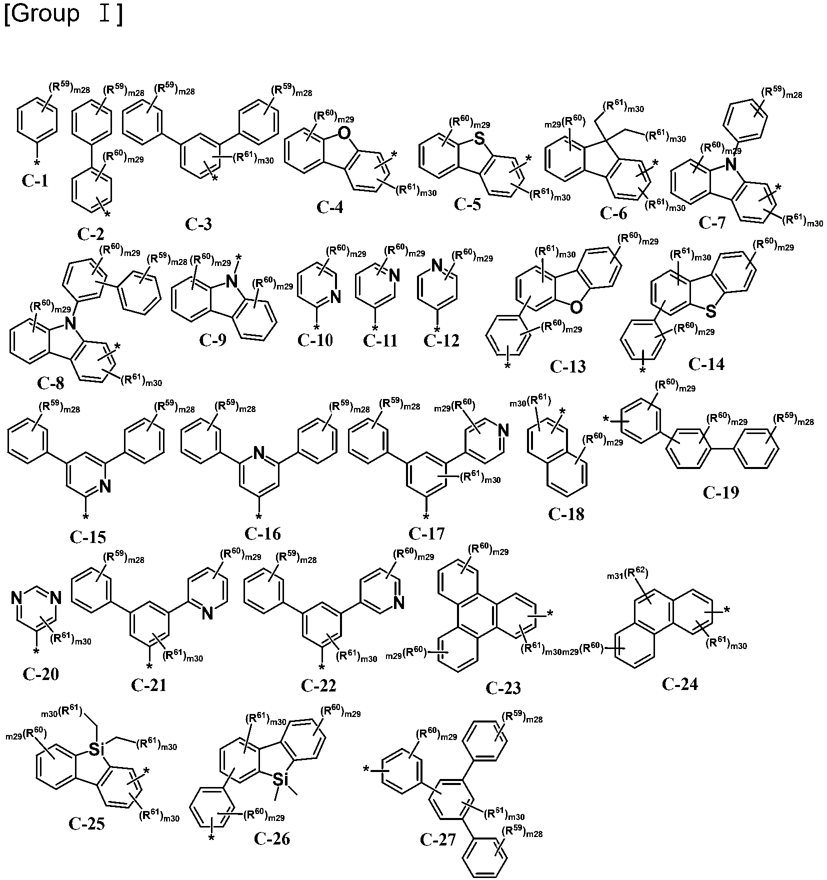
wherein, in Group I ,
R⁵⁹ to R⁶² are each independently hydrogen, deuterium, a C1 to C4 alkyl group, a C6 to C18 aryl group, or a C2 to C30 heteroaryl group,
m28 is an integer from 1 to 5,
m29 is an integer from 1 to 4,
m30 is an integer from 1 to 3,
m31 is an integer from 1 to 2, and
* is a linking point.

13. The organic optoelectronic device of claim 1, wherein
the iridium complex is represented by Chemical Formula V: 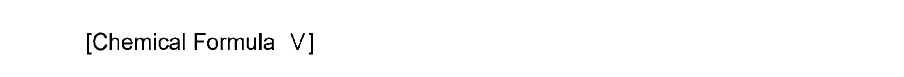 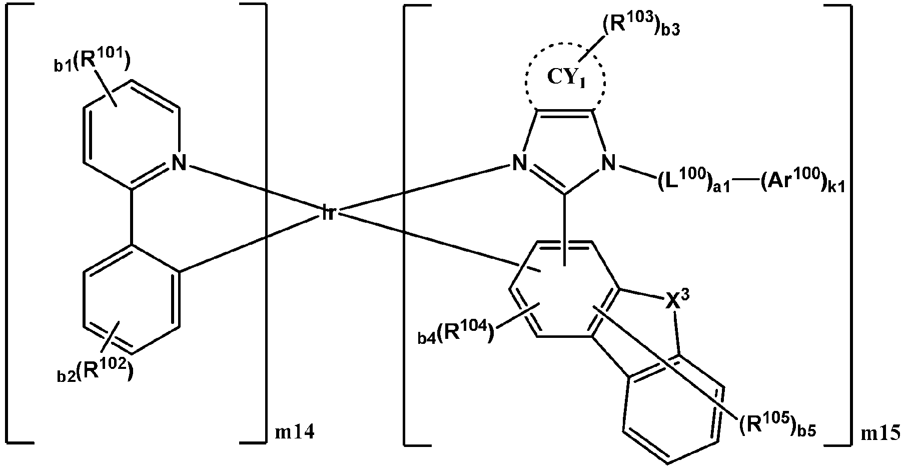
wherein, in Chemical Formula V,
X³ is O, S, or Se,
CY₁ is a substituted or unsubstituted C5 to C30 carbocyclic group or a substituted or unsubstituted C1 to C30 heterocyclic group,
L¹⁰⁰ is a substituted or unsubstituted C3 to C10 cycloalkylene group, a substituted or unsubstituted C1 to C10 heterocycloalkylene group, a substituted or unsubstituted C3 to C10 cycloalkenylene group, a substituted or unsubstituted C2 to C10 heterocycloalkenylene group, a substituted or unsubstituted C6 to C60 arylene group, a substituted or unsubstituted C1 to C60 heteroarylene group, a substituted or unsubstituted divalent non-aromatic condensed polycyclic group, or a substituted or unsubstituted divalent non-aromatic heterocondensed polycyclic group,
a1 is an integer of 0 to 3,
Ar¹⁰⁰, R¹⁰¹, R¹⁰², R¹⁰³, R¹⁰⁴, and R¹⁰⁵ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C2 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted C1 to C60 heteroaryloxy group, a substituted or unsubstituted C1 to C60 heteroarylthio group, a substituted or unsubstituted monovalent non-aromatic condensed polycyclic group, a substituted or unsubstituted monovalent non-aromatic heterocondensed polycyclic group, -N(Q1)(Q2), -Si(Q3)(Q4)(Q5), -Ge(Q3)(Q4)(Q5), -B(Q6)(Q7), or -P(=O)(Q8)(Q9),
k1 is an integer of 1 to 8,
b1 and b2 are each independently an integer of 1 to 4,
b3 is an integer of 1 to 8,
b4 is an integer of 1 to 6,
m14 is an integer of 1 to 2,
m15 is an integer of 1 to 3, and
Q1 to Q9 are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C1 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted C1 to C60 heteroaryloxy group, a substituted or unsubstituted C1 to C60 heteroarylthio group, a substituted or unsubstituted monovalent non-aromatic condensed polycyclic group, or a substituted or unsubstituted monovalent non-aromatic heterocondensed polycyclic group.

14. The organic optoelectronic device of claim 1, wherein
the platinum complex is represented by Chemical Formula VI: 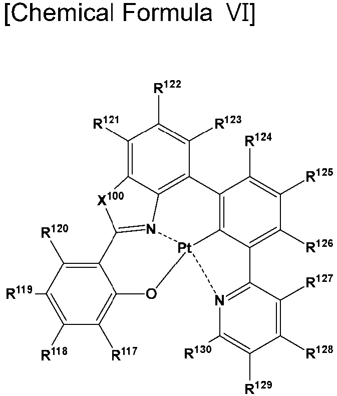
wherein, in Chemical Formula VI,
X¹⁰⁰ is selected from O, S, and NR¹³¹,
R¹¹⁷ to R¹³¹ are each independently hydrogen, deuterium, a substituted or unsubstituted C1 to C10 alkyl group, a substituted or unsubstituted C6 to C20 aryl group, or - SiR¹³²R¹³³R¹³⁴,
R¹³² to R¹³⁴ are each independently a substituted or unsubstituted C1 to C6 alkyl group,
at least one of R¹¹⁷ to R¹³¹ is -SiR¹³²R¹³³R¹³⁴ or a tert-butyl group, and
R¹³² to R¹³⁴ are each independently a substituted or unsubstituted C1 to C6 alkyl group.

15. The organic optoelectronic device of claim 1, wherein
the first light emitting layer and the second light emitting layer are in contact with each other.

16. The organic optoelectronic device of claim 1, wherein
at least one of a hole transport region, an electron transport region, and a charge generation layer (CGL) is further included between the first light emitting layer and the second light emitting layer.

17. A display device comprising the organic optoelectronic device of any one of claim 1 to claim 16.
